# EUROPEAN PATENT APPLICATION

(11) **EP 4 412 241 A1**
(43) Date of publication of application: **07.08.2024**
(21) Application number: 22914668.3
(22) Date of filing: 26.12.2022
(51) Int. Cl.: H04R 1/10, A44C 5/00

(54) **WEARABLE DEVICE**

(30) Priority: 31.12.2021 CN 202111677026
(71) Applicant: Huawei Technologies Co., Ltd., Shenzhen, Guangdong 518129 (CN)
(72) Inventor: LI, Kelin, Shenzhen, Guangdong 518129 (CN); ZHENG, Wei, Shenzhen, Guangdong 518129 (CN)
(74) Representative: Gill Jennings & Every LLP
(86) International application number: PCT/CN2022/141942
(87) International publication number: WO 2023/125414

(57) **Abstract**

This application provides a wearable device, including an earphone and a host. The earphone has an earphone magnet. The host includes a first part and a second part that can be opened and closed. The first part has a first accommodation groove. The second part has a third accommodation groove. When the host is closed, the first accommodation groove and the third accommodation groove enclose an accommodation space. The first part has a first host attachment magnet. When the host is closed, the earphone is accommodated in the accommodation space, and the earphone magnet is magnetically attached to the first host attachment magnet. When the host is opened, the earphone can be attached in the first accommodation groove and move with the first part. When the earphone is accommodated in the first accommodation groove, a small part of the earphone is located in the first accommodation groove, and a large part of the earphone is located outside the first accommodation groove. A host that can be opened and closed is designed, so that a wireless earphone can be accommodated in the host, and product forms of the wireless earphone and a wearable product are integrated, to reduce devices that need to be carried by a user. This improves user experience.

## Description

This application claims priority to Chinese Patent Application No. 202111677026.6, filed with the China National Intellectual Property Administration on December 31, 2021 and entitled "WEARABLE DEVICE", which is incorporated herein by reference in its entirety.

### TECHNICAL FIELD

This application relates to the field of electronic devices, and in particular, to a wearable device.

### BACKGROUND

Wearable products such as a smartwatch and a smart band and wireless earphones have been widely used by users. In a routine scenario, a user often wears both a wearable product and a wireless earphone. The user further needs to carry an earphone case, to accommodate the wireless earphone. This requires the user to carry more devices, which is unfavorable to user experience.

### SUMMARY

An embodiment of this application provides a wearable device, so that a wireless earphone can be directly accommodated in a wearable product, and product forms of the wireless earphone and the wearable product are integrated, to reduce devices that need to be carried by a user. This improves user experience.

The wearable device in this embodiment of this application includes an earphone and a host. The earphone has an earphone magnet. The host includes a first part and a second part. The first part can rotate relative to the second part and be opened relative to the second part, so that the host is opened; or the first part and the second part can be closed, so that the host is closed. The first part has a first accommodation groove. The second part has a third accommodation groove. When the host is closed, the first accommodation groove and the third accommodation groove enclose an accommodation space. The first part has a first host attachment magnet. When the host is closed, the earphone is accommodated in the accommodation space, and the earphone magnet is magnetically attached to the first host attachment magnet. When the first part is opened relative to the second part, the earphone can be attached in the first accommodation groove and move with the first part. When the earphone is accommodated in the first accommodation groove, a maximum distance between a part that is of the earphone and that is located in the first accommodation groove and a plane on which an opening of the first accommodation groove is located is a first distance, and a maximum distance between a part that is of the earphone and that is located outside the first accommodation groove and the plane on which the opening of the first accommodation groove is located is a second distance. The first distance is less than the second distance.

In this solution, a host that can be opened and closed is designed, so that a wireless earphone can be accommodated in the host, and product forms of the wireless earphone and a wearable product are integrated, to reduce devices that need to be carried by a user. This improves user experience. In addition, when the host is opened, the earphone can be attached to the first part, and a large part of the earphone may be exposed outside the first part, so that the user can take and place the earphone conveniently.

In an implementation, the first host attachment magnet is a Halbach array, and the earphone magnet is a single magnet or a Halbach array. A magnetic attraction force of the first part of the host on the earphone can be enhanced by making the first host attachment magnet into the Halbach array, so that when the user places the earphone in the first part, the earphone can be accurately attached to the first part without precise alignment.

In an implementation, the first host attachment magnet is a Halbach array, the first host attachment magnet includes two single magnets that are connected, and magnetic field directions of the two single magnets are different. The earphone magnet includes one single magnet, and the single magnet is a Halbach array having two different magnetic field directions. Based on the magnet design, the magnetic attraction force of the first part of the host on the earphone can be greatly enhanced, so that when the user places the earphone in the first part, the earphone can be accurately attached to the first part without precise alignment.

In an implementation, the second part has a second host attachment magnet. When the earphone is accommodated in the accommodation space, the earphone magnet is magnetically attached to both the first host attachment magnet and the second host attachment magnet, and a magnetic force between the earphone magnet and the first host attachment magnet is greater than a magnetic force between the earphone magnet and the second host attachment magnet. Based on the magnet design, the earphone can be attached to the first part when the host is opened. In addition, if the earphone is located on the second part when the host is opened, the earphone can be reliably placed on the second part due to a magnetic attraction force of the second part on the earphone, and the earphone is not easily dropped even if the host is turned over.

In an implementation, a groove is provided on a circumferential edge of the first part, the first part has a sealing member, several protrusions are provided on a surface of the sealing member, the several protrusions are spaced in pairs, the sealing member is fastened in the groove of the first part, the several protrusions of the sealing member are all connected to a bottom surface of the groove of the first part, a side that is of the sealing member and that is far away from the protrusions of the sealing member is exposed outside the groove of the first part, and when the host is closed, a part that is of the sealing member and that is exposed outside the groove of the first part is in contact with the second part, to seal a gap between the first part and the second part; or a groove is provided on a circumferential edge of the second part, the second part has a sealing member, several protrusions are provided on a surface of the sealing member, the several protrusions are spaced in pairs, the sealing member is fastened in the groove of the second part, the several protrusions of the sealing member are all connected to a bottom surface of the groove of the second part, a side that is of the sealing member and that is far away from the protrusions of the sealing member is exposed outside the groove of the second part, and when the host is closed, a part that is of the sealing member and that is exposed outside the groove of the second part is in contact with the first part, to seal a gap between the first part and the second part. In the solution, the gap between the two parts of the host can be sealed, to ensure that an inside of the host and the earphone accommodated in the host are not easily eroded by foreign matter.

In an implementation, the second part has a first charging spring and a second charging spring. The earphone is in a centrosymmetric shape. The earphone includes a first electrode and a second electrode. Both the first electrode and the second electrode are located on an outer side of the earphone and are of ring-shaped structures that surround a center line of the earphone. The first electrode and the second electrode are spaced from each other. When the earphone is located in the second part, the first electrode is in contact with the first charging spring, and the second electrode is in contact with the second charging spring. The host includes a charging circuit. The charging circuit is configured to charge the earphone by using the first charging spring and the second charging spring. In this solution, when the earphone is placed in the second part at a random rotation angle, the earphone can be charged by using the host.

In an implementation, the second part has a foreign matter detection spring. The host includes a processor. The processor is configured to: control, based on an abnormal charging signal of the charging circuit, the charging circuit to be turned off, and control, based on a normal charging signal of the charging circuit, the charging circuit to work. After the foreign matter detection spring and at least one of the first charging spring and the second charging spring are in contact with foreign matter, the charging circuit generates the abnormal charging signal; otherwise, the charging circuit generates the normal charging signal. In this solution, when determining that the foreign matter enters the second part, the host can stop charging the earphone, to avoid causing an abnormality and ensure product safety and reliability.

In an implementation form, the first part or the second part has a temperature detection module. The host includes the processor. The processor is configured to: when determining, based on a detection result of the temperature detection module, that a detected temperature is greater than or equal to a threshold, control the charging circuit to be turned off. The processor is further configured to: when determining, based on the detection result of the temperature detection module, that the detected temperature is less than the threshold, control the charging circuit to work. In this solution, when determining that a temperature of the host is excessively high, the host can stop charging the earphone, to avoid causing an abnormality and ensure product safety and reliability.

In an implementation, the second part has a status detection magnet, the first part has a first magnetic field sensor, and the first magnetic field sensor is configured to detect a magnetic flux of the status detection magnet. The host includes the processor. The processor is configured to determine, based on a detection signal of the first magnetic field sensor, whether the host is in an open state or a closed state. In this solution, the open state/the closed state of the host can be detected, so that corresponding functions of the host and the earphone can be implemented, to ensure user experience.

In an implementation, the first part or the second part has a second magnetic field sensor, and the second magnetic field sensor is configured to detect a magnetic flux of the earphone magnet. The host includes the processor. The processor is configured to determine, based on a detection signal of the second magnetic field sensor of the first part, whether the earphone is located in the first accommodation groove; or the processor is configured to determine, based on a detection signal of the second magnetic field sensor of the second part, whether the earphone is located in the third accommodation groove. In this solution, the host can detect a position status of the earphone in the host, so that corresponding functions of the host and the earphone are implemented, to ensure user experience.

In an implementation, the second part has the status detection magnet. The earphone has a third magnetic field sensor, and the third magnetic field sensor is configured to detect the magnetic flux of the status detection magnet. The earphone has a controller, and the controller is configured to determine, based on a detection signal of the third magnetic field sensor, whether the earphone is located in the third accommodation groove. In this solution, the earphone can detect the position status of the earphone in the host, so that corresponding functions of the earphone are implemented, to ensure user experience.

In an implementation, the host includes a rotating shaft assembly, and the rotating shaft assembly includes a shaft sleeve, a driven member, an elastic member, and a first shaft. The shaft sleeve has an inner cavity, and an outer side of the shaft sleeve is fixedly connected to the first part. The driven member has a shaft matching surface and a through hole, and the through hole of the driven member penetrates the shaft matching surface. The driven member is located in the inner cavity, and the driven member can slide along a surface of the inner cavity but cannot rotate relative to the shaft sleeve. The elastic member is located in the inner cavity, and presses against a surface that is of the driven member and that is far away from the shaft matching surface. One part of the first shaft is located in the inner cavity and is rotatably connected to the shaft sleeve; the part that is of the first shaft and that is located in the inner cavity passes through the through hole of the driven member, and fits with the shaft matching surface of the driven member to form a cam mechanism; and the other part of the first shaft is located outside the inner cavity and is fixedly connected to the second part. The first part can rotate relative to the second part by using the rotating shaft assembly. In a process in which the host is switched from the closed state to the open state, a rotation stroke of the first part sequentially includes a first stroke segment, a second stroke segment, and a third stroke segment. In the first stroke segment, the driven member can move along the first shaft under driving of an elastic force of the elastic member, and the driven member can rotate around the first shaft under a joint action of the cam mechanism and the elastic member, to drive the shaft sleeve to rotate around the first shaft, so that the shaft sleeve drives the first part to rotate relative to the second part. In the second stroke segment, the first part can rotate relative to the second part under driving of an external force, to drive the shaft sleeve and the driven member to rotate around the first shaft. In the third stroke segment, the driven member can move along the first shaft under driving of the elastic force of the elastic member, and the driven member can rotate around the first shaft under the j oint action of the cam mechanism and the elastic member, to drive the shaft sleeve to rotate around the first shaft, so that the shaft sleeve drives the first part to rotate relative to the second part. In this solution, based on a structure design of the rotating shaft assembly, the first part has different motion features in each stroke segment. This can create special hand feeling for the user and greatly improve user experience.

In an implementation, the shaft matching surface includes a first slope, a plane, and a second slope that are sequentially connected. The first slope and the plane form an obtuse angle. The plane and the second slope form an obtuse angle. The first slope, the plane, and the second slope form a two-step ladder. In the first stroke segment, the first slope is in sliding contact with the part that is of the first shaft and that is located in the inner cavity. In the second stroke segment, the plane is in sliding contact with the part that is of the first shaft and that is located in the inner cavity. In the third stroke segment, the second slope is in sliding contact with the part that is of the first shaft and that is located in the inner cavity. In this solution, a three-segment stroke design of the first part can be reliably implemented by designing a cam matching surface.

In an implementation, the rotating shaft assembly includes the shaft sleeve, a second shaft, and a flexible circuit board. The shaft sleeve has the inner cavity. A channel is formed on the second shaft in an axial direction of the second shaft. One part of the second shaft is located in the inner cavity and is rotatably connected to the shaft sleeve, and the other part of the second shaft is located outside the inner cavity. The flexible circuit board includes a first electrical connection end, a mounting part, and a second connection end. The mounting part is located between the first electrical connection end and the second electrical connection end, and the mounting part includes a wound part and a laminated part that are connected to each other. When the flexible circuit board is mounted on the second shaft, both the first electrical connection end and the second electrical connection end are located outside the inner cavity, the wound part is wound around a part that is of the second shaft and that is located in the inner cavity, the laminated part is in a folded state, and at least one part of the laminated part is accommodated in the channel of the second shaft. The first part has a first host circuit board assembly, and the first host circuit board assembly is electrically connected to the first electrical connection end. The second part has a second host circuit board assembly, and the second host circuit board assembly is electrically connected to the second electrical connection end. The first part is fixedly connected to the outer side of the shaft sleeve, the second part is fixedly connected to a part that is of the second shaft and that is located outside the inner cavity, and the first part can rotate relative to the second part by using the rotating shaft assembly. In this solution, based on a structure design of the rotating shaft assembly, the two parts of the host can implement electrical connection and communication by using the rotating shaft assembly. This ensures normal operation of the host.

In an implementation, the first host circuit board assembly includes a circuit board, and the circuit board has a grounding point and a feeding point. The first part includes a first host housing, the first host housing is fixedly connected to the outer side of the shaft sleeve, and the first host circuit board assembly is fastened to a side that is of the first host housing and that is far away from the shaft sleeve. The first host housing is electrically connected to both the grounding point and the feeding point, and the first host housing is used as an antenna of the host. In this solution, based on a proper structure design, an antenna function of the host is implemented by using the first host housing.

In an implementation, the shaft assembly includes a shaft contact member. The shaft contact member is fastened in the shaft sleeve, and is in sliding contact with the part that is of the second shaft and that is located in the inner cavity. The second part includes a third host housing, the third host housing is fixedly connected to the part that is of the second shaft and that is located outside the inner cavity, and the third host housing is used as an antenna of the host. In this solution, based on a proper structure design, an antenna system is constructed by using the first host housing, the rotating shaft assembly, and the third host housing, to implement an antenna function of the host.

In an implementation, when the host is closed, there is a gap between the first host housing and the third host housing, and the first host housing and the second host housing are coupled. In this solution, a feeding path in a coupling manner is designed, so that different communication requirements of the host in the open state and the closed state can be met, and antenna performance of the host in different states can be ensured.

In an implementation, the first part is one of a cover of the host and a body of the host, and the second part is the other of the cover and the body. The host includes an open button, and the open button includes a cap, an elastic member, and a touch-sensitive spring. A part of the cap is located in the second part, and the other part of the cap is located outside the second part. The cap is movably connected to the second part. The cap has a bump located in the second part. The elastic member is mounted in the second part to provide a rebound force for the cap. The touch-sensitive spring is located in the second part, and the touch-sensitive spring is spaced opposite to the bump of the cap. When the host is closed, the cap and the first part form a buckle connection, to latch the first part and the second part. When being pressed, the cap can move into the second part, so that the buckle connection is released, and the bump of the cap presses the touch-sensitive spring. In this solution, the open button having the foregoing structure is designed, so that the host can be opened and closed.

In an implementation, the earphone and the first accommodation groove match in shape, and/or the earphone and the third accommodation groove match in shape. An internal space of the host can be fully utilized to accommodate the earphone by matching the earphone with an internal shape of the host, to ensure a compact structure and a beautiful appearance of the host.

In an implementation, the earphone includes an earplug, the first electrode, an earphone front housing, the second electrode, and an earphone rear housing. The first electrode is located between the earplug and the earphone front housing. The earphone front housing is connected to the first electrode and the second electrode. The second electrode is connected to the earphone front housing and the earphone rear housing. When the earphone is accommodated in the first accommodation groove or the third accommodation groove, the earplug faces the rotating shaft assembly, and the earphone rear housing is far away from the rotating shaft assembly. The earphone is placed in the host in the foregoing posture, so that the user can quickly wear the earphone after taking out the earphone from the host. This meets an ergonomic requirement.

In an implementation, the host includes a smartwatch. In this solution, a wireless earphone can be directly accommodated in the smartwatch, and product forms of the wireless earphone and the smartwatch are integrated, to reduce devices that need to be carried by the user. This improves user experience.

### BRIEF DESCRIPTION OF DRAWINGS

FIG. 1 is a schematic diagram of an assembly structure of a wearable device according to an embodiment of this application;
FIG. 2 is a schematic diagram of an assembly structure of a wearable device according to an embodiment of this application;
FIG. 3 is a schematic diagram of an assembly structure of a wearable device according to an embodiment of this application;
FIG. 4 is a schematic diagram of an assembly structure of a wearable device according to an embodiment of this application;
FIG. 5 is a schematic diagram of an assembly structure of a wearable device according to an embodiment of this application;
FIG. 6 is a schematic exploded view of a structure of a wearable device according to an embodiment of this application;
FIG. 7 is a schematic diagram of an assembly structure of a first host housing of the wearable device in FIG. 6;
FIG. 8 is a schematic exploded view of a structure of the first host housing in FIG. 7;
FIG. 9 is a schematic diagram of an assembly structure of a first host housing of the wearable device in FIG. 6;
FIG. 10 is a schematic diagram of an assembly structure of a latch portion of the first host housing in FIG. 8;
FIG. 11 is a schematic exploded view of a structure of a magnet assembly of the first host housing in FIG. 8;
FIG. 12 is a schematic diagram of a structure of a sealing bracket of the first host housing in FIG. 8;
FIG. 13 is a schematic diagram of an A-A sectional structure of the first host housing in FIG. 9;
FIG. 14 is a schematic diagram of a partially enlarged structure at a position B in FIG. 13;
FIG. 15 is a schematic diagram of a structure of a first host circuit board assembly of the wearable device in FIG. 6;
FIG. 16 is a schematic diagram of a structure of a second host housing of the wearable device in FIG. 6;
FIG. 17 is a schematic diagram of a structure of a second host housing of the wearable device in FIG. 6;
FIG. 18 is a schematic exploded view of a structure of the second host housing in FIG. 17;
FIG. 19 is a schematic diagram of a structure of a second bracket of the second host housing in FIG. 16;
FIG. 20 is a schematic diagram of an assembly structure including a second host housing and a host battery;
FIG. 21 is a schematic diagram of an assembly structure of a third host housing of the wearable device in FIG. 6;
FIG. 22 is a schematic diagram of an assembly structure of a third host housing of the wearable device in FIG. 6;
FIG. 23 is a schematic diagram of a partially enlarged structure at a position A in FIG. 22;
FIG. 24 is a schematic diagram of an assembly structure of a third host housing of the wearable device in FIG. 6;
FIG. 25 is a schematic diagram of an assembly structure of an open button of the wearable device in FIG. 6;
FIG. 26 is a schematic exploded view of a structure of the open button in FIG. 25;
FIG. 27 is a schematic diagram of a structure of a cap of the open button in FIG. 25;
FIG. 28 is a schematic diagram of a structure of a button support of the open button in FIG. 25;
FIG. 29 is a schematic diagram of a structure of a touch-sensitive spring of the open button in FIG. 25;
FIG. 30 is a schematic diagram of an assembly structure including an open button and a third host housing;
FIG. 31 is a schematic diagram of an A-A sectional structure in FIG. 30;
FIG. 32 is a schematic diagram of an assembly structure including an open button and a first host housing;
FIG. 33 is a schematic diagram of a partially enlarged structure at a position B in FIG. 32;
FIG. 34 is a schematic diagram of an assembly structure including a second host housing, a third host housing, and an open button;
FIG. 35 is a schematic diagram of an assembly structure of a fourth host housing of the wearable device in FIG. 6;
FIG. 36 is a schematic diagram of an assembly structure of a fourth host housing of the wearable device in FIG. 6;
FIG. 37 is a schematic exploded view of a structure of the fourth host housing in FIG. 36;
FIG. 38 is a schematic diagram of an assembly structure of a rotating shaft assembly of the wearable device in FIG. 6;
FIG. 39 is a schematic diagram of an A-A sectional structure in FIG. 38;
FIG. 40 is a schematic exploded view of a structure of the rotating shaft assembly in FIG. 38;
FIG. 41 is a schematic diagram of a structure of a shaft sleeve in a rotating shaft assembly;
FIG. 42 is a schematic diagram of a B-B sectional structure of the shaft sleeve in FIG. 41;
FIG. 43 is a schematic diagram of a structure of a shaft sleeve in a rotating shaft assembly;
FIG. 44 is a schematic diagram of a structure of a shaft sleeve in a rotating shaft assembly;
FIG. 45 is a schematic diagram of a structure of a bump matching member in a rotating shaft assembly;
FIG. 46 is a schematic diagram of a structure of a driven member in a rotating shaft assembly;
FIG. 47 is a schematic diagram of an A-A sectional structure of the driven member in FIG. 46;
FIG. 48 is a schematic diagram of a structure of a driven member in a rotating shaft assembly;
FIG. 49 is a schematic diagram of a structure of a gasket in a rotating shaft assembly;
FIG. 50 is a schematic diagram of a structure of a gasket in a rotating shaft assembly;
FIG. 51 is a schematic diagram of a structure of a first shaft in a rotating shaft assembly;
FIG. 52 is a schematic diagram of a structure of a first shaft in a rotating shaft assembly;
FIG. 53 is a schematic diagram of a structure of a first shaft in a rotating shaft assembly;
FIG. 54 is a schematic diagram of an assembly structure including a first shaft, a driven member, and an elastic member in a rotating shaft assembly;
FIG. 55 is a schematic diagram of a structure of a limiting member in a rotating shaft assembly;
FIG. 56 is a schematic diagram of a structure of a second shaft in a rotating shaft assembly;
FIG. 57 is a schematic diagram of a structure of a second shaft in a rotating shaft assembly;
FIG. 58 is a schematic diagram of a structure of a second shaft in a rotating shaft assembly;
FIG. 59 is a schematic diagram of a structure of a flexible circuit board in a rotating shaft assembly;
FIG. 60 is a schematic diagram of a structure of a flexible circuit board in a rotating shaft assembly;
FIG. 61 is a schematic diagram of a structure of a flexible circuit board in a rotating shaft assembly;
FIG. 62 is a schematic diagram of an assembly structure including a second shaft and a flexible circuit board in a rotating shaft assembly;
FIG. 63 is a schematic diagram of an assembly structure including a second shaft and a flexible circuit board in a rotating shaft assembly;
FIG. 64 is a schematic diagram of an assembly structure of a rotating shaft assembly;
FIG. 65 is a schematic diagram of a structure of a clamping member in a rotating shaft assembly;
FIG. 66 is a schematic diagram of an assembly structure of a rotating shaft assembly;
FIG. 67 is a schematic diagram of a sectional structure of a rotating shaft assembly;
FIG. 68 is a schematic diagram of an assembly structure including a rotating shaft assembly and a third host housing;
FIG. 69 is a schematic diagram of an assembly structure including a rotating shaft assembly, a third host housing, and a second host housing;
FIG. 70 is a schematic diagram of an assembly structure including a rotating shaft assembly, a third host housing, a second host housing, and a first host housing;
FIG. 71 is a schematic diagram of a partially enlarged structure at a position A in FIG. 70;
FIG. 72 is a schematic diagram of an assembly structure of a host in a wearable device;
FIG. 73 is a schematic partial sectional view of an assembly structure of a host in a wearable device;
FIG. 74 is a schematic diagram of a sectional structure of a rotating shaft assembly;
FIG. 75 is a schematic diagram of a partially enlarged structure at a position B in FIG. 74;
FIG. 76 is a schematic diagram of an A-A sectional structure of the structure shown in FIG. 75;
FIG. 77 is a schematic diagram of a matching structure including a first shaft, a driven member, and an elastic member in a rotating shaft assembly;
FIG. 78 is a schematic diagram of a structure showing a matching state of a shaft sleeve and a bump matching member in a rotating shaft assembly;
FIG. 79 is a schematic diagram of a matching structure including a first shaft, a driven member, and an elastic member in a rotating shaft assembly;
FIG. 80 is a schematic diagram of a structure showing a matching state of a shaft sleeve and a bump matching member in a rotating shaft assembly;
FIG. 81 is a schematic diagram of a matching structure including a first shaft, a driven member, and an elastic member in a rotating shaft assembly;
FIG. 82 is a schematic diagram of a structure showing a matching state of a shaft sleeve and a bump matching member in a rotating shaft assembly;
FIG. 83 is a schematic diagram of a structure in which a first part of a host is opened to a limit position relative to a second part;
FIG. 84 is a schematic diagram of a partially enlarged structure at a position A in FIG. 83;
FIG. 85 is a schematic diagram of an assembly structure of a first earphone of the wearable device in FIG. 6;
FIG. 86 is a schematic exploded view of a structure of the first earphone in FIG. 85;
FIG. 87 is a schematic diagram of an assembly structure of an earphone front-housing assembly in a first earphone;
FIG. 88 is a schematic diagram of an assembly structure of an earphone front-housing assembly in a first earphone;
FIG. 89 is a schematic exploded view of a structure of an earphone front-housing assembly in a first earphone;
FIG. 90 is a schematic diagram of an A-A sectional structure of the earphone front-housing assembly in FIG. 88;
FIG. 91 is a schematic diagram of a structure in which a clamp clamps an intermediate assembly;
FIG. 92 is a schematic exploded view of a structure of an assembly jig according to an embodiment of this application;
FIG. 93 is a schematic diagram of a structure of a base of an assembly jig;
FIG. 94 is a schematic diagram of a structure of a base of an assembly jig;
FIG. 95 is a schematic diagram of a structure of an upper cover of an assembly jig;
FIG. 96 is a schematic diagram of a structure of an upper cover of an assembly jig;
FIG. 97 is a schematic diagram of a structure in which a clamp and an intermediate assembly are placed into a base;
FIG. 98 is a schematic diagram of a structure in which an upper cover matches a base;
FIG. 99 is a schematic diagram of a structure in which an upper cover matches a base;
FIG. 100 is a schematic diagram of a partially enlarged structure at a position A in FIG. 99;
FIG. 101 is a schematic diagram of a structure in which an earphone magnet is mounted into an assembly jig;
FIG. 102 is a schematic diagram of a structure of a first electrode of a first earphone;
FIG. 103 is a schematic diagram of a structure of an earplug support assembly of a first earphone;
FIG. 104 is a schematic diagram of a structure of an earplug support assembly of a first earphone;
FIG. 105 is a schematic exploded view of a structure of an earplug support assembly;
FIG. 106 is a schematic diagram of a structure of an earplug support in an earplug support assembly;
FIG. 107 is a schematic diagram of a structure of an earplug of a first earphone;
FIG. 108 is a schematic diagram of a structure of an earplug of a first earphone;
FIG. 109 is a schematic diagram of an A-A sectional structure of the earplug in FIG. 108;
FIG. 110 is a schematic diagram of structures of several voice pickup through holes of an earplug inner cover in an earplug;
FIG. 111 is a schematic diagram of a structure of a second electrode of a first earphone;
FIG. 112 is a schematic exploded view of a structure of an earphone rear-housing assembly in a first earphone;
FIG. 113 is a schematic diagram of an assembly structure of an earphone rear-housing assembly;
FIG. 114 is a schematic diagram of a structure of an earphone rear housing in an earphone rear-housing assembly;
FIG. 115 is a schematic diagram of an A-A sectional structure of an earphone rear housing in FIG. 112;
FIG. 116 is a schematic diagram of a structure of an antenna in an earphone rear-housing assembly;
FIG. 117 is a schematic diagram of another structure of an antenna in an earphone rear-housing assembly;
FIG. 118 is a schematic diagram of another structure of an antenna in an earphone rear-housing assembly;
FIG. 119 is a schematic diagram of a structure of a rear housing support in an earphone rear-housing assembly;
FIG. 120 is a schematic diagram of a B-B sectional structure of the earphone rear-housing assembly in FIG. 113;
FIG. 121 is a schematic diagram of a sectional structure of a first earphone;
FIG. 122 is a schematic diagram of a partially enlarged structure at a position A in FIG. 121;
FIG. 123 is a schematic diagram of a structure of another first earphone;
FIG. 124 is a schematic diagram of a structure of another first earphone;
FIG. 125 is a schematic diagram of a structure of an electronic assembly in a first earphone;
FIG. 126 is a schematic diagram of a structure of an electronic assembly in a first earphone;
FIG. 127 is a schematic diagram of a sectional structure of a first earphone;
FIG. 128 is a schematic diagram of a partially enlarged structure at a position A in FIG. 127;
FIG. 129 is a schematic diagram of a partially enlarged structure at a position B in FIG. 127;
FIG. 130 is a schematic diagram of a matching relationship between a first host attachment magnet in a host and an earphone magnet in a first earphone;
FIG. 131 is a schematic diagram of a magnet design of a first host attachment magnet and an earphone magnet;
FIG. 132 is a schematic diagram of another magnet design of a first host attachment magnet and an earphone magnet;
FIG. 133 is a schematic diagram of another magnet design of a first host attachment magnet and an earphone magnet;
FIG. 134 is a schematic diagram of another magnet design of a first host attachment magnet and an earphone magnet;
FIG. 135 is a schematic diagram of a design in which a first host attachment magnet is magnetically attached to a first electrode and a second electrode in an earphone;
FIG. 136 is a schematic diagram of a structure in which a first earphone is attached to a first part after a host is opened;
FIG. 137 is a schematic diagram of a process in which a first earphone is automatically placed in position when the first earphone is placed from outside of a host to a first part;
FIG. 138 is a schematic diagram of a process in which a first earphone is automatically placed in position when the first earphone is placed from outside of a host to a first part;
FIG. 139 is a schematic diagram of a process in which a first earphone is automatically placed in position when the first earphone is placed from outside of a host to a first part;
FIG. 140 is a schematic diagram of detecting an open state and a closed state of a host;
FIG. 141 is a schematic diagram in which a host detects an in-box/out-box state of an earphone;
FIG. 142 is a schematic diagram in which an earphone detects an in-box/out-box state of the earphone; and
FIG. 143 is a schematic diagram in which a host performs foreign matter detection.

### DESCRIPTION OF EMBODIMENTS

The following embodiments of this application provide a wearable device. The wearable device is a brand-new product form in which a host and an earphone are integrated. A product form of the host includes but is not limited to electronic devices such as a smartwatch, an electronic sphygmomanometer, a smart band, a smart helmet, smart clothing, smart glasses, mobile Wi-Fi, and a smart backpack. The earphone is a wireless earphone, and includes but is not limited to a Bluetooth earphone (for example, a true wireless stereo (True Wireless Stereo, TWS) earphone), an infrared earphone, and the like. The following uses an example in which the host has a product form of a smartwatch and the earphone is a Bluetooth earphone for description.

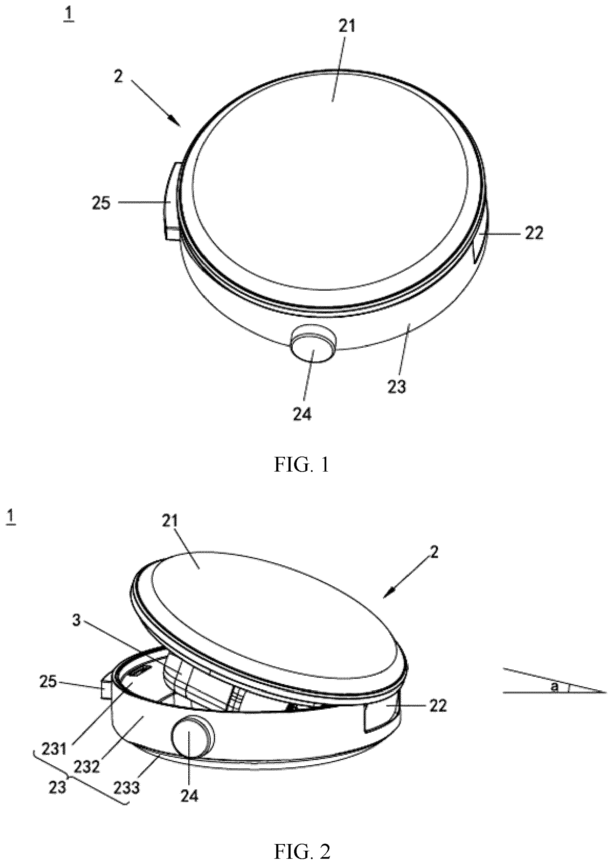

As shown in FIG. 1, FIG. 2, FIG. 3, FIG. 4, and FIG. 5, a wearable device 1 in this embodiment may include a host 2 and earphones 3, and the earphones 3 may be accommodated in the host 2. The following first describes a related design of the host 2, then describes a related design of the earphones 3, and finally describes an overall feature and functions of the wearable device 1.

### Product form and motion design of the host 2

As shown in FIG. 1 to FIG. 4, the host 2 may include a first part 21, a rotating shaft assembly 22, a second part 23, a function button 24, and an open button 25. The first part 21 may be referred to as a cover, and the second part 23 may be referred to as a body.

The host 2 may further include a wrist strap that may be connected to two opposite sides of the second part 23.

As shown in FIG. 1 to FIG. 3, the rotating shaft assembly 22 is connected to the first part 21 and the second part 23, and the first part 21 can rotate relative to the second part 23 through the rotating shaft assembly 22, so that the host 2 is in a closed state or an open state. When the host 2 is closed, the first part 21 and the second part 23 can enclose an accommodation space, and the earphones 3 are accommodated in the accommodation space.

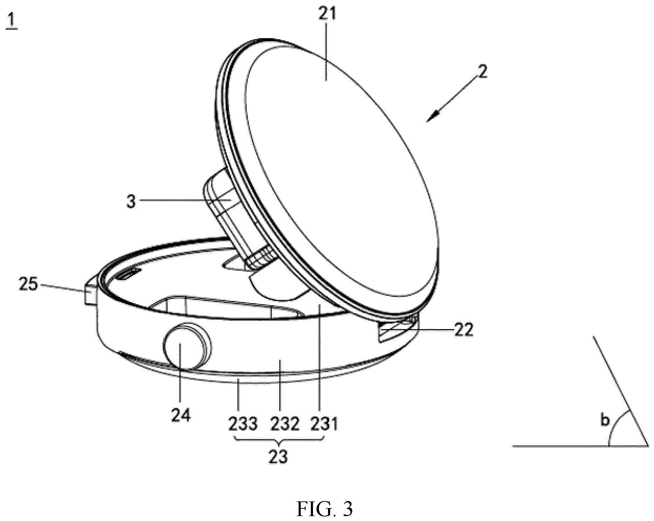

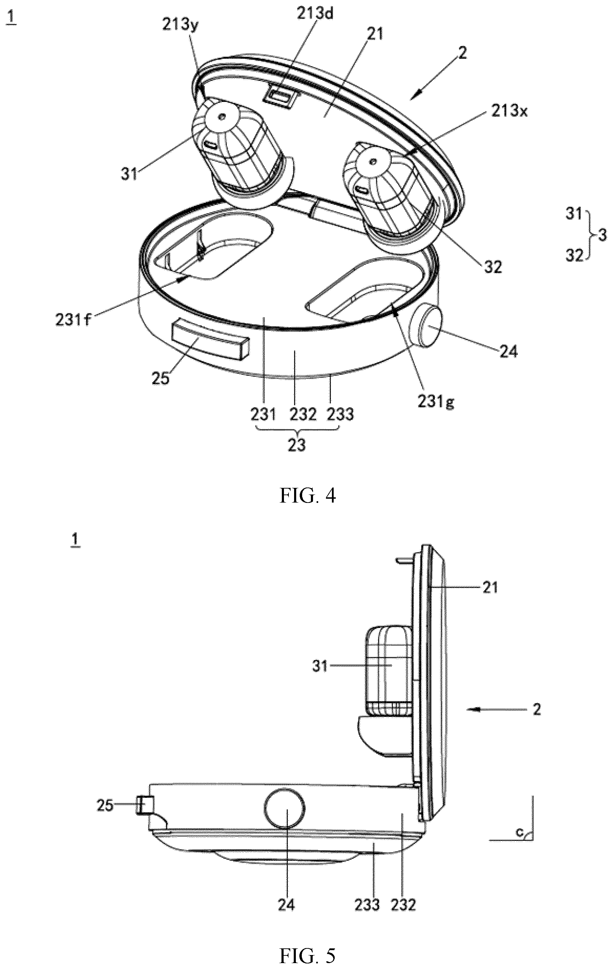

In FIG. 1, the host 2 is in the closed state. In this case, the first part 21 and the second part 23 are latched. In all of FIG. 2 to FIG. 5, the host 2 is in the open state. In this case, the first part 21 is opened at an angle relative to the second part 23. For example, an opening angle a of the first part 21 in FIG. 2 may be approximately 15 degrees; an opening angle b of the first part 21 in FIG. 3 may be approximately 75 degrees; and the first part 21 in FIG. 5 rotates to a limit position, and an opening angle c of the first part 21 may be approximately 90 degrees. It may be understood that a specific value of the opening angle c generated when the first part 21 is in the limit position may be designed based on a product requirement, and is not limited to the foregoing descriptions.

In addition, in this embodiment, as shown in FIG. 2 to FIG. 4, when the host 2 is in the open state, the earphones 3 may be separated from the second part 23 and attached to the first part 21. This design is convenient for a user to take and place the earphones 3 (descriptions are further provided below). In another embodiment, after the host 2 is opened, the earphones 3 may be accommodated in the second part 23.

In this embodiment, based on a special structure design of the rotating shaft assembly 22, a rotation stroke of the first part 21 can be segmented, and the first part 21 has a corresponding rotation feature in each stroke segment. In a specific stroke segment, the first part 21 can provide a touch feeling feedback (a specific principle is described in detail below).

For example, during opening of the closed host 2, the rotation stroke of the first part 21 may be divided into three segments. A stroke from the state shown in FIG. 1 to the state shown in FIG. 2 may represent a first stroke segment of the first part 21. In the first stroke segment, an opening angle of the first part 21 gradually increases to the opening angle a, and the first part 21 automatically rotates under driving of torque of the rotating shaft assembly 22 without an external force. A stroke from the state shown in FIG. 2 to the state shown in FIG. 3 may represent a second stroke segment of the first part 21. In the second stroke segment, the opening angle of the first part 21 gradually increases from the opening angle a to the opening angle b, the rotating shaft assembly 22 no longer provides the torque for the first part 21, and the first part 21 needs to rotate under driving of the external force. A stroke from the state shown in FIG. 3 to the state shown in FIG. 5 may represent a third stroke segment of the first part 21. In the third stroke segment, the opening angle of the first part 21 gradually increases from the opening angle b to the opening angle c, and the first part 21 automatically rotates under torque driving of the rotating shaft assembly 22 without the external force. When the opening angle of the first part 21 is the opening angle c, the torque of the rotating shaft assembly 22 may continue to exist. It is easily understood that the host 2 has a limiting structure, and the first part 21 may maintain a balanced state under a joint action of the limiting structure and the rotating shaft assembly 22.

A flip of a conventional flip electronic device (for example, a notebook computer or a flip mobile phone) can be opened only after the user continuously applies a force, and touch feeling experience is monotonous. However, in this embodiment, the rotation stroke of the first part 21 is segmented by using a structure design of the rotating shaft assembly 22, so that the first part 21 needs to be driven by a force applied by the user only in the second stroke segment, and may automatically rotate in other stroke segments without the force applied by the user. This provides novel touch feeling experience.

Further, in the third stroke segment, the first part 21 is driven by the rotating shaft assembly 22 in a direction away from the second part 23. When the opening angle of the first part 21 reaches the opening angle c, the driving force of the rotating shaft assembly 22 still exists. Therefore, an operation of removing the earphones 3 from the first part 21 by the user does not easily pull the first part 21 toward the second part 23. This design facilitates the user to remove the earphones 3, and can improve user experience.

In another embodiment, a structure of a rotating shaft may be designed, so that the rotation stroke of the first part 21 does not need to be segmented, and the first part 21 rotates in a manner of continuously applying a force by the user or in an always automatic manner.

As shown in FIG. 1 to FIG. 3, the open button 25 may be mounted on the second part 23. The open button 25 and the rotating shaft assembly 22 may be respectively located at two ends in a radial direction of the second part 23. A part of the open button 25 may be exposed outside the second part 23 for the user to press. A latch structure (descriptions are provided below) in the open button 25 may form a detachable connection with a latch structure (descriptions are provided below) in the first part 21. The open button 25 matches the latch structure in the first part 21 to open and close the host 2.

For example, as shown in FIG. 1, when the host 2 is in the closed state, the latch structure in the open button 25 and the latch structure in the first part 21 form the detachable connection.

With reference to FIG. 1 and FIG. 2, when the user needs to open the host 2, the user may press the open button 25, so that the open button 25 generates a mechanism motion, and the latch structure in the open button 25 no longer matches the latch structure in the first part 21. In this case, the first part 21 may automatically open under driving of the rotating shaft assembly 22, and perform the first stroke segment. Conversely, when the user wants to close the host 2, the user can press down the first part 21 to rotate the first part 21 toward the second part 23. When the latch structure in the second part 23 is in contact with the latch structure in the open button 25, the open button 25 generates a mechanism motion, and the latch structure in the open button 25 recovers to match the latch structure in the first part 21.

A specific principle of opening and closing of the host 2 through latch structures of the open button 25 and the first part 21 is described in detail below.

In another embodiment, the open button may alternatively be mounted in the first part, and the second part has a latch structure. The open button matches the latch structure in the second part, to open and close the host. The first part may be the cover, and the second part may be the body. A design in which the open button 25 is mounted on the second part 23 is used as an example for further description below.

The product form and the motion design of the wearable device 1 are briefly described above. The following describes in detail a specific structure of the wearable device 1 in a sequence of the first part 21, the second part 23, the open button 25, the function button 24, and the rotating shaft assembly 22.

### Structure of the host 2

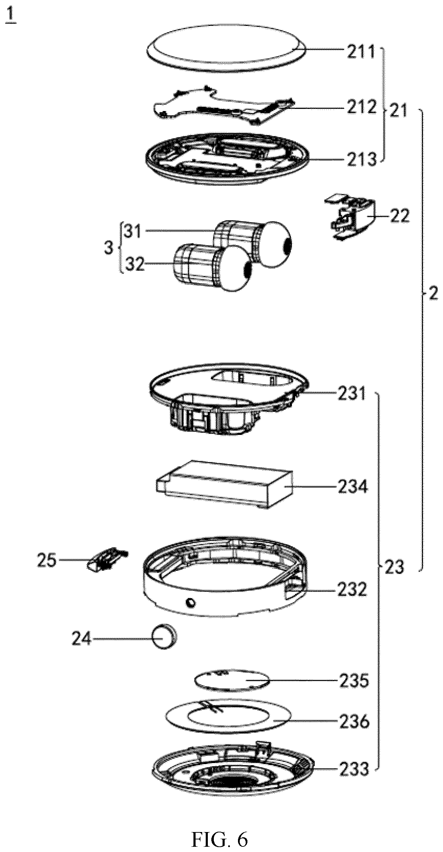

As shown in FIG. 5 and FIG. 6, the first part 21 of the host 2 of the wearable device 1 may include a display 211, a first host circuit board assembly 212, and a first host housing 213. Both the display 211 and the first host circuit board assembly 212 are mounted on the first host housing 213, and the first host circuit board assembly 212 is located between the display 211 and the first host housing 213.

### Structure of the first host housing 213

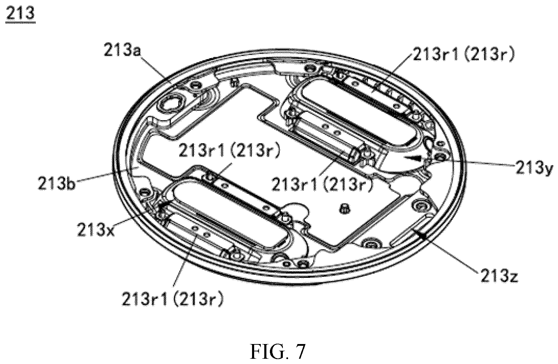

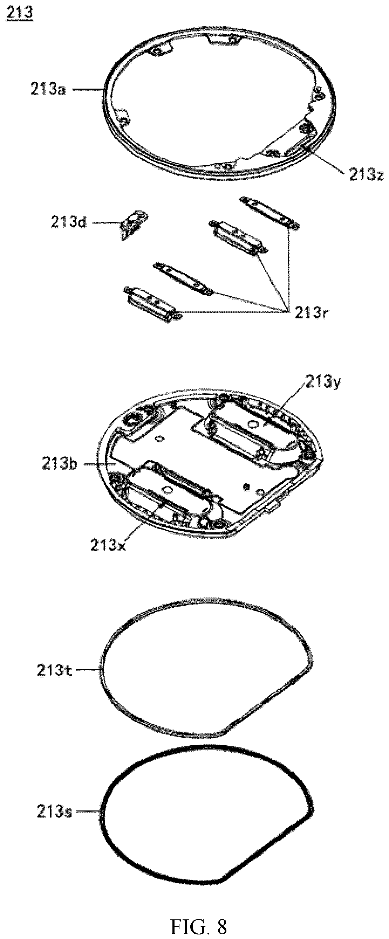

As shown in FIG. 7 and FIG. 8, the first host housing 213 may be approximately in a disk shape. The first host housing 213 may be obtained by assembling several components, for example, may include a first frame body 213a, a first bracket 213b, a magnet assembly 213r, a latch portion 213d (namely, the latch structure in the first part 21 described above), a sealing bracket 213t and a sealing ring 213s.

As shown in FIG. 7 to FIG. 9, the first frame body 213a may be roughly a frame structure having a circular outline. A through hole 213z may be provided on an edge of the first frame body 213a, and the through hole 213z may be a waist-shaped hole (or referred to as a runway-shaped hole). The first frame body 213a may be made of a conductive material, for example, metal. The first frame body 213a may serve as an antenna (descriptions are provided below).

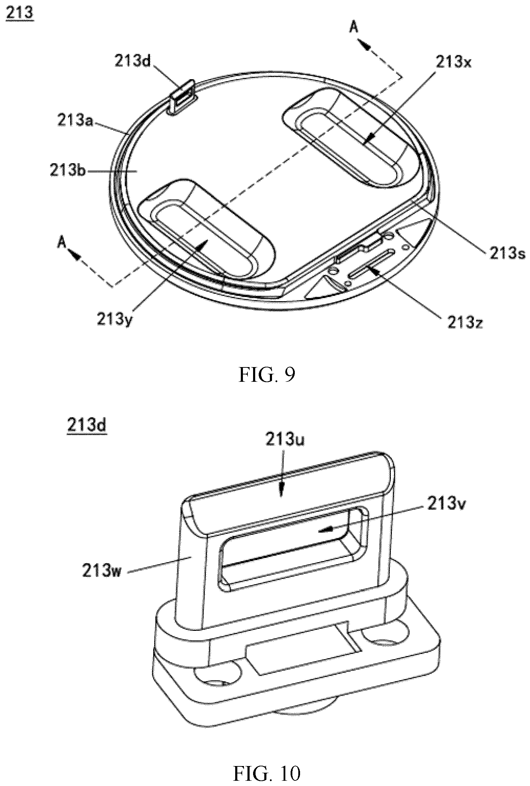

As shown in FIG. 7 to FIG. 9, the first bracket 213b may be approximately of a disk-shaped structure. A first accommodation groove 213y and a second accommodation groove 213x may be formed in a partial region of the first bracket 213b, and the first accommodation groove 213y and the second accommodation groove 213x are spaced from each other. As shown in FIG. 9, when viewed from one side of the first bracket 213b, the partial region in which the first accommodation groove 213y and the second accommodation groove 213x are formed is in a concave shape. As shown in FIG. 7 and FIG. 8, when viewed from the other side of the first bracket 213b, the partial region in which the first accommodation groove 213y and the second accommodation groove 213x are formed is in a convex shape. As shown in FIG. 4 and FIG. 9, the first accommodation groove 213y may be used to accommodate a first earphone 31, and the second accommodation groove 213x may be used to accommodate a second earphone 32.

As shown in FIG. 9, a groove surrounding a periphery of the first bracket 213b may further be provided, and an opening of the groove and an opening of the first accommodation groove 213y are located on a same side of the first bracket 213b. The groove surrounds peripheries of the first accommodation groove 213y and the second accommodation groove 213x. As described below, the groove is used to mount the sealing bracket 213t and the sealing ring 213s.

As shown in FIG. 7 to FIG. 9, the first bracket 213b is fixedly connected to the first frame body 213a, a circumferential region of the first frame body 213a surrounds the periphery of the first bracket 213b, and the through hole 213z of the first frame body 213a is also located on an outer side of the first bracket 213b.

As shown in FIG. 9, the latch portion 213d may be fastened to an edge of the first bracket 213b, and may be disposed opposite to the through hole 213z of the first frame body 213a. With reference to FIG. 9 and FIG. 10, a frame structure 213w may be provided at an end that is of the latch portion 213d and that is far away from the first bracket 213b, and the frame structure 213w may be located on a same side of the first bracket 213b as the opening of the first accommodation groove 213y. A through hole 213v may be provided around the frame structure 213w. A side that is of the frame structure 213w and that is far away from the first bracket 213b may have a slope 213u. The frame structure 213w of the latch portion 213d is used to form a detachable buckle connection (descriptions are provided below) with the latch structure in the open button 25. The slope 213u serves as a guide, so that the frame structure 213w can smoothly match the latch structure in the open button 25.

### Magnet assembly 213r

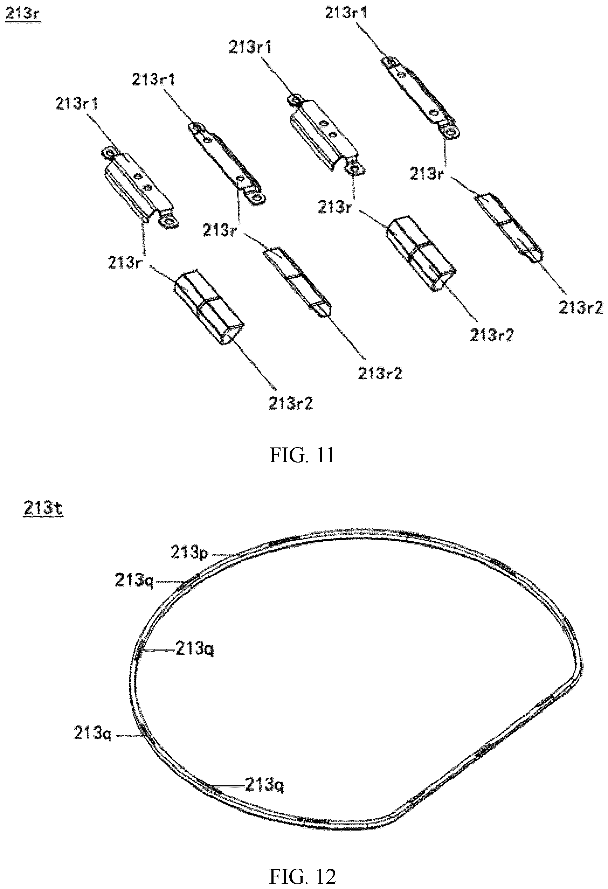

As shown in FIG. 8 and FIG. 11, the magnet assembly 213r may include a fastening bracket 213r1 and a first host attachment magnet 213r2.

For example, the first host attachment magnet 213r2 may be formed by splicing two single magnets, each single magnet has a single magnetic field direction, and the first host attachment magnet 213r2 formed by the two single magnets may have two magnetic field directions. The first host attachment magnet 213r2 may form a Halbach array.

Based on a product requirement, in another embodiment, the first host attachment magnet may be a Halbach array formed by splicing another quantity of single magnets. For example, the first host attachment magnet is a Halbach array formed by splicing three single magnets, and the first host attachment magnet may have three magnetic field directions. Alternatively, the first host attachment magnet is a Halbach array formed by splicing four single magnets, and the first host attachment magnet may have four magnetic field directions.

Alternatively, in another embodiment, the first host attachment magnet may be a single magnet and has a single magnetic field direction. Alternatively, the first host attachment magnet may be a single magnet, but the first host attachment magnet may form a Halbach array having at least two magnetic field directions (which may be obtained by magnetizing different physical regions of a single magnet in different directions).

As shown in FIG. 11 and FIG. 7, the first host attachment magnet 213r2 in this embodiment may match an outer surface of a groove wall of the first accommodation groove 213y (or the second accommodation groove 213x) in the first bracket 213b in shape. The first host attachment magnet 213r2 may be fastened to the outer surface of the groove wall of the first accommodation groove 213y and the outer surface of the groove wall of the second accommodation groove 213x.

As shown in FIG. 11, there may be, for example, four first host attachment magnets 213r2, and structures of the four first host attachment magnets 213r2 may be, for example, consistent. With reference to FIG. 11 and FIG. 7, the four first host attachment magnets 213r2 may be grouped in pairs. A first group is mounted on the outer surface of the groove wall of the first accommodation groove 213y, and two first host attachment magnets 213r2 in the first group may be symmetrically mounted on both sides of the groove wall of the first accommodation groove 213y (for example, left and right sides from the perspective of FIG. 7). A second group is mounted on the outer surface of the groove wall of the second accommodation groove 213x, and two first host attachment magnets 213r2 in the second group are symmetrically mounted on both sides of the groove wall of the second accommodation groove 213x (for example, left and right sides from the perspective of FIG. 7).

In another embodiment, a quantity of first host attachment magnets 213r2 may be designed based on a product requirement, and is not limited to the foregoing descriptions.

As shown in FIG. 11, a quantity of fastening brackets 213r1 may be consistent with the quantity of first host attachment magnets 213r2. For example, there are also four fastening brackets 213r1. With reference to FIG. 11 and FIG. 7, the fastening bracket 213r1 may be mounted on the first bracket 213b, and one fastening bracket 213r1 may correspond to one first host attachment magnet 213r2, so that each first host attachment magnet 213r2 is fastened between one fastening bracket 213r1 and the first bracket 213b.

In this embodiment, the fastening bracket 213r1 can ensure that the first host attachment magnet 213r2 is reliably fastened. In another embodiment, the fastening bracket 213r1 may not be provided based on a product requirement.

### Sealing bracket 213t and sealing ring 213s

As shown in FIG. 8 and FIG. 12, the sealing bracket 213t may be enclosed in a circle and matches the periphery of the first bracket 213b in shape. The sealing bracket 213 may include a bracket main portion 213p, and several protrusions 213q convexly disposed on one side of the bracket main portion 213p. All the protrusions 213q may be spaced from each other. A previous protrusion 213q may be close to an outer side of the bracket main portion 213p, a next protrusion 213q adjacent to the previous protrusion 213q may be close to an inner side of the bracket main portion 213p, and all the protrusions 213q may be arranged according to this rule. In another embodiment, all the protrusions 213q may alternatively not be arranged in a "one inside one outside" manner. For example, all the protrusions 213q may be located on the outer side or the inner side of the bracket main portion 213p.

As shown in FIG. 8, the sealing ring 213s may be enclosed in a circle and matches the sealing bracket 213t in shape. The sealing ring 213s is fixedly connected to the sealing bracket 213t, and the sealing ring 213s and the sealing bracket 213t may be integrally formed, for example, formed by using an integral injection molding technique. The sealing bracket 213t may have a hard material and large structural strength, and is not easily deformed. The sealing ring 213s may have a soft material and small structural strength, and is easily deformed. A component formed by the sealing ring 213s and the sealing bracket 213t may be referred to as a sealing member.

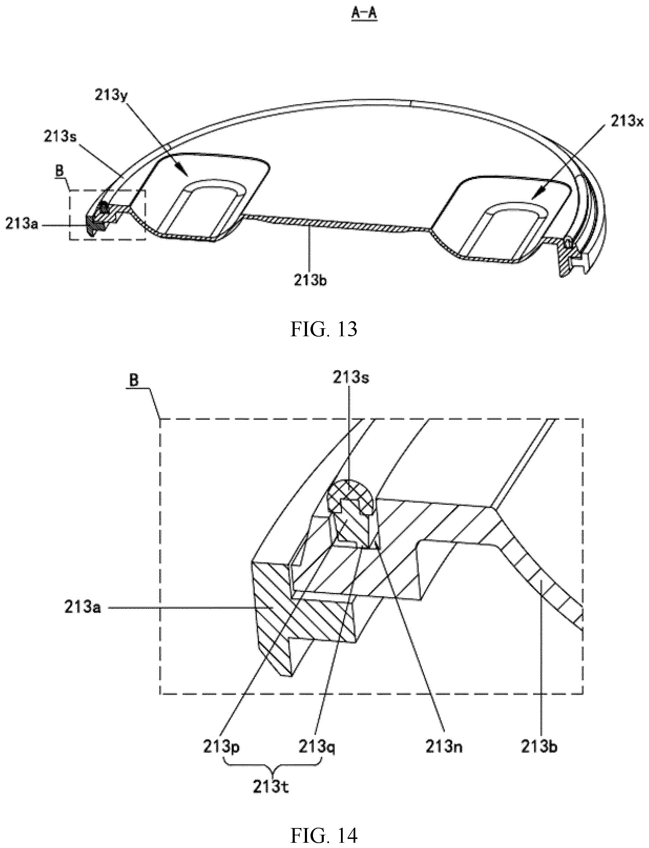

FIG. 13 shows an assembly structure including the first frame body 213a, the first bracket 213b, the sealing bracket 213t, and the sealing ring 213s. FIG. 14 is a partially enlarged view at a position B in FIG. 13.

As shown in FIG. 14, a groove 213n may be provided on the periphery of the first bracket 213b. With reference to FIG. 13 and FIG. 14, the groove 213n surrounds the periphery of the first bracket 213b, and the groove 213n may surround the peripheries of the first accommodation groove 213y and the second accommodation groove 213x. The sealing bracket 213t is fastened in the groove 213n, and the protrusion 213q can be in contact with a bottom surface of the groove 213n. A gap is formed between the bottom surface of the groove 213n and a region that is of the bracket main portion 213p and that is not provided with the protrusion 213q.

The sealing bracket 213t may be bonded to the groove 213n based on, for example, a dispensing technique. An adhesive may be filled in the groove 213n, and is filled in the gap between the bottom surface of the groove 213n and the region that is of the bracket main portion 213p and that is not provided with the protrusion 213q. Because the sealing bracket 213t has several protrusions 213q spaced from each other, several gaps are formed between the sealing bracket 213t and the bottom surface of the groove 213n. This ensures a filling amount of the adhesive, and further ensures adhesive strength. In addition, due to existence of the gap, the adhesive is not easy to overflow, so that a yield of the dispensing technique can be ensured.

As shown in FIG. 14, the sealing ring 213s is located on a side that is of the sealing bracket 213t and that is far away from the protrusion 213q. As explained below, the sealing ring 213s is used to seal a gap between the first bracket 213b and a second host housing 231 of the host 2.

In this embodiment, the groove 213n of the first frame body 213a is narrower, and the sealing ring 213s is thinner and softer (that is, material hardness of the sealing ring 213s is low). It is difficult to separately insert the sealing ring 213s into the groove 213n. However, the sealing ring 213s can be easily assembled to the first frame body 213a by connecting the soft sealing ring 213s to the hard sealing bracket 213t (material hardness of the sealing bracket 213t is high), and then placing the sealing bracket 213t into the groove 213n.

### First host circuit board assembly 212

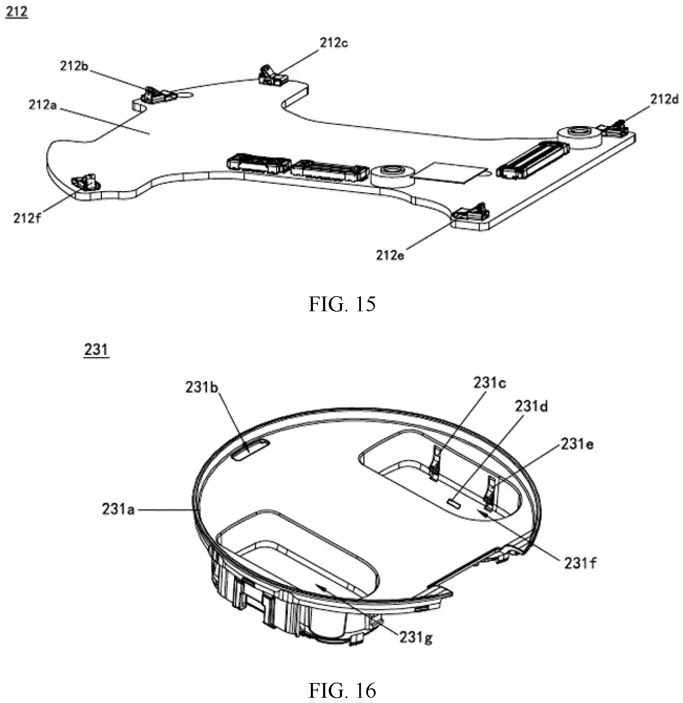

As shown in FIG. 15, the first host circuit board assembly 212 may include a circuit board 212a and components disposed on the circuit board 212a. The circuit board 212a may be, for example, a main circuit board of the host 2. The components on the circuit board 212a may include, for example, a grounding spring 212b, a grounding spring 212c, a grounding spring 212d, a grounding spring 212e, and a feeding spring 212f. The grounding spring 212b, the grounding spring 212c, the grounding spring 212d, and the grounding spring 212e may all be electrically connected to a grounding point on the circuit board 212a, and the feeding spring 212f may be connected to a feeding point on the circuit board 212a. The components on the circuit board 212a may further include a magnetic field sensor like a Hall effect sensor or a magnetometer.

With reference to FIG. 6 and FIG. 7, the first host circuit board assembly 212 may be mounted on a side that is of the first bracket 213b and that is far away from the opening of the first accommodation groove 213y, and is partially located between the groove wall of the first accommodation groove 213y and the groove wall of the second accommodation groove 213x.

### Display 211

As shown in FIG. 6, the display 211 may have a circular outline, and an edge of the display 211 may have a transition rounded corner. The display 211 may be connected to both the first frame body 213a and the first bracket 213b of the first host housing 213. The display 211 may face the first host circuit board assembly 212. The display 211 may be electrically connected to the first host circuit board assembly 212, to implement image display. The display 211 may further have a touch control function.

As shown in FIG. 4 and FIG. 6, the second part 23 of the host 2 of the wearable device 1 may include the second host housing 231, a host battery 234, a third host housing 232, a second host circuit board assembly 235, a wireless charging coil 236, and a fourth host housing 233.

### Second host housing 231

As shown in FIG. 16, FIG. 17, and FIG. 18, the second host housing 231 may include a second bracket 231a, a second charging spring 231c, a first charging spring 231e, a foreign matter detection spring 231d, a status detection magnet 231x, a status detection magnet 231w, and a second host attachment magnet 231v.

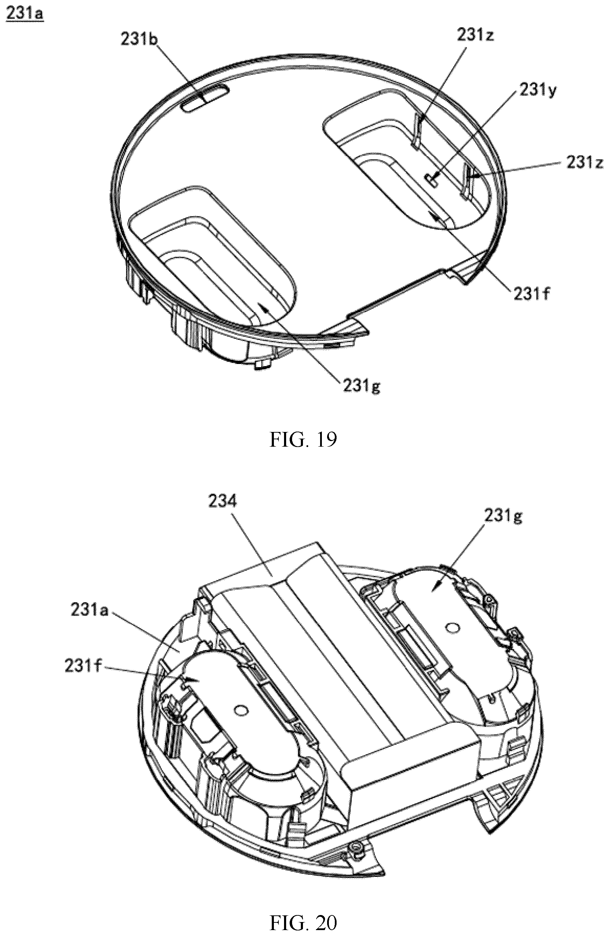

As shown in FIG. 19, the second bracket 231a may have a roughly circular profile. A third accommodation groove 231f and a fourth accommodation groove 231g may be formed in a partial region of the second bracket 231a. The third accommodation groove 231f and the fourth accommodation groove 231g are spaced from each other, and structures of the third accommodation groove 231f and the fourth accommodation groove 231g may be basically consistent. When viewed from one side of the second bracket 231a, the partial region in which the third accommodation groove 231f and the fourth accommodation groove 231g are formed is in a concave shape. When viewed from the other side of the second bracket 231a, the partial region in which the third accommodation groove 231f and the fourth accommodation groove 231g are formed is in a convex shape.

With reference to FIG. 4 and FIG. 19, the third accommodation groove 231f is used to accommodate the first earphone 31, and the fourth accommodation groove 231g is used to accommodate the second earphone 32. When the host 2 is closed, the third accommodation groove 231f and the first accommodation groove 213y enclose an accommodation space for accommodating the first earphone 31, and the fourth accommodation groove 231g and the second accommodation groove 213x enclose an accommodation space for accommodating the second earphone 32.

In this embodiment, a groove depth of the third accommodation groove 231f may be greater than that of the first accommodation groove 213y, and a groove depth of the fourth accommodation groove 231g may be greater than that of the second accommodation groove 213x. The groove depth may be defined as a maximum distance from an opening of an accommodation groove (a collective name of the first accommodation groove 213y, the second accommodation groove 213x, the third accommodation groove 231f, and the fourth accommodation groove 231g) to a groove bottom surface of the accommodation groove in a normal direction of a circuit board in the host 2.

In this embodiment, when the host 2 is opened, the earphones 3 may be attached to the first part 21. One part of the first earphone 31 is located in the first accommodation groove 213y, and the other part is located outside the first accommodation groove 213y. A maximum distance between the part that is of the first earphone 31 and that is located in the first accommodation groove 213y and a plane on which the opening of the first accommodation groove 213y is located may be defined as a first distance. A maximum distance between the part that is of the first earphone 31 and that is located outside the first accommodation groove 213y and the plane on which the opening of the first accommodation groove 213y is located may be defined as a second distance. The first distance is less than the second distance. In other words, when the host 2 is opened, a small part of the first earphone 31 is located in the first accommodation groove 213y, and a large part of the first earphone 31 is exposed outside the first accommodation groove 213y. For the second earphone 32, similarly, when the host 2 is opened, a small part of the second earphone 32 is located in the second accommodation groove 213x, and a large part of the second earphone 32 is located outside the second accommodation groove 213x. The design is further described below.

As shown in FIG. 19, two through holes 231z may be provided on a groove wall of the third accommodation groove 231f. For example, the two through holes 231z may be disposed on a side wall of a side that is of the third accommodation groove 231f and that is far away from the fourth accommodation groove 231g. There is a spacing between the two through holes 231z. The two through holes 231z are respectively used to mount the second charging spring 231c and the first charging spring 231e (descriptions are further provided below). A through hole 231y may be further provided on the groove wall of the third accommodation groove 231f. For example, the through hole 231y may be roughly located on a bottom wall of the third accommodation groove 231f. The through hole 231y is spaced from the two through holes 231z. The through hole 231y is used to mount the foreign matter detection spring 231d (descriptions are further provided below).

As shown in FIG. 19, a groove wall of the fourth accommodation groove 231g may also be provided with the through hole 231z and the through hole 231y (which are collectively referred to as a through hole below). The through holes on the groove wall of the fourth accommodation groove 231g may be located on a side that is of the fourth accommodation groove 231g and that is far away from the third accommodation groove 231f. The through holes on the groove wall of the fourth accommodation groove 231g and the through hole on the groove wall of the third accommodation groove 231f may be basically symmetrically distributed on both sides of a symmetrical plane of the second bracket 231a.

As shown in FIG. 19, a through hole 231b may be formed at an edge of the second bracket 231a. The through hole 231b may be located between the third accommodation groove 231f and the fourth accommodation groove 231g, and distances between the through hole 231b and the third accommodation groove 231f and between the through hole 231b and the fourth accommodation groove 231g may be basically equal. With reference to FIG. 19 and FIG. 4, the through hole 231b is used for the latch portion 213d in the first part 21 to pass through (descriptions are further provided below).

### Charging spring

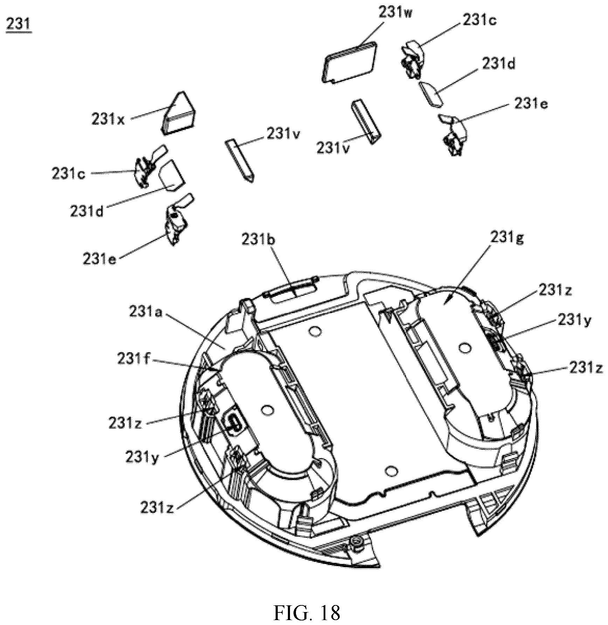

As shown in FIG. 18, there may be two second charging springs 231c and two first charging springs 231e. With reference to FIG. 16 to FIG. 19, one second charging spring 231c and one first charging spring 231e are mounted on the groove wall of the third accommodation groove 231f; and the other second charging spring 231c and the other first charging spring 231e are mounted on the groove wall of the fourth accommodation groove 231g. For the third accommodation groove 231f, the second charging spring 231c may be located at one through hole 231z of the third accommodation groove 231f, and a contact of the second charging spring 231c may extend into the third accommodation groove 231f through the through hole 231z. The first charging spring 231e may be located at the other through hole 231z of the third accommodation groove 231f, and a contact of the first charging spring 231e may extend into the third accommodation groove 231f through the other through hole 231z. For the fourth accommodation groove 231g, the second charging spring 231c may be located at one through hole 231z of the fourth accommodation groove 231g, and the contact of the second charging spring 231c may extend into the fourth accommodation groove 231g through the through hole 231z. The first charging spring 231e may be located at the other through hole 231z of the fourth accommodation groove 231g, and the contact of the first charging spring 231e may extend into the fourth accommodation groove 231g through the other through hole 231z.

In this embodiment, both the two second charging springs 231c and the two first charging springs 231e may be electrically connected to the first host circuit board assembly 212 through a line (for example, a flexible circuit board). The second charging spring 231c and the first charging spring 231e in the third accommodation groove 231f are respectively used to be in elastic contact with two electrodes on the first earphone 31, and the second charging spring 231c and the first charging spring 231e in the fourth accommodation groove 231g are respectively used to be in elastic contact with two electrodes on the second earphone 32 (descriptions are further provided below). Therefore, the first earphone 31 may be charged by using the second charging spring 231c and the first charging spring 231e in the third accommodation groove 231f, and the second earphone 32 may be charged by using the second charging spring 231c and the first charging spring 231e in the fourth accommodation groove 231g.

### Foreign matter detection spring

As shown in FIG. 18, there may be two foreign matter detection springs 231d. With reference to FIG. 16 to FIG. 19, one foreign matter detection spring 231d may be mounted on the groove wall of the third accommodation groove 231f, and the foreign matter detection spring 231d may be located at the through hole 231y of the third accommodation groove 231f. A contact of the foreign matter detection spring 231d may penetrate the through hole 231y. The other foreign matter detection spring 231d may be mounted on the groove wall of the fourth accommodation groove 231g, and the foreign matter detection spring 231d may be located at the through hole 231y of the fourth accommodation groove 231g. A contact of the foreign matter detection spring 231d may penetrate the through hole 231y.

In this embodiment, the foreign matter detection springs 231d may be electrically connected to the first host circuit board assembly 212 through a line (for example, a flexible circuit board). The foreign matter detection springs 231d are used to implement foreign matter detection (detecting whether foreign matter enters the third accommodation groove 231f and the fourth accommodation groove 231g). A specific principle is described below.

### Status detection magnet

As shown in FIG. 18, schematically, the status detection magnet 231x may be a single magnet. The status detection magnet 231x may have a single magnetic field direction, or at least two magnetic field directions (that is, a Halbach array is formed). The status detection magnet 231w may be a single magnet. The status detection magnet 231x may have a single magnetic field direction, or at least two magnetic field directions (namely, a Halbach array).

In another embodiment, the status detection magnet may be a Halbach array formed by splicing at least two single magnets.

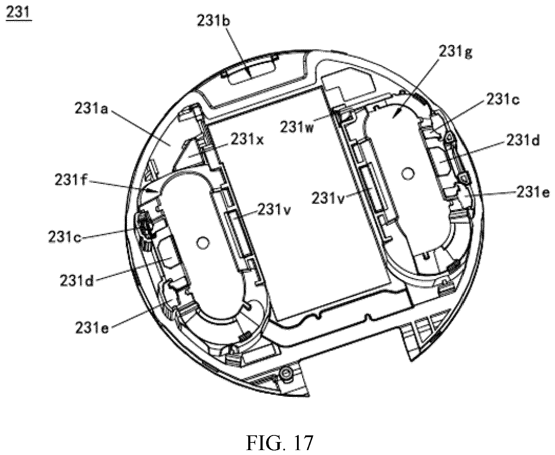

As shown in FIG. 18 and FIG. 17, the status detection magnet 231x may be fastened to a side that is of the second bracket 231a and that is far away from the opening of the third accommodation groove 231f, and the status detection magnet 231x may be adjacent to the groove wall of the third accommodation groove 231f, or may be close to the through hole 231b. The status detection magnet 231w and the status detection magnet 231x are located on a same side of the second bracket 231a, and the status detection magnet 231w may be adjacent to the groove wall of the fourth accommodation groove 231g.

### Second host attachment magnet 231v

As shown in FIG. 18, schematically, the second host attachment magnet 231v may be a single magnet. The second host attachment magnet 231v may have a single magnetic field direction, or at least two magnetic field directions (that is, a Halbach array is formed).

Based on a product requirement, in another embodiment, the second host attachment magnet 231v may alternatively be a Halbach array formed by splicing at least two single magnets.

As shown in FIG. 18 and FIG. 17, there may be, for example, two second host attachment magnets 231v in this embodiment, and structures of the two second host attachment magnets 231v may be, for example, consistent. Each of the two second host attachment magnets 231v may be fastened to the side that is of the second bracket 231a and that is far away from the opening of the third accommodation groove 231f. One second host attachment magnet 231v may be located on a side that is of the groove wall of the third accommodation groove 231f and that faces the fourth accommodation groove 231g; and the other second host attachment magnet 231v may be located on a side that is of the groove wall of the fourth accommodation groove 231g and that faces the third accommodation groove 231f.

In another embodiment, a quantity and positions of second host attachment magnets 231v may be designed based on a product requirement. For example, one second host attachment magnet 231v may be mounted on both sides of the groove wall of the third accommodation groove 231f, and one second host attachment magnet 231v may be mounted on both sides of the groove wall of the fourth accommodation groove 231g.

### Host battery 234

As shown in FIG. 6 and FIG. 20, the host battery 234 may be fastened to the second bracket 231a, and is located on the side that is of the second bracket 231a and that is far away from the opening of the third accommodation groove 231f. The host battery 234 may be located between the groove wall of the third accommodation groove 231f and the groove wall of the fourth accommodation groove 231g. The host battery 234 may be electrically connected to the second host circuit board assembly 235 through a line (for example, a flexible circuit board), and the second host circuit board assembly 235 may be electrically connected to the first host circuit board assembly 212 through a line (for example, a flexible circuit board). Therefore, the host battery 234 can be electrically connected to the first host circuit board assembly 212.

### Third host housing 232

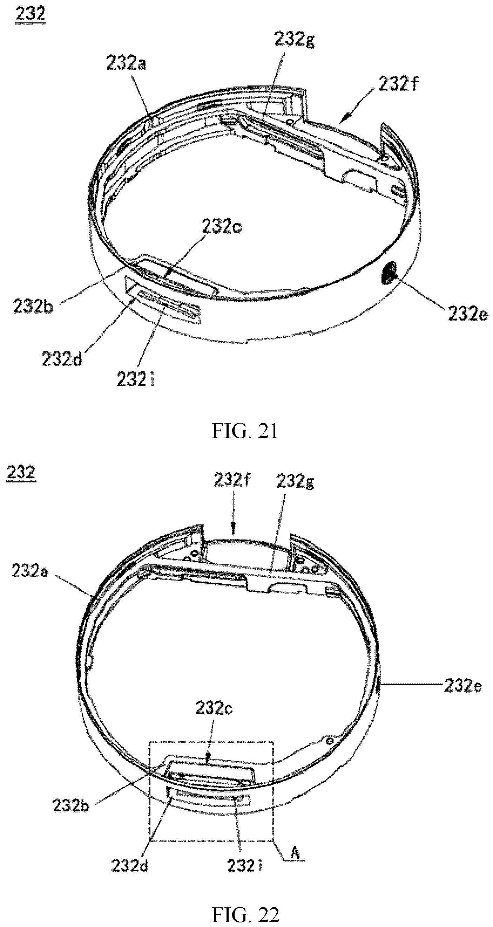

As shown in FIG. 21, the third host housing 232 may be roughly of a ring-shaped structure. The third host housing 232 may include a circumferential side wall 232a, an inner bearing platform 232b, and an inner bearing platform 232g. The circumferential side wall 232a may be enclosed in a ring shape. Both the inner bearing platform 232b and the inner bearing platform 232g are connected to an inner side of the circumferential side wall 232a, and the inner bearing platform 232b and the inner bearing platform 232g may be spaced from each other, for example, roughly located at both ends in a radial direction of the circumferential side wall 232a.

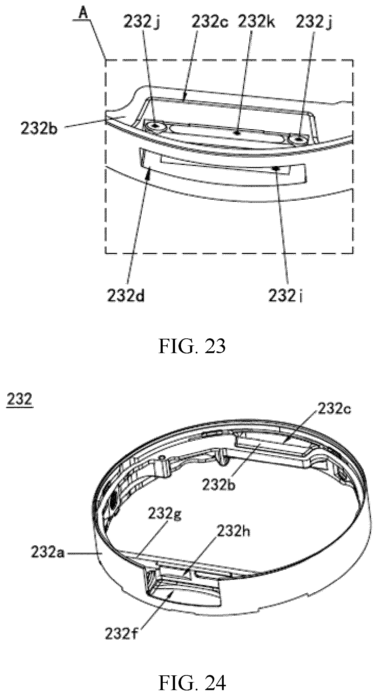

As shown in FIG. 22, the third host housing 232 may have a rotating shaft mounting space 232f, and the rotating shaft mounting space 232f may be a groove formed in the inner bearing platform 232g and penetrating the circumferential side wall 232a. The rotating shaft mounting space 232f is used to mount the rotating shaft assembly 22. As shown in FIG. 24, an inner surface of the rotating shaft mounting space 232f may have a limiting groove 232h, and the limiting groove 232h may be opposite to an opening that is of the rotating shaft mounting space 232f and that is formed on the circumferential side wall 232a.

As shown in FIG. 22, the third host housing 232 may further have an open button mounting space, the open button mounting space may form a second opening 232c on the inner bearing platform 232b, and the open button mounting space may further penetrate the circumferential side wall 232a and form a first opening 232d on the circumferential side wall 232a. The open button mounting space may be opposite to the rotating shaft mounting space 232f. For example, the open button mounting space and the rotating shaft mounting space 232f may be located roughly at two opposite ends of a same diameter of the third host housing 232.

As shown in FIG. 22 and FIG. 23, a groove 232i may be provided on an inner surface that is of the open button mounting space and that is opposite to the second opening 232c. The groove 232i may be an elongated groove. A guiding groove 232j and a groove 232k may be provided on an inner surface that is of the open button mounting space and that is opposite to the first opening 232d. The guiding groove 232j may be a round hole, and there may be two guiding grooves 232j. The groove 232k may be runway-shaped, and the groove 232k may be located between the two guiding grooves 232j.

As shown in FIG. 21 and FIG. 22, the third host housing 232 may further have a function button mounting through hole 232e, and the function button mounting through hole 232e may be opened on the circumferential side wall 232a, and may be located between the rotating shaft mounting space 232f and the first opening 232d. The function button mounting through hole 232e is used to mount the function button 24.

### Open button 25

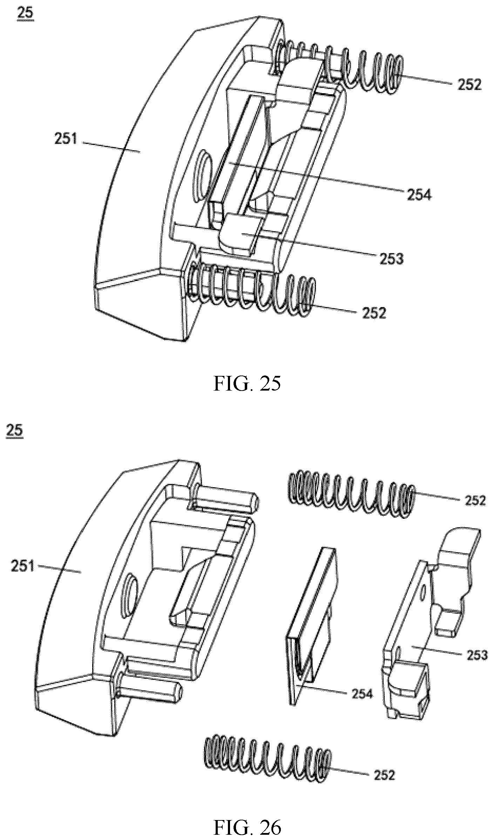

As shown in FIG. 25 and FIG. 26, the open button 25 may include a cap 251, an elastic member 252, a button support 253, and a touch-sensitive spring 254.

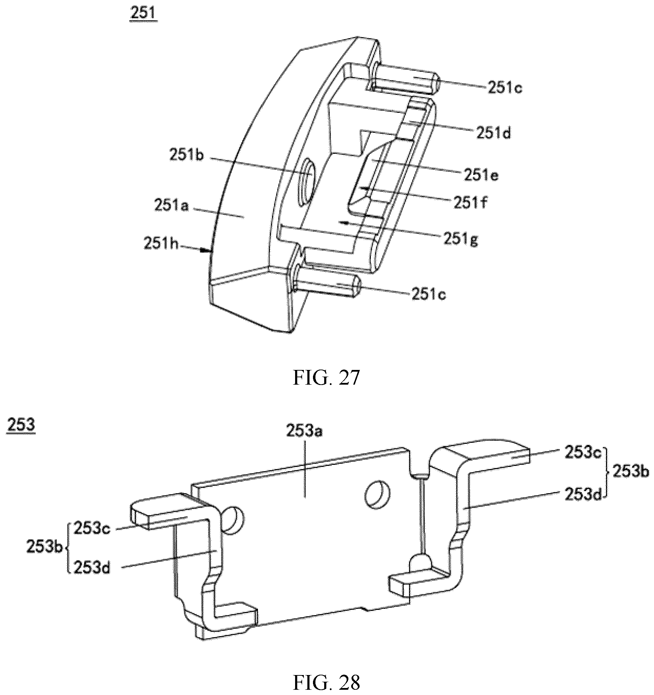

As shown in FIG. 27, the cap 251 may be an integrated frame structure. The cap 251 may include a pressing portion 251a, a bump 251b, a guiding portion 251c, a bearing portion 251d, and a buckle 251e.

As shown in FIG. 27, the pressing portion 251a may be roughly in a long strip shape, and a cross section of the pressing portion 251a is roughly a trapezoid (the cross section may be perpendicular to a length direction of the pressing portion 251a). The pressing portion 251a has a surface 251h, and the surface 251h is a surface on which an upper bottom of the trapezoidal cross section of the pressing portion 251a is located.

As shown in FIG. 27, the bump 251b may be provided on another surface of the pressing portion 251a and is far away from the surface 251h of the pressing portion 251a. A surface of the bump 251b may be a curved surface, a plane, or formed by connecting a curved surface and a plane.

As shown in FIG. 27, the guiding portion 251c may be in a column shape, for example, a cylinder. The guiding portion 251c may be convexly disposed on the another surface of the pressing portion 251a, and the guiding portion 251c and the bump 251b may be located on a same side of the pressing portion 251a. There may be two guiding portions 251c, and the two guiding portions 251c may be respectively located at two opposite ends of the pressing portion 251a. The guiding portions 251c are configured to guide the cap 251 when the cap 251 moves.

As shown in FIG. 27, the bearing portion 251d is connected to a side that is of the pressing portion 251a and that is far away from the surface 251h, and the bearing portion 251d is located between the two guiding portions 251c. The bearing portion 251d may be roughly C-shaped. Two free ends of a C-shaped structure of the bearing portion 251d are connected to the pressing portion 251a. The bearing portion 251d and the pressing portion 251a may jointly form an open space 251g. The bearing portion 251d is used to bear the button support 253.

As shown in FIG. 27, the buckle 251e may be connected to the bearing portion 251d and located in the open space 251g. The buckle 251e may face the bump 251b. The buckle 251e may have an assembly guide slope 251f. The buckle 251e is the latch structure in the open button 25 described above.

As shown in FIG. 25 and FIG. 26, the elastic member 252 may be a spring. Alternatively, the elastic member 252 may be another component that can be elastically telescopic. There may be two elastic members 252. With reference to FIG. 26 and FIG. 27, one elastic member 252 may be sleeved on one guiding portion 251c, and the other elastic member 252 may be sleeved on the other guiding portion 251c.

As shown in FIG. 28, the button support 253 may include a support body 253a and two mounting ears 253b that are respectively connected to two sides of the support body 253a. The support body 253a may be in a flat-plate shape. The mounting ears 253b may be bent plate-like. The mounting ears 253b each may include a first plate 253c and a second plate 253d, and the first plate 253c and the second plate 253d may be roughly bent by 90 degrees. The two first plates 253c in the two mounting ears 253b may be bent backward relative to the second plate 253d. For example, from the perspective of the figure, the first plate 253c on the left side may be bent to the left relative to the second plate 253d on the left side, and the first plate 253c on the right side may be bent to the right relative to the second plate 253d on the right side.

In another embodiment, the two mounting ears may alternatively be bent in a same direction.

With reference to FIG. 27 and FIG. 28, the button support 253 may be mounted in the open space 251g of the cap 251, and the two mounting ears 253b of the button support 253 may be supported on the bearing portion 251d of the cap 251. The button support 253 is configured to fasten the touch-sensitive spring 254, and may be further configured to limit the cap 251 when the cap 251 moves to a limit position.

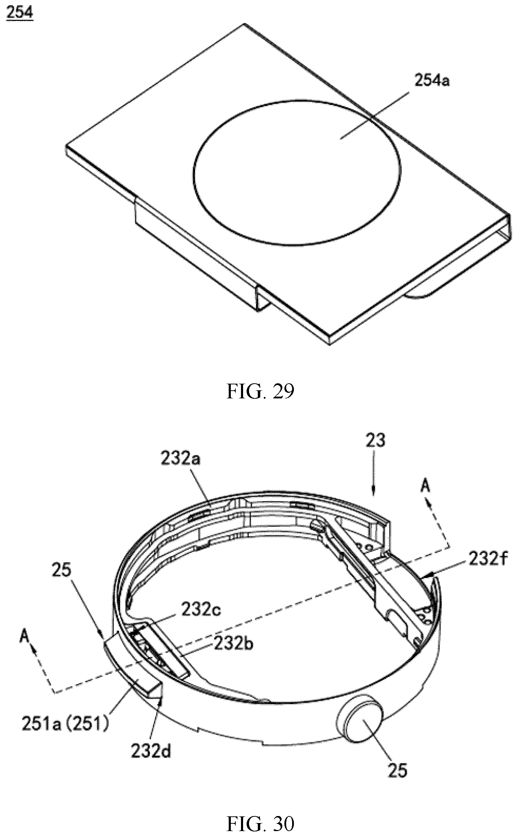

In this embodiment, the touch-sensitive spring 254 has elastic deformation performance, and can be compressed when a force is applied, and rebound after pressure disappears. As shown in FIG. 29, the touch-sensitive spring 254 may be, for example, a dome spring. The dome spring may include a polyethylene glycol terephthalate (polyethylene glycol terephthalate, PET) sheet, a metal dome (or referred to as a button spring), an adhesive, a film, and the like. The touch-sensitive spring 254 may have an elastic region 254a. The elastic region 254a may be in a convex shape when being not pressed, may be in a concave shape after being pressed, and may restore to the convex shape after pressure disappears.

With reference to FIG. 29 and FIG. 25, the touch-sensitive spring 254 may be fastened to the button support 253, and the elastic region 254a may face the bump 251b.

The foregoing describes a detailed structure of the open button 25. The following describes assembly of the open button 25 and the third host housing 232 and matching between the open button 251 and the latch portion 213d on the first bracket 213b.

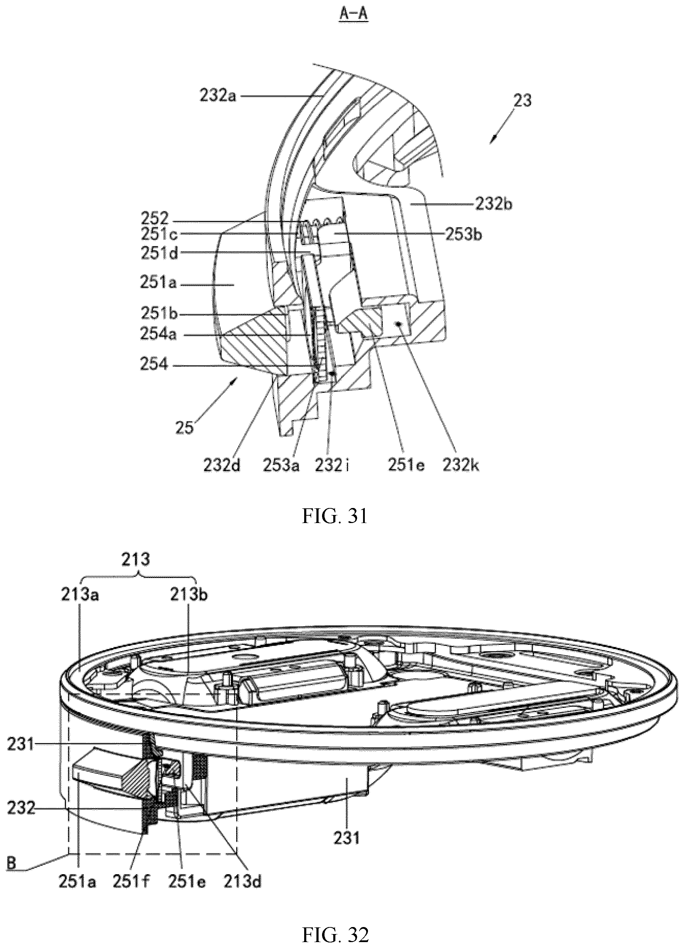

As shown in FIG. 30 and FIG. 31, the open button 25 may be mounted in the open button mounting space of the third host housing 232. A state of the open button 25 shown in FIG. 30 and FIG. 31 corresponds to the closed state of the host 2.

As shown in FIG. 31, the pressing portion 251a may be exposed from the first opening 232d of the open button mounting space. With reference to FIG. 31 and FIG. 23, a part of the guiding portion 251c may be located in the guiding groove 232j, but is not in contact with a bottom surface of the guiding groove 232j. As shown in FIG. 31, a part that is of the bearing portion 251d and that is spaced opposite to the pressing portion 251a may be located in the groove 232k. The buckle 251e may be located in the open button mounting space and outside the groove 232k. The cap 251 can move in an axial direction of the guiding portion 251c. Due to a limiting effect of the first opening 232d on the pressing portion 251a, the cap 251 basically cannot move in other directions.

With reference to FIG. 31 and FIG. 23, the elastic member 252 is sleeved on the guiding portion 251c, and a part of the elastic member 252 may be located in the guiding groove 232j. One end of the elastic member 252 is in contact with the pressing portion 251a, and the other end is in contact with the bottom surface of the guiding groove 232j.

As shown in FIG. 31 and FIG. 27, the button support 253 and the cap 251 may be assembled and fastened in the open button mounting space. The support body 253a of the button support 253 may be located in the open space 251g of the cap 251 and inserted into the groove 232i, and the support body 253a may abut against a side wall of a side that is of the groove 232i and that is close to the first opening 232d. The two mounting ears 253b of the button support 253 may be respectively supported (or referred to as overlapped) on both sides of the bearing portion 251d. Each mounting ear 253b may abut against a part that is of the bearing portion 251d and that is spaced opposite to the pressing portion 251a, so that the cap 251 cannot continue to move out of the open button mounting space. In other words, this is a limiting effect of the button support 253 on the cap 251 at a limit position. Each mounting ear 253b may abut against a top surface of a side wall of the groove 232k (a surface that is of the side wall and that faces the first opening 232d). Therefore, a side wall of the groove 232i and the side wall of the groove 232k may limit the button support 253 in an opposite direction, so that the button support 253 basically cannot move in an axial direction of the guiding groove 232j.

As shown in FIG. 31, the touch-sensitive spring 254 may be fastened to the support body 253a. The touch-sensitive spring 254 may be inserted into the groove 232i, or the touch-sensitive spring 254 may be located outside the groove 232i. The touch-sensitive spring 254 is located between the bump 251b and the buckle 251e, and the elastic region 254a of the touch-sensitive spring 254 faces the bump 251b. There is a specific spacing between the touch-sensitive spring 254 and the buckle 251e.

As shown in FIG. 31, when the user presses the cap 251 from the pressing portion 251a, the cap 251 moves into the open button mounting space. In this case, the guiding portion 251c moves into the guiding groove 232j, and the elastic member 252 is gradually compressed. The bearing portion 251d slides into the groove 232k relative to the mounting ears 253b, and the buckle 251e moves into the groove 232k. The bump 251b is close to the touch-sensitive spring 254. When the bump 251b squeezes the elastic region 254a and enables the elastic region 254a to elastically deform, the user may experience a touch feeling feedback.

On the contrary, when the pressing portion 251a is no longer pressed, the elastic member 252 bounces and pushes the cap 251 to move out of the open button mounting space. In this case, the guiding portion 251c moves out of the guiding groove 232j, and the elastic member 252 is gradually elongated. The bearing portion 251d slides out of the groove 232k relative to the mounting ears 253b, and the buckle 251e moves out of the groove 232k. The bump 251b is far away from the touch-sensitive spring 254. The cap 251 stops moving when the part that is of the bearing portion 251d and that is spaced opposite to the pressing portion 251a abuts against the mounting ear 253b again.

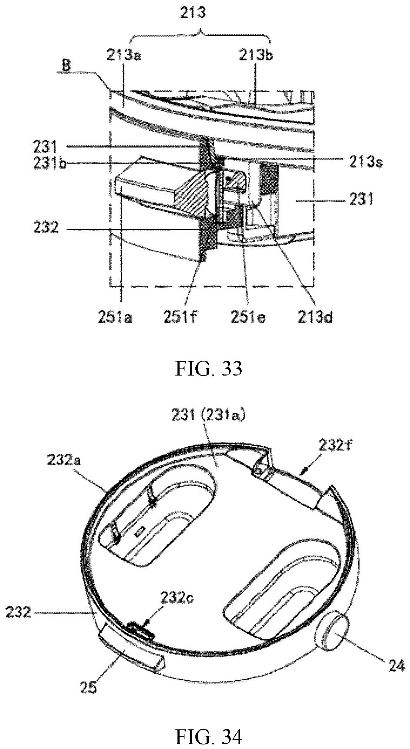

FIG. 32 is a schematic sectional view of an assembly structure including the first host housing 213, the second host housing 231, the third host housing 232, and the open button 25. A sectional view of the first host housing 213 is not provided, to clearly show the assembly structure. FIG. 33 is a partially enlarged view at a position B in FIG. 32.

With reference to FIG. 33 and FIG. 16, the latch portion 213d on the first bracket 213b of the first host housing 213 may pass through the through hole 231b of the second host housing 231, and enter the open button mounting space of the third host housing 232. In addition, the latch portion 213d and the buckle 251e may form a buckle connection, and the buckle connection is a detachable connection. Therefore, the first host housing 213 and the third host housing 232 can be kept closed through matching between the latch portion 213d and the buckle 251e. In other words, the first part 21 and the second part 23 of the host 2 can be closed.

As shown in FIG. 33, when the user presses the pressing portion 251a, the buckle 251e moves and no longer maintains the buckle connection with the latch portion 213d. In this case, the first host housing 213 automatically opens under driving of the rotating shaft assembly 22. When the user wants to latch the first part 21 and the second part 23, after the latch portion 213d is in contact with the buckle 251e, the latch portion 213d can press the buckle 251e until the latch portion 213d forms the buckle connection with the buckle 251e again. In this case, the first part 21 and the second part 23 are latched.

The reciprocating buckle 251e is designed, so that the host 2 can be opened and closed by using the open button 25 in this embodiment. The touch-sensitive spring 254 is designed, so that the touch feeling feedback can be provided when the host 2 is opened. This improves user experience.

In another embodiment, based on a product requirement, the host may be opened and latched by using an open button having another structure. For example, a buckle may be disposed on the first support of the first host housing (the buckle corresponds to the buckle 251e), and a latch portion is disposed in the open button (for example, the latch portion is disposed on the bearing portion of the cap, and the latch portion corresponds to the latch portion 213d). Alternatively, for example, a torsion spring mechanism may be used to provide a rebound force for a movable cap, a buckle (or a latch portion) is designed on the cap of the open button, and the host is opened and closed through matching between the buckle (or the latch portion) and the buckle (or the latch portion) that is on the first bracket of the first host housing. In another embodiment, the touch-sensitive spring may not be disposed.

In addition, with reference to FIG. 33 and FIG. 13, when the first part 21 and the second part 23 are closed, the first bracket 213b and the second host housing 231 are closed and match with each other, and the sealing ring 213s on the first bracket 213b abuts against a periphery of the second host housing 231. Therefore, the sealing ring 213s can seal a gap between the first bracket 213b and the second host housing 231, and prevent external water vapor from entering inside of the host 2 through the gap.

In another embodiment, it is easily understood that the sealing bracket and the sealing ring may alternatively be mounted on the circumferential edge of the second host housing 231. An assembly structure including the sealing bracket, the sealing ring, and the second host housing is similar to that described above. Details are not described herein again. When the first part 21 and the second part 23 are closed, the sealing ring on the second host housing 231 abuts against a periphery of the first bracket to seal a gap between the second host housing 231 and the first bracket 213b.

Alternatively, different from that in the foregoing sealing design, in another embodiment, the sealing bracket 213t may not be disposed, but a sealing ring is disposed only on the first bracket 213b or the second host housing 231. In this way, the gap between the first bracket 213b and the second host housing 231 may also be sealed.

As shown in FIG. 6 and FIG. 21, the function button 24 may be roughly a cylinder. The function button 24 may be fitted into the function button mounting through hole 232e of the third host housing 232, and is movably connected to the third host housing 232. The function button 24 may be moved in an axis of the function button mounting through hole 232e within the function button mounting through hole 232e, and/or the function button 24 may be rotated about the axis of the function button mounting through hole 232e. The function button 24 is configured to be pressed and/or rotated by the user, so that the host 2 implements a corresponding function, for example, selection, confirmation, or picture display switching.

As shown in FIG. 34 and FIG. 6, the open button 25 and the function button 24 may be assembled to the third host housing 232, and the third host housing 232 may be assembled to the second host housing 231. The circumferential side wall 232a of the third host housing 232 surrounds peripheries of the second host housing 231 and the host battery 234. With reference to FIG. 34 and FIG. 16, the second opening 232c of the third host housing 232 may communicate with the through hole 231b of the second bracket 231a. A wall of the second bracket 231a may avoid the rotating shaft mounting space 232f of the third host housing 232, so as to mount the rotating shaft assembly 22.

### Fourth host housing 233

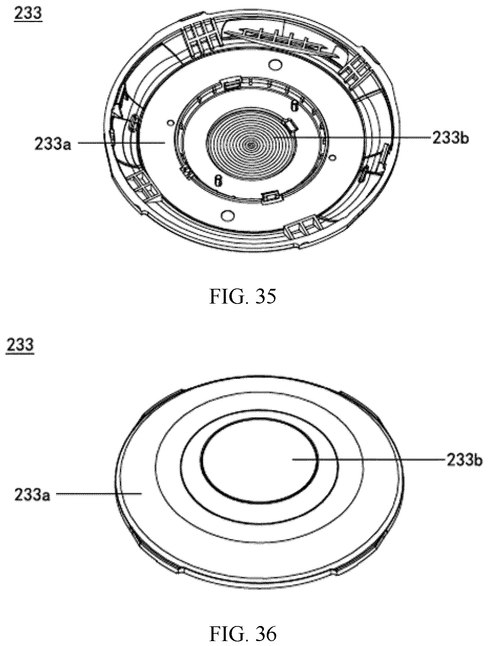

As shown in FIG. 35, FIG. 36, and FIG. 37, the fourth host housing 233 may be roughly in a disk shape. The fourth host housing 233 may include a third bracket 233a and a lens 233b. The third bracket 233a may be roughly in a disk shape. The third bracket 233a may have a mounting through hole 233c. The lens 233b is mounted on the third bracket 233a and covers the mounting through hole 233c. The lens 233b may be configured to transmit light emitted by a photoplethysmography (photoplethysmography, PPG) sensor (descriptions are provided below) and transmit light reflected back by a human body.

### Second host circuit board assembly 235

As shown in FIG. 6, the second host circuit board assembly 235 may include a circuit board and wires and components disposed on the circuit board. The circuit board in the second host circuit board assembly 235 may be, for example, a subsidiary board of the host 2. For example, the components such as a PPG sensor may be disposed on the subsidiary board. As shown in FIG. 6, the second host circuit board assembly 235 may be mounted on the fourth host housing 233.

### Wireless charging coil 236

The wireless charging coil 236 is configured to implement wireless charging. The wireless charging coil 236 may be mounted on the fourth host housing 233. The wireless charging coil 236 may be electrically connected to the circuit board in the second host circuit board assembly 235. For example, a pin of the wireless charging coil 236 may be soldered to the circuit board. As shown in FIG. 6, for example, the wireless charging coil 236 may be located on a periphery of the second host circuit board assembly 235.

As shown in FIG. 5 and FIG. 6, the fourth host housing 233 and the third host housing 232 may be assembled and fastened, and the fourth host housing 233 and the third host housing 232 together surround the second host housing 231, the host battery 234, the second host circuit board assembly 235, and the wireless charging coil 236. Both the second host circuit board assembly 235 and the wireless charging coil 236 may be located between the host battery 234 and the fourth host housing 233.

### Rotating shaft assembly 22

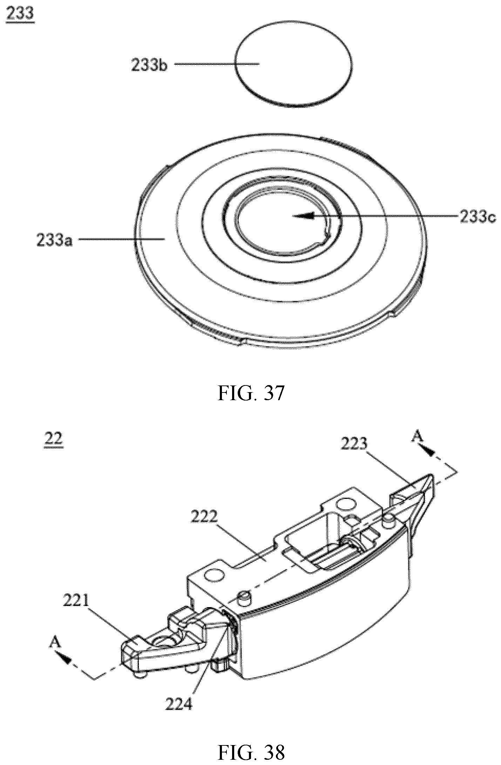

As shown in FIG. 38, FIG. 39, and FIG. 40, in an implementation 1 of this embodiment, the rotating shaft assembly 22 may include a shaft sleeve 222, a bump matching member 227, a driven member 229, a gasket 225, an elastic member 228, a first shaft 221, a limiting member 226, a second shaft 223, and a shaft contact member 224.

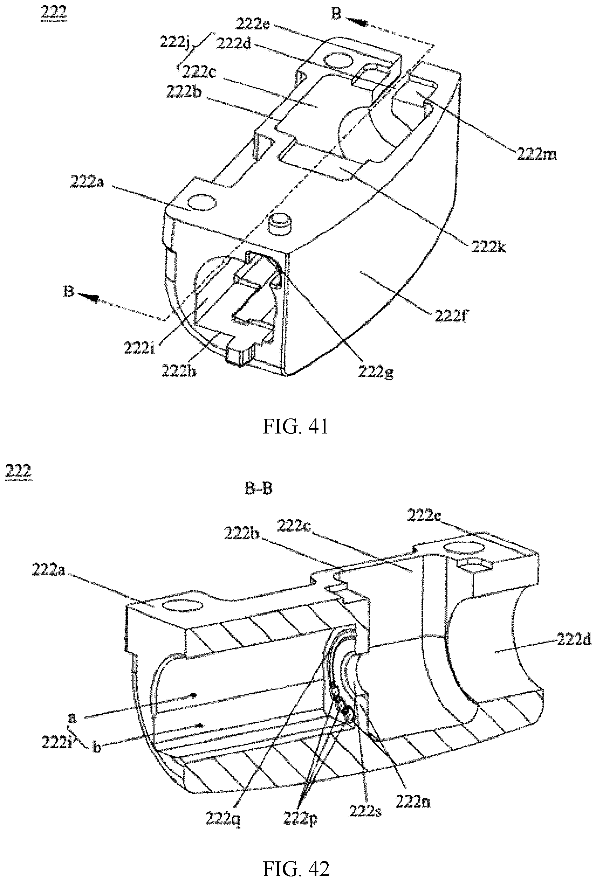

As shown in FIG. 41, the shaft sleeve 222 may be roughly a hollow cuboid structure. The shaft sleeve 222 may have a first outer surface 222a and a second outer surface 222f, which are two outer surfaces intersected on the shaft sleeve 222. In the host 2, a side on which the first outer surface 222a of the shaft sleeve 222 is located can be fixedly connected to the first frame body 213a in the first part 21, and is covered by the first part 21, so as not to be seen (descriptions are further provided below). When the host 2 is in the closed state, the second outer surface 222f may be seen as an external surface of the host 2 (descriptions are further provided below).

As shown in FIG. 41 and FIG. 42, an inner cavity of the shaft sleeve 222 has a spacer plate 222n that divides the inner cavity into a first inner cavity 222i and a second inner cavity 222j. The spacer plate 222n is provided with a through hole 222s, and the through hole 222s communicates the first inner cavity 222i with the second inner cavity 222j.

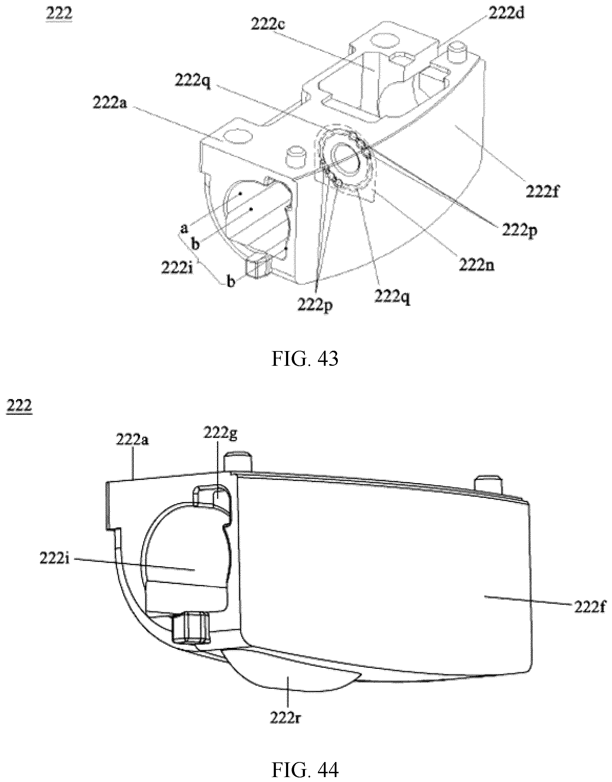

As shown in FIG. 42 and FIG. 43, a chute 222q and several matching grooves 222p may be provided on a surface that is of a side of the spacer plate 222n and that faces the first inner cavity 222i. The chute 222q and all the matching grooves 222p may be connected to form a ring, and the ring is located on a periphery of the through hole 222s and may be concentric with the through hole 222s.

As shown in FIG. 42, the matching grooves 222p may be concave, and an inner surface of each of the matching grooves 222p may be a curved surface. All the matching grooves 222p may be arranged along a circular arc, and may be divided into two groups. The two groups are spaced from each other, and several matching grooves 222p in each group are sequentially connected. A quantity of matching grooves 222p in the two groups may be consistent, for example, three in each group. In each group, two adjacent matching grooves 222p have a common side wall. A side of the side wall may have a rounded corner. A top surface of the side wall may also be depressed (that is, there is a step difference) relative to a surface on which openings of the matching grooves 222p are located.

As shown in FIG. 42 and FIG. 43, the chute 222q may be a long strip-shaped groove, and an extension track of the chute 222q may be a circular arc. There may be two chutes 222q, both of which are on a same circumference. Positions of the two chutes 222q on the circumference may be symmetrical, and two center angles (included angle formed by lines between two ends of the chute 222q and a center of the circumference) corresponding to the two chutes 222q may be opposite angles. The two chutes 222q and the two groups of matching grooves 222p are arranged alternately along the circumference. To be specific, the two chutes 222q and the two groups of matching grooves 222p are arranged on the circumference in an order of one chute 222q, one group of matching grooves 222p, the other chute 222q, and the other group of matching grooves 222p. One end of each chute 222q is connected to one matching groove 222p of a group of matching grooves 222p, and the other end of the chute 222q is connected to one matching groove 222p of the other group of matching grooves 222p. There may be a common side wall between the chute 222q and the matching grooves 222p. Alternatively, there is not a side wall between the chute 222q and the matching grooves 222p, but the chute 222q communicates with the matching grooves 222p.

The foregoing designs such as a quantity, structures, and positions of chutes 222q and designs such as a quantity, structures, and positions of matching grooves 222p are merely examples for description, and this embodiment is not limited thereto.

In this embodiment, the chute 222q and the matching grooves 222p are used to match bumps on the bump matching member 227 (descriptions are provided below). In another embodiment, the spacer plate 222n may not be provided with the chute 222q and the matching grooves 222p, and the rotating shaft may not be provided with the bump matching member 227.

As shown in FIG. 41 and FIG. 42, an end that is of the first inner cavity 222i and that is far away from the spacer plate 222n may pass through the shaft sleeve 222 to form an opening 222h. As shown in FIG. 41 and FIG. 43, an inner surface of the first inner cavity 222i may include an arc surface a and two planes b, and the two planes b are respectively connected to two opposite sides of the arc surface a. The arc surface a is close to the first outer surface 222a, and the planes b are far away from the first outer surface 222a. In other words, the first inner cavity 222i approximates an arch in shape, and the opening 222h is approximately arch-shaped.

As shown in FIG. 41 and FIG. 42, the second inner cavity 222j may include a first region 222c and a second region 222d that communicates with each other. The first region 222c is located between the spacer plate 222n and the second region 222d. The first region 222c forms an opening 222b on the first outer surface 222a. The second region 222d may be a circular hole with an axis facing the spacer plate 222n. The second region 222d forms an opening 222e on the first outer surface 222a, and an end that is of the second region 222d and that is far away from the spacer plate 222n may pass through the shaft sleeve 222.

As shown in FIG. 41, a groove 222k and a groove 222m may be further provided on the first outer surface 222a of the shaft sleeve 222. The groove 222k and the groove 222m are respectively located on two opposite sides of the first region 222c. The groove 222m may alternatively be located above the second region 222d. A side that is of the groove 222k and that faces the groove 222m communicates with the first region 222c, and a side that is of the groove 222m and that faces the groove 222k, communicates with the first region 222c.

As shown in FIG. 44, a limiting protrusion 222r is disposed on a side that is of the shaft sleeve 222 and that is opposite to the first outer surface 222a. A structure of the limiting protrusion 222r may be designed as required and is not limited in this embodiment. In this embodiment, the limiting protrusion 222r may be located on a side of the first inner cavity 222i on the shaft sleeve 222. In another embodiment, a position of the limiting protrusion 222r may be flexibly determined as required, and is not limited to a side that is of the spacer plate 222n and that is close to the first inner cavity 222i. Alternatively, the limiting protrusion 222r may not be provided.

As shown in FIG. 44, a mounting groove 222g may be further provided on a surface of the shaft sleeve 222, on which the opening 222h is formed, and the mounting groove 222g may communicate with the first inner cavity 222i. Similarly, another mounting groove 222g may be provided on a surface of one end that is of the shaft sleeve 222 and that is opposite to the opening 222h, and the another mounting groove 222g may communicate with the second region 222d. The mounting groove 222g is used to mount the shaft contact member 24 (descriptions are further provided below). In another embodiment, a position of the mounting groove 222g may be flexibly determined as required, and is not limited to the foregoing descriptions. Alternatively, the mounting groove 222g may not be provided.

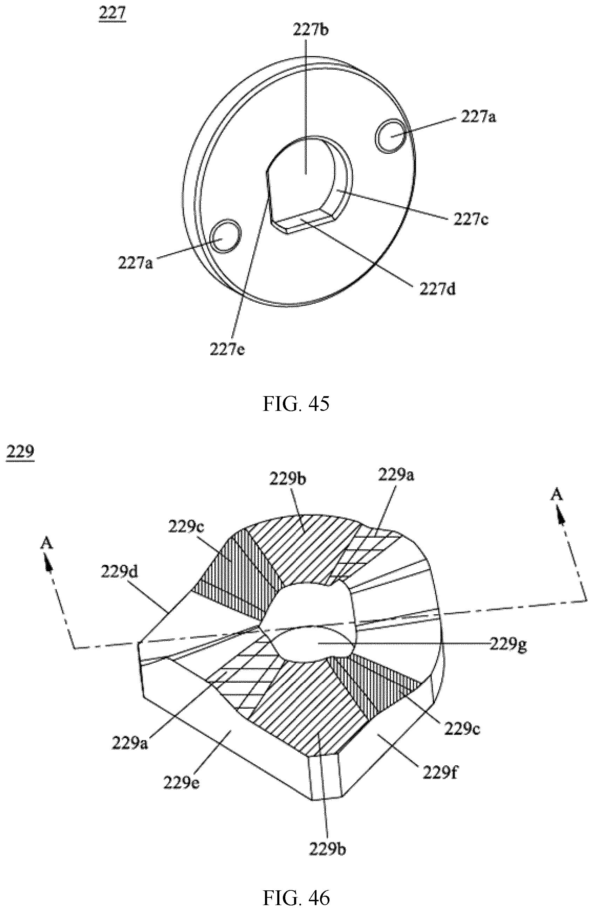

As shown in FIG. 45, the bump matching member 227 may be roughly a cylinder. A bottom surface of the bump matching member 227 may be provided with a bump 227a, and the bump 227a may have a curved surface protruding from the bottom surface. There is at least one bump 227a. For example, two bumps 227a are shown in FIG. 45. When there are at least two bumps 227a, the bumps 227a may be evenly spaced along a circumference. The bumps 227a are used to match the chute 222q and the matching grooves 222p on the spacer plate 222n of the shaft sleeve 222 (descriptions are further provided below).

As shown in FIG. 45, the bump matching member 227 may further have a through hole 227b, and the through hole 227b may penetrate the bump matching member 227 in a direction of a center line of the bump matching member 227. In this embodiment, an inner surface of the through hole 227b may include an arc surface 227c, a plane 227d, and a plane 227e. Two sides of the arc surface 227c are respectively connected to the plane 227d and the plane 227e, and an included angle may be formed between the plane 227d and the plane 227e. The bump matching member 227 may be mounted on the first shaft 221, and the through hole 227b may cooperate with the first shaft 221. The through hole 227b having the foregoing structure allows the bump matching member 227 to move along the first shaft 221, but not rotate relative to the first shaft 221 (descriptions are further provided below).

In another embodiment, the rotating shaft may not be provided with the bump matching member 227.

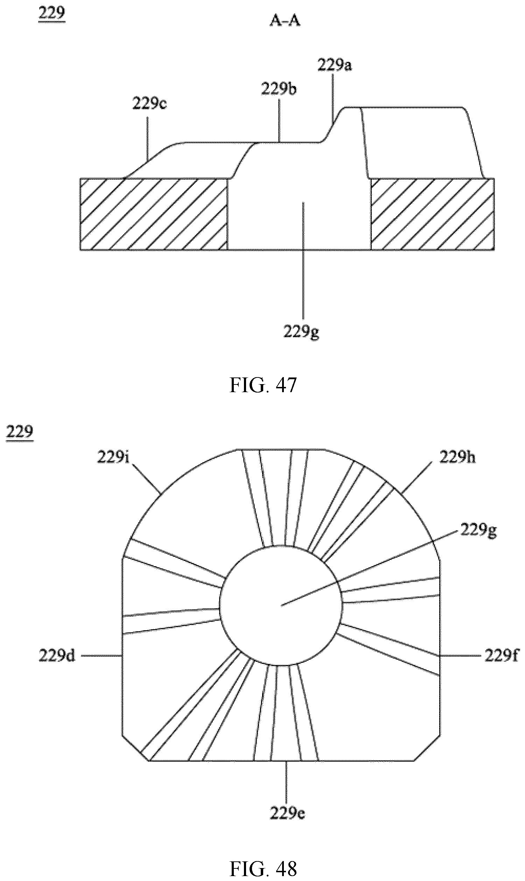

As shown in FIG. 46 and FIG. 47, the driven member 229 may be roughly in a block shape or a sheet shape. The driven member 229 has a through hole 229g, and an axis of the through hole 229g is roughly in a thickness direction of the driven member 229. A surface on one side of the driven member 229 in the thickness direction may be referred to as a shaft matching surface. The shaft matching surface may form a two-step ladder. The shaft matching surface may include a first slope 229a, a plane 229b, and a second slope 229c that are sequentially connected (to highlight the three regions, the three regions are represented by shadows). A normal line of the plane 229b may be in an axial direction of the through hole 229g. The first slope 229a and the plane 229b form an obtuse angle. The plane 229b and the second slope 229c form an obtuse angle. There is a step difference between the first slope 229a and the second slope 229c. A side that is of the first slope 229a and that is far away from the plane 229b may be higher than the plane 229b, and a side that is of the second slope 229c and that is far away from the plane 229b may be lower than the plane 229b.

As shown in FIG. 46, the shaft matching surface of the driven member 229 may include two first slopes 229a, two planes, and two second slopes 229c. The shaft matching surface may form two two-step ladders and may extend downward step by step in a circumferential direction of the shaft matching surface. The two two-step ladders may be spaced from each other. For example, the two two-step ladders may be centrosymmetric with respect to the through hole 229g.

As shown in FIG. 48, an outer side surface of the driven member 229, whose normal line points to the through hole 229g, may be approximately arched. The outer side surface may include an arc surface 229h, an arc surface 229i, a plane 229d, a plane 229e, and a plane 229f. The arc surface 229h and the arc surface 229i may serve as a top of the arch, and both may be roughly symmetrical with respect to the axis of the through hole 229g. The plane 229e may serve as a bottom of the arch. The plane 229f may be located between the arc surface 229h and the plane 229e, and one side of the plane 229f may be connected to the arc surface 229h. The plane 229d may be located between the arc surface 229i and the plane 229e, and one side of the plane 229d may be connected to the arc surface 229i.

The driven member 229 may be mounted in the first inner cavity 222i of the shaft sleeve 222, and the outer side surface of the driven member 229 has the foregoing structure, so that the driven member 229 can move in the first inner cavity 222i without rotating (descriptions are further provided below). In another embodiment, the outer side surface of the driven member 229 may have another appropriate structure, provided that a design requirement that the driven member 229 moves in the first inner cavity 222i without rotation is met.

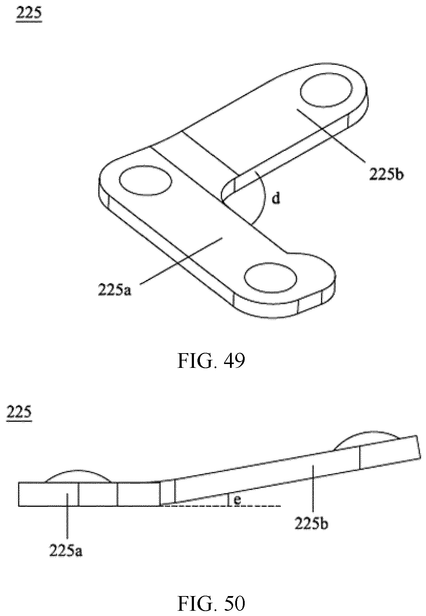

As shown in FIG. 49 and FIG. 50, the gasket 225 may be roughly in a sheet shape. The gasket 225 may include a first part 225a and a second part 225b. The first part 225a and the second part 225b may be connected (for example, connected as a whole). The first part 225a and the second part 225b may, for example, form an included angle d. The included angle d is, for example, approximately 90°. The first part 225a and the second part 225b may not be in a same plane, and the second part 225b may form an included angle e with a plane in which the first part 225a is located. For example, from the perspective of FIG. 50, the second part 225b may be tilted upward relative to the first part 225a, and form the included angle e with the plane on which the first part 225a is located (in other words, form the included angle e with the first part 225a).

The first part 225a of the gasket 225 may be fastened in the first cavity 222i of the shaft sleeve 222, and the second part 225b of the gasket 225 may abut against the plane 229e of the driven member 229 (descriptions are further provided below).

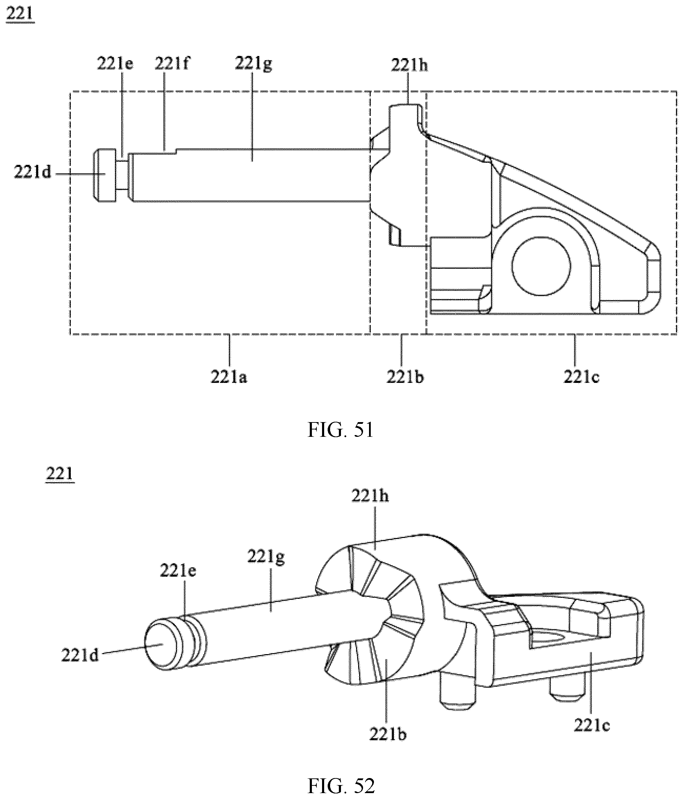

As shown in FIG. 51, the first shaft 221 may be an integrated structure, and may include a first part 221a, a second part 221b, and a third part 221c that are sequentially connected. It may be understood that, in FIG. 51, the first part 221a, the second part 221b, and the third part 221c are respectively distinguished by using three dotted line boxes, which is merely intended to intuitively illustrate approximate positions of the first part 221a, the second part 221b, and the third part 221c, but is not intended to strictly define boundaries among the first part 221a, the second part 221b, and the third part 221c.

As shown in FIG. 51 and FIG. 52, the first part 221a may include an end portion 221d and a main portion 221g, and both the end portion 221d and the main portion 221g may be roughly cylinders. The main portion 221g is connected to the second part 221b, and the end portion 221d is far away from the second part 221b. A slot 221e may be formed between the end portion 221d and the main portion 221g, and the slot 221e may surround an axis of the end portion 221d. A bottom surface of the slot 221e is lower than an outer circumferential surface of the end portion 221d and an outer circumferential surface of the main portion 221g.

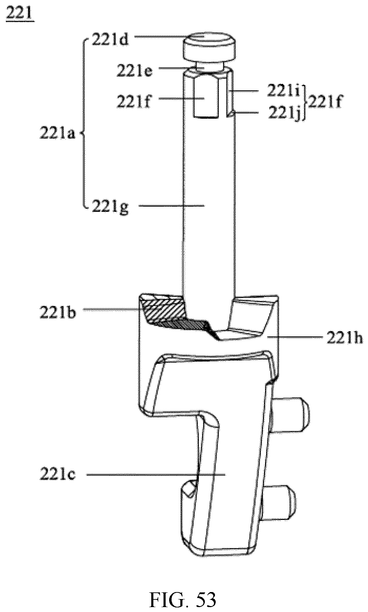

As shown in FIG. 51 and FIG. 53, an end that is of the main portion 221g and that is close to the end portion 221d may form a concave space 221f. The concave space 221f may have a plane 221i and a plane 221j. The plane 221i may be basically parallel to an axis of the end portion 221d, the plane 221j may be basically perpendicular to the axis of the end portion 221d, and the plane 221i may be basically perpendicular to the plane 221j. The plane 221j may be connected to the outer circumferential surface of the main portion 221g and the plane 221i. Both sides of the plane 221i may be connected to the outer circumferential surface of the main portion 221g. The concave space 221f may be formed by cutting the outer circumferential surface of the main portion 221g.

As shown in FIG. 53, there may be two concave spaces 221f, and the two concave spaces 221f may have a specific spacing. In another embodiment, a quantity of concave spaces 221f is not limited to the foregoing descriptions, for example, may be one or more.

In this embodiment, an end that is of the main portion 221g and that is close to the end portion 221d may match the through hole 227b of the bump matching member 227, and a surface of the end of the main portion 221g may match the inner wall of the through hole 227b, so that the bump matching member 227 may move along the main portion 221g but cannot rotate (descriptions are further provided below). In another embodiment, if the bump matching member 227 is not provided, the end that is of the main portion 221g and that is close to the end portion 221d may not form the concave space 221f.

As shown in FIG. 51 to FIG. 53, the second part 221b may have an outer circumferential surface 221h, and the outer circumferential surface 221h may be roughly a cylindrical surface. In this embodiment, the second part 221b may be mounted into the first inner cavity 222i of the shaft sleeve 22, and the outer circumferential surface 221h may rotate and match the arc surface a of the first inner cavity 222i.

As shown in FIG. 52 and FIG. 53, a two-step ladder may be formed on a surface that is of the second part 221b and that faces the end portion 221d (a surface of the two-step ladder is shown by using a shadow in FIG. 53), and the two-step ladder has a similar (or roughly similar) structure to the two-step ladder of the driven member 229 described above. With reference to FIG. 52, FIG. 46, and FIG. 40, the second part 221b may be assembled with the driven member 229 to form a cam mechanism, and the surface of the two-step ladder of the second part 221b may move and match the surface of the two-step ladder of the driven member 229, so that the driven member 229 implements a specific motion (descriptions are further provided below).

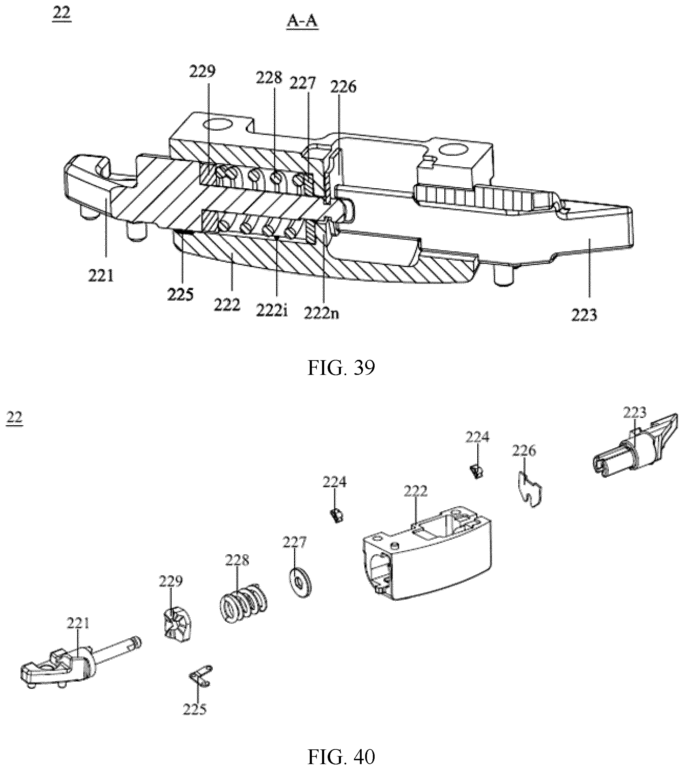

A structure of the third part 221c may be designed as required, and is not limited to that shown in FIG. 51 to FIG. 53. The third part 221c is fastened to the inner bearing platform 232g of the third host housing 232 (descriptions are further provided below). As shown in FIG. 40, the elastic member 228 is a component capable of providing a rebound force, for example, may be a spring.

The foregoing respectively describes structures of the shaft sleeve 222, the bump matching member 227, the first shaft 221, the driven member 229, and the elastic member 228. The following describes an assembly structure including these components.

As shown in FIG. 39, FIG. 45, FIG. 43, and FIG. 46, the driven member 229, the elastic member 228, and the bump matching member 227 may all be located in the first inner cavity 222i of the shaft sleeve 222. The bump matching member 227 is close to the spacer plate 222n of the shaft sleeve 222, and the bumps 227a of the bump matching member 227 may face the chute 222q (or face the matching grooves 222p) of the spacer plate 222n. The driven member 229 is remote from the spacer plate 222n, and the two-step ladder of the driven member 229 backs onto the spacer plate 222n. Both the arc surface 229h and the arc surface 229i of the driven member 229 may be opposite to and match the arc surface a of the first inner cavity 222i. Both the plane 229e and the plane 229f of the driven member 229 can be opposite to and match the plane b of the first inner cavity 222i. Therefore, the driven member 229 can move in the first inner cavity 222i, but cannot rotate relative to the first inner cavity 222i.

It is easily understood that the foregoing matching structure including the driven member 229 and the first inner cavity 222i is merely an example. In another embodiment, another appropriate matching structure may be designed as required, so that the driven member 229 can move only in the first inner cavity 222i, but cannot rotate relative to the first inner cavity 222i (descriptions that the driven member 229 may rotate with the shaft sleeve 222 are provided below).

As shown in FIG. 39, the elastic member 228 is located between the driven member 229 and the bump matching member 227. One end of the elastic member 228 may abut against the driven member 229, and the other end may abut against the bump matching member 227.

As shown in FIG. 51, FIG. 39, FIG. 41, and FIG. 42, both the main portion 221g of the first part 221a of the first shaft 221 and the second part 221b of the first shaft 221 may be located in the first inner cavity 222i of the shaft sleeve 222. The end portion 221d of the first part 221a may be located in the first region 222c of the second inner cavity 222j of the shaft sleeve 222, and a part or all of the slot 221e of the first part 221a may be located in the first region 222c.

As shown in FIG. 51, FIG. 46, FIG. 45, and FIG. 42, the first part 221a may pass through the through hole 229g of the driven member 229, the elastic member 228, a through hole 227c of the bump matching member 227, and a through hole of the spacer plate 222n. The two-step ladder of the second part 221b may face the two-step ladder of the driven member 229. The two-step ladder of the second part 221b may cooperate with the two-step ladder of the driven member 229, so that the second part 221b and the driven member 229 form the cam mechanism.

As shown in FIG. 53 and FIG. 45, a plane 221i of one concave space 221f of the main portion 221g may be opposite to and match the plane 227d of the through hole 227b of the bump matching member 227. A plane 221i of the other concave space 221f of the main portion 221g may be opposite to and match the plane 227e of the through hole 227b of the bump matching member 227. The outer circumferential surface of the main portion 221g may be opposite to and match the arc surface 227c of the through hole 227b of the bump matching member 227. Therefore, the bump matching member 227 can move along the main portion 221g in the first inner cavity 222i, but cannot rotate around the main portion 221g.

It is easily understood that the foregoing matching structure including the main portion 221g and the bump matching member 227 is merely an example. In another embodiment, another appropriate matching structure may be designed as required, so that the bump matching member 227 can move only along the main portion 221g but cannot rotate around the main portion 221g.

With reference to FIG. 51 and FIG. 39, the third part 221c of the first shaft 221 may be located outside the shaft sleeve 222.

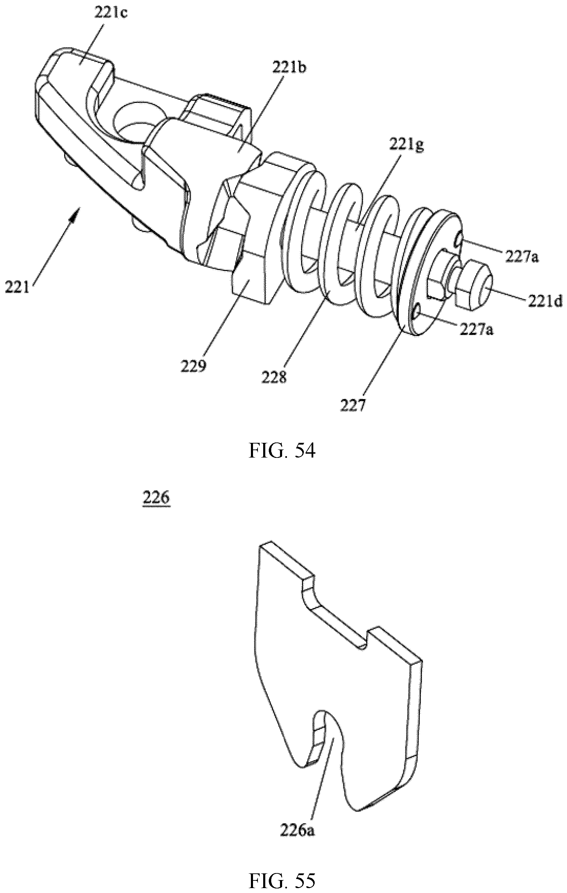

FIG. 54 may intuitively show an assembly structure including the first shaft 221, the driven member 229, the elastic member 228, and the bump matching member 227.

As shown in FIG. 39 and FIG. 50, the gasket 225 may be fastened to the first inner cavity 222i of the shaft sleeve 222. The first part 225a of the gasket 225 may be located between the third part 221c of the first shaft 221 and the shaft sleeve 222. The second part 225b of the gasket 225 may be located between the driven member 229 and the shaft sleeve 222. The second part 225b may always abut against the driven member 229 in an entire motion process of the driven member 229. Because the second part 225b is tilted relative to the first part 225a, the second part 225b can press the driven member 229 against the inner surface of the first inner cavity 222i of the shaft sleeve 222, so that the driven member 229 closely matches the inner surface of the first inner cavity 222i. This can prevent the driven member 229 from shaking during movement due to a manufacturing error. In another embodiment, the gasket 225 may not be provided based on an actual requirement.

As shown in FIG. 55, the limiting member 226 may be basically in a plate shape, and a structure of the limiting member 226 may be designed as required. For example, an outline of the limiting member 226 may match a shape of the first region 222c of the second inner cavity 222i of the shaft sleeve 22. An opening 226a may be formed on the limiting member 226.

With reference to FIG. 39, FIG. 52, and FIG. 55, the limiting member 226 may be located in the first region 222c of the second inner cavity 222i of the shaft sleeve 22, and may be in contact with the spacer plate 222n of the shaft sleeve 22. An edge of the opening 226a of the limiting member 226 may be snapped into the slot 221e of the first part 221a of the first shaft 221. Therefore, the limiting member 226 can limit the first shaft 221, to prevent the first shaft 221 from detaching from the shaft sleeve 22, and ensure that a position of the first shaft 221 relative to the shaft sleeve 22 remains unchanged. This further ensures reliable assembly of the driven member 229, the elastic member 228, and the bump matching member 227, and the shaft sleeve 22.

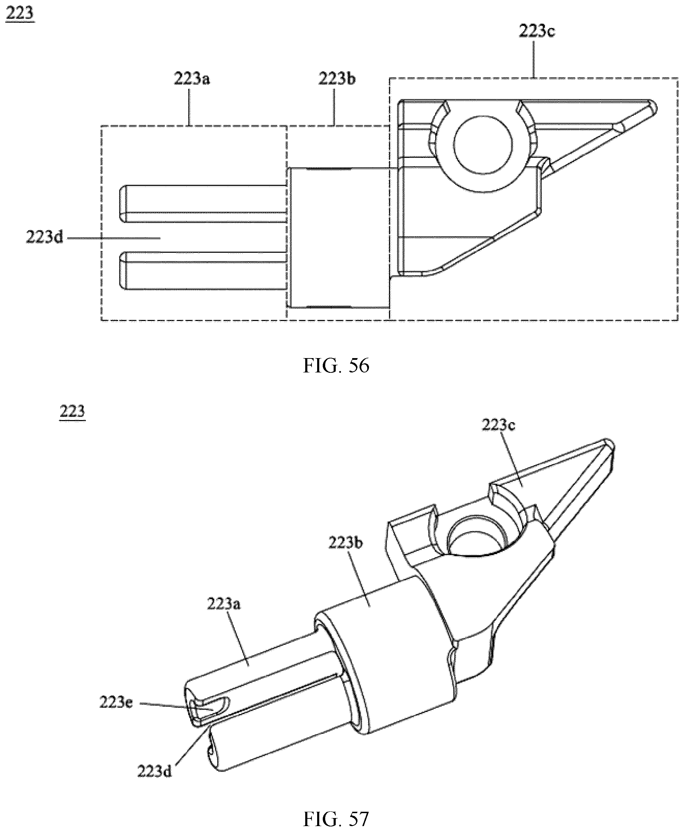

As shown in FIG. 56, FIG. 57, and FIG. 58, the second shaft 223 may be an integrated structure, and may include a first part 223a, a second part 223b, and a third part 223c that are sequentially connected. It may be understood that, in FIG. 56, the first part 223a, the second part 223b, and the third part 223c are respectively distinguished by using three dotted line boxes, which is merely intended to intuitively illustrate approximate positions of the first part 223a, the second part 223b, and the third part 223c, but is not intended to strictly define boundaries among the first part 223a, the second part 223b, and the third part 223c.

As shown in FIG. 56 to FIG. 58, both the first part 223a and the second part 223b may be roughly cylinders. A structure of the third part 223c may be designed as required. FIG. 56 to FIG. 58 are merely schematic diagrams. A channel 223d may be formed on the second shaft 223, and may extend basically in an axial direction of the first part 223a. The channel 223d may pass through two opposite ends in a radial direction of the first part 223a and through one end of the second part 223b and the third part 223c in a radial direction of the second part 223b. Therefore, the first part 223a may be divided into two completely disconnected parts by the channel 223d, and the second part 223b and the third part 223c each may be divided into two connected parts by the channel 223d.

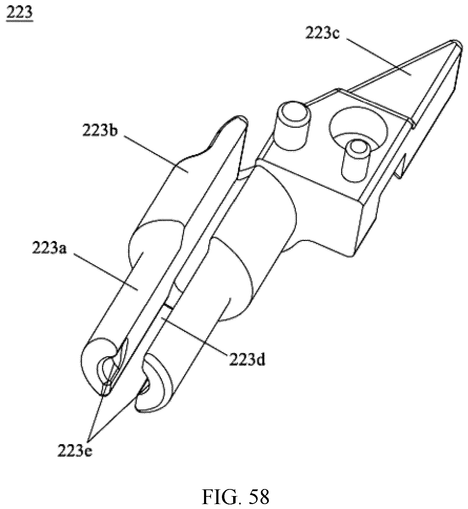

As shown in FIG. 57 and FIG. 58, an end that is of the first part 223a and that is far away from the second part 223b has a groove 223e, and the groove 223e may be specifically provided on an inner surface of the channel 223d. There may be two grooves 223e. Each part of the first part 223a has one groove 223e, and openings of the two grooves 223e face each other.

In this embodiment, a flexible circuit board may be mounted on the second shaft 223. Details are described below.

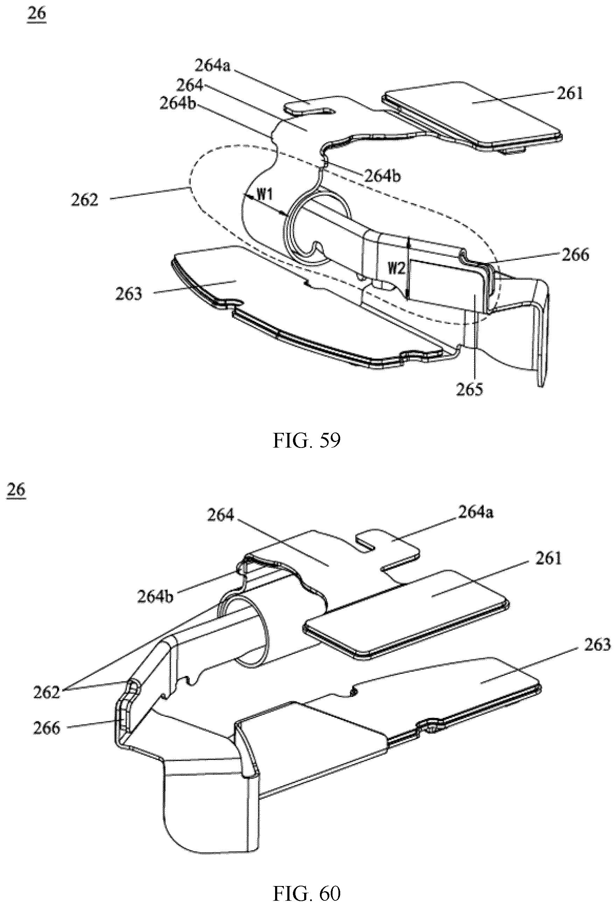

FIG. 59, FIG. 60, and FIG. 61 show schematic structures of a flexible circuit board 26 obtained by bending and winding (the flexible circuit board 26 is bent and wound after being mounted on the second shaft 223). Actually, the flexible circuit board 26 is in an unfolded state before being mounted on the second shaft 223, and in the unfolded state, the flexible circuit board 26 may be roughly of a long strip-shaped structure.

As shown in FIG. 59 to FIG. 61, the flexible circuit board 26 may include an electrical connection end 261 and an electrical connection end 263. After the flexible circuit board 26 is unfolded, the electrical connection end 261 and the electrical connection end 263 are respectively two ends in an extension direction of the flexible circuit board 26. Both the electrical connection end 261 and the electrical connection end 263 are configured to transmit an electrical signal, and the electrical connection end 261 and the electrical connection end 263 each may include a connector.

For example, the electrical connection end 261 may be connected to the first host circuit board assembly 212. For example, the connector of the electrical connection end 261 may be connected to a connector on the circuit board 212a of the first host circuit board assembly 212, so as to electrically connect the flexible circuit board 26 to the first host circuit board assembly 212.

For example, the electrical connection end 263 may be electrically connected to the second host circuit board assembly 235 and a flexible circuit board connecting the function button 24 and a motor (for example, the function button 24 and the motor may share the same flexible circuit board). The flexible circuit board connecting the function button 24 and the motor may be fastened, for example, to a side that is of the second bracket 231a and that is far away from the opening of the third accommodation groove 231f. A magnetic field sensor (for example, a Hall effect sensor or a magnetometer) may be further disposed on the flexible circuit board. For example, there may be two magnetic field sensors, and the two magnetic field sensors may be respectively close to the groove wall of the third accommodation groove 231f and the groove wall of the fourth accommodation groove 231g.

As shown in FIG. 59 to FIG. 61, the flexible circuit board 26 may further include a connection part 264 and a mounting part 262. The connection part 264 connects the mounting part 262 to the electrical connection end 261, and the mounting part 262 is further connected to the electrical connection end 263.

As shown in FIG. 59 to FIG. 61, the connection part 264 has a grounding portion 264a and a limiting portion 264b. For example, the grounding portion 264a may be close to the electrical connection end 261, and the limiting portion 264b may be far away from the electrical connection end 261. The limiting portion 264b may be, for example, lug-like. For example, there may be two limiting portions 264b, and the two limiting portions 264b are respectively located on edges of two sides of the connection part 264.

As shown in FIG. 59 to FIG. 61, the mounting part 262 is used to match the second shaft 223 and may be in a bent and wound state. For example, from the perspective of FIG. 59, one part of the mounting part 262 may be folded in half to form layers, and thus may be referred to as a laminated part. Another part of the mounting part 262 may be connected to the laminated part and wound into a loop, and thus may be referred to as a wound part. The wound part may be located at one end of the laminated part. It may be understood that the mounting part 262 is marked with a dashed box in FIG. 59, which is merely intended to visually illustrate a general position of the mounting part 262, and is not intended to strictly define a boundary of the mounting part 262.

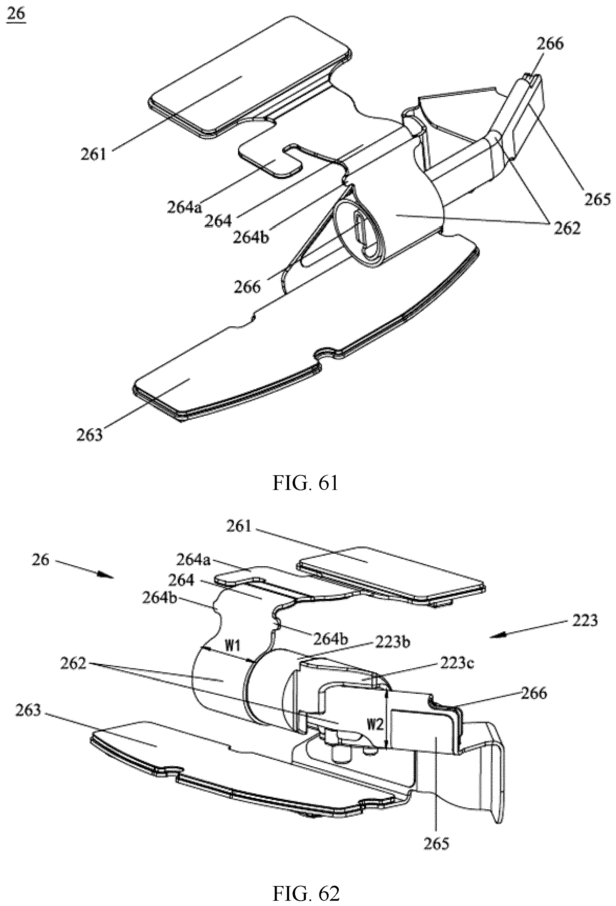

In this embodiment, a quantity of wires in the flexible circuit board 26 needs to meet a design requirement, and a width of the flexible circuit board 26 affects the quantity of wires in the flexible circuit board 26. Therefore, the width (for example, a minimum width) of the flexible circuit board 26 needs to meet the design requirement. FIG. 59 and FIG. 62 schematically show a width W1 of the wound part of the mounting part 262 of the flexible circuit board 26 and a folding width W2 of the laminated part (an unfolding width of the laminated part is approximately 2*W2). The width W1 of the wound part and the folding width W2 of the laminated part can be designed as required.

As shown in FIG. 59 to FIG. 61, the flexible circuit board 26 may further include a separation bracket 266. A structure of the separation bracket 266 may be designed as desired, for example, roughly in a flat-plate shape. A quantity of the separation brackets 266 may be determined as required. There may be one or at least two separation brackets. The separation bracket 266 is sandwiched between folded layers of the laminated part, and each layer may be connected (for example, bonded) to the separation bracket 266.

In this embodiment, the unfolded width of the laminated part is generally small, and it is difficult to maintain a folded form after the laminated part is folded (the folded layers are easily tilted). However, because the separation bracket 266 is provided, the laminated part is allowed to remain in a folded configuration. In addition, the separation bracket 266 can also limit a bending radius of the laminated part to avoid damage caused by excessive bending of the laminated part. In another embodiment, the separation bracket 266 may not be provided based on a product requirement. As shown in FIG. 59 and FIG. 61, the flexible circuit board 26 may further include a protective layer 265. For example, the protective layer 265 may be attached to a surface of the laminated part, and may be located at an end that is of the laminated part and that is far away from the wound part. A material of the protective layer 265 may be, for example, mylar (mylar). In this embodiment, the position and the material of the protective layer 265 may alternatively be designed based on a product requirement, and are not limited to the foregoing descriptions.

In this embodiment, the laminated part may be fastened to the third host housing 232, and the protective layer 265 may separate the laminated part from the third host housing 232, so as to prevent damage to the flexible circuit board 26 caused by friction between the laminated part and the third host housing 232 (descriptions are further provided below). In addition, the protective layer 265 may further enhance a structure of the laminated part. In another embodiment, the protective layer 265 may not be provided based on a product requirement.

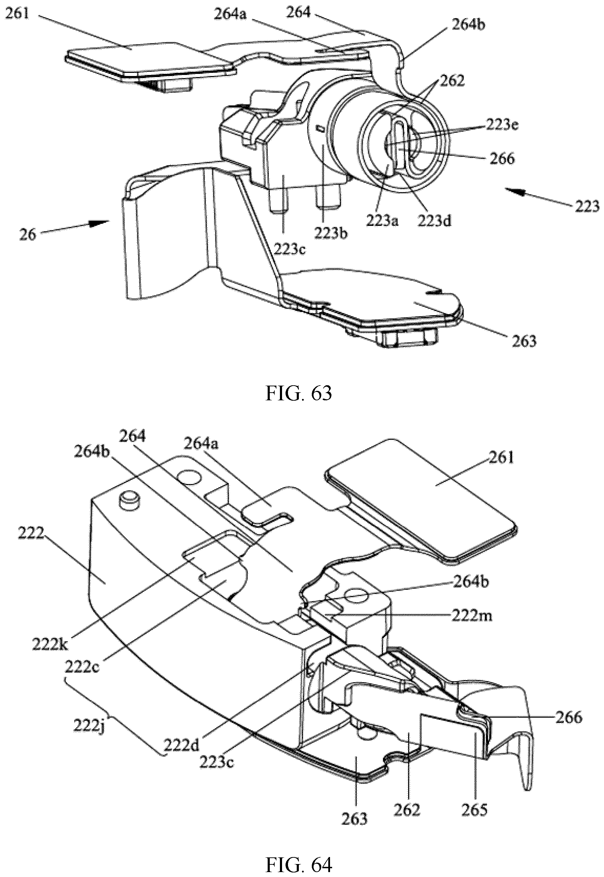

FIG. 62 and FIG. 63 show assembly structures of the flexible circuit board 26 and the second shaft 223. When the flexible circuit board 26 and the second shaft 223 are assembled, the laminated part of the mounting part 262 of the flexible circuit board 26 in the unfolded state may be folded in half, and the wound part of the mounting part 262 may continue to be in the unfolded state. With reference to FIG. 62, FIG. 63, and FIG. 58, the entire mounting part 262 is then fitted into the channel 223d of the second shaft 223 from the end of the third part 223c of the second shaft 223, so that the wound part of the mounting part 262 is positioned to the first part 223a of the second shaft 223. In this case, the wound part may be bent so that the wound part is wound around a periphery of the first part 223a, and a quantity of winding turns may be determined based on the actual requirement. After the winding is completed, there is a specific distance between the wound part and an end portion that is of the first part 223a and that is far away from the second part 223b (that is, the wound part does not cover the end portion of the first part 223a). This helps avoid that the wound part is scratched and a life is affected (descriptions are further provided below). Both the electrical connection end 261 and the electrical connection end 263 of the flexible circuit board 26 are located outside the second shaft 223. The electrical connection end 261 and the electrical connection end 263 may be bent to adapt to internal space of the host 2. The protective layer 265 and the connection part 264 of the flexible circuit board 26 may alternatively be exposed outside the second shaft 223.

In this embodiment, an inner ring of the wound part of the flexible circuit board 26 is in direct contact with the first part 223a of the second shaft 223, and a joint between the wound part and the laminated part may be fastened, for example, by bonding, to the first part 223a. Other regions of the wound part may be not fastened but remain in a natural wound state, and may be relaxed to increase a diameter of the part, or tightened to decrease the diameter of the part.

In this embodiment, because the wound part of the flexible circuit board 26 is wound around the first part 223a of the second shaft 223, the width W1 of the wound part can be ensured by using an axial size of the first part 223a. The laminated part of the flexible circuit board 26 is accommodated in the channel 223d of the second shaft 223 in a folded state, so that the laminated part with the unfolding width of 2*W2 can be accommodated in only a small space of the second shaft 223. This facilitates miniaturization of the second shaft 223 and is beneficial to realizing miniaturization of the host 2.

To sum up, the second shaft 223 having the foregoing structure is designed, and the flexible circuit board 26 is mounted on the second shaft 223 in a bent and wound manner, so that electrical connection of the host 2 can be implemented, and a width of the flexible circuit board 26 can meet a design requirement, and miniaturization of the host 2 can be implemented.

In this embodiment, the second shaft 223 on which the flexible circuit board 26 is mounted may be mounted in the second inner cavity 222j of the shaft sleeve 222.

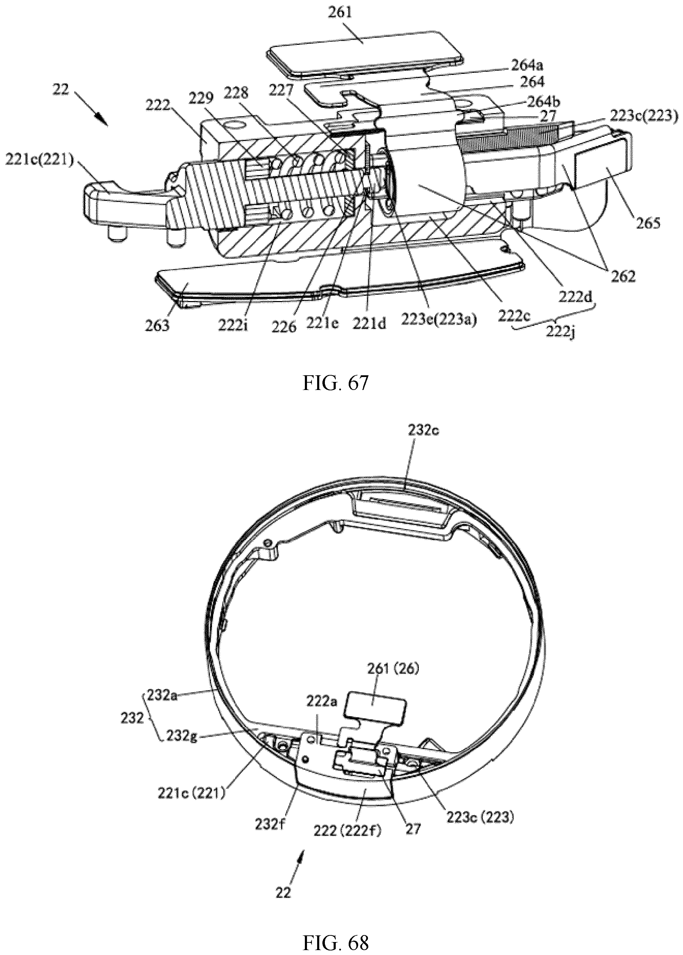

With reference to FIG. 57 and FIG. 67, the first part 223a of the second shaft 223 is located in the first region 222c of the shaft sleeve 222. The second part 223b of the second shaft 223 may be located in the second region 222d of the second inner cavity 222j. The outer circumferential surface of the second part 223b may rotate and match the inner surface of the second region 222d. In other words, the outer circumferential surface of the second part 223b may be in contact with or may not be in contact with the inner surface of the second region 222d (with a small gap), and the inner surface of the second region 222d may rotate relative to the outer circumferential surface of the second part 223b. The third part 223c of the second shaft 223 is located outside the shaft sleeve 222.

As shown in FIG. 59, FIG. 64, and FIG. 67, the wound part of the flexible circuit board 26 is located in the first region 222c. One part of the laminated part of the flexible circuit board 26 is located in the first region 222c and the second region 222d, and the other part of the laminated part is located outside the shaft sleeve 222. Both the electrical connection end 261 and the electrical connection end 263 of the flexible circuit board 26 are located outside the shaft sleeve 222. The connection part 264 of the flexible circuit board 26 may pass through an opening of the first region 222c, and both the grounding portion 264a and the limiting portion 264b of the connection part 264 are located outside the shaft sleeve 222.

With reference to FIG. 64, in this embodiment, the electrical connection end 261 of the flexible circuit board 26 may be fastened to the first host circuit board assembly 212, and the electrical connection end 261 may move with the first part 21 of the host 2. Accordingly, the connection part 264 connected to the electrical connection end 261 also moves with the electrical connection end 261. To enable the connection part 264 to move based on the design requirement, ensure that the motion of the connection part 264 is controllable, and avoid fatigue damage to the connection part 264, the connection part 264 may be clamped by using a clamping member, so as to limit the connection part 264. Descriptions are provided below.

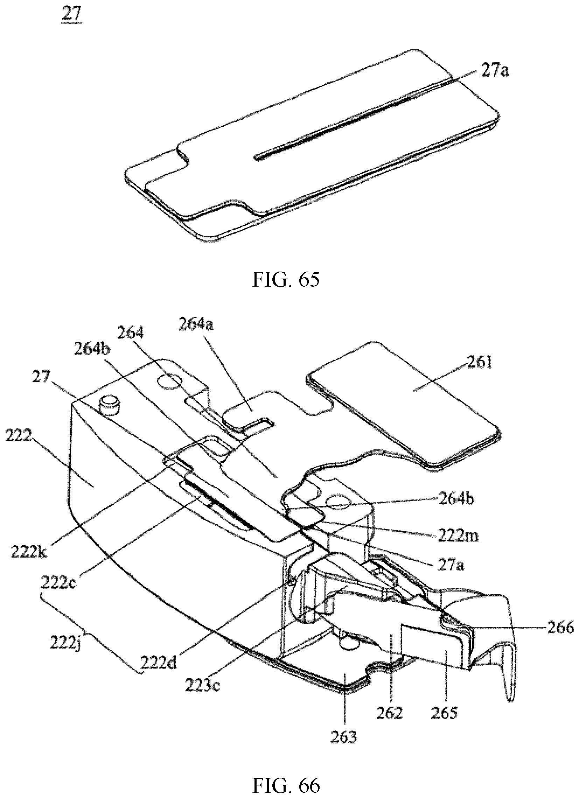

As shown in FIG. 65, the clamping member 27 may be roughly in a sheet shape, and a clamping gap 27a may be provided on the clamping member 27. The clamping gap 27a may be roughly in a straight-line shape. One end of the clamping gap 27a passes through the clamping member 27, and the other end does not pass through the clamping member 27. The clamping member 27 may be made of a material having good insulation and moisture resistance, like mylar (mylar).

As shown in FIG. 65 and FIG. 66, the connection part 264 may penetrate the clamping gap 27a of the clamping member 27, the limiting portion 264b of the connection part 264 may be clamped on an edge of the clamping gap 27a, the clamping member 27 may be fastened to the groove 222k and the groove 222m of the shaft sleeve 222, and the clamping member 27 covers at least a part of the first region 222c. Therefore, the clamping member 27 can clamp the connection part 264 and limit the connection part 264. When the connection part 264 moves, due to existence of the clamping member 27, a motion stroke of the connection part 264 meets the design requirements and is not prone to fatigue damage. In addition, the limiting portion 264b is designed, so that accurate positioning of the clamping member 27 and the flexible circuit board 26 during production line assembly is facilitated. This ensures an assembly yield. In another embodiment, the design of clamping the connection part 264 by the clamping member 27 may not be used.

The foregoing describes structures and assembly of the second shaft 223, the flexible circuit board 26, the shaft sleeve 222, and the clamping member 27. The following describes an overall assembly structure of the rotating shaft assembly 22 and assembly relationships among the flexible circuit board 26, the second shaft 223, and the first shaft 221.

FIG. 67 shows a sectional view of an assembly structure including the rotating shaft assembly 22, the flexible circuit board 26, and the clamping member 27. A sectional view of the flexible circuit board 26 is not provided, to clearly show the flexible circuit board 26. The foregoing describes an assembly relationship among the first shaft 221, the driven member 229, the elastic member 228, the bump matching member 227, and the shaft sleeve 222, and an assembly relationship among the second shaft 223, the flexible circuit board 26, the clamping member 27, and the shaft sleeve 222, as shown in FIG. 67. This is not repeated herein. As described above, the end portion of the first part 223a of the second shaft 223 is not covered by the wound part of the flexible circuit board 26. This facilitates insertion of the end portion 221d of the first shaft 221 into the groove 223e of the first part 223a of the second shaft 223. There may be a specific gap between the end portion 221d and the wound part in an axial direction of the first shaft 221, to avoid interference between the end portion 221d and the wound part.

In addition, as shown in FIG. 44, FIG. 38, and FIG. 40, one shaft contact member 224 may be fastened in the mounting groove 222g that is of the shaft sleeve 222 and that is close to the second part 221b of the first shaft 221, and the shaft contact member 224 is in contact with the second part 221b. Similarly, another shaft contact member 224 may be fastened in a groove that is of the shaft sleeve 222 and that is close to the second part 223b of the second shaft 223, and the shaft contact member 224 is in contact with the second part 223b (due to an angle of view, the groove that is assembled in the shaft sleeve 222 and that is close to the second part 223b and the shaft contact member 224 within the groove are not displayed). In this embodiment, the shaft contact member 224 may be a conductor, for example, a metal spring.

The assembly structure of the rotating shaft assembly 22, the flexible circuit board 26, the first part 21, and the second part 23 of the host 2 is described step by step below.

As shown in FIG. 68, both the third part 221c of the first shaft 221 and the third part 223c of the second shaft 223 may be fastened to the inner bearing platform 232g of the third host housing 232. The shaft sleeve 222 may be located in the rotating shaft mounting space 232f of the third host housing 232, and the shaft sleeve 222 may rotate in the rotating shaft mounting space 232f. The second outer surface 222f of the shaft sleeve 222 may face an outer side of the circumferential side wall 232a of the third host housing 232. The electrical connection end 261 of the flexible circuit board 26 may be located on the inner side of the circumferential side wall 232a.

With reference to FIG. 67 and FIG. 68, the electrical connection end 263 of the flexible circuit board 26 may be located on the inner side of the circumferential side wall 232a and fastened to the inner bearing platform 232g. For example, the electrical connection end 263 may have an adhesive, and the electrical connection end 263 may be bonded to the inner bearing platform 232g. With reference to FIG. 67, FIG. 24, and FIG. 68, the protective layer 265 of the flexible circuit board 26 may be located on the inner side of the circumferential side wall 232a, and is located between the circumferential side wall 232a and the laminated part of the flexible circuit board 26, so as to prevent the flexible circuit board 26 from being damaged due to friction caused because the laminated part is in direct contact with the circumferential side wall 232a.

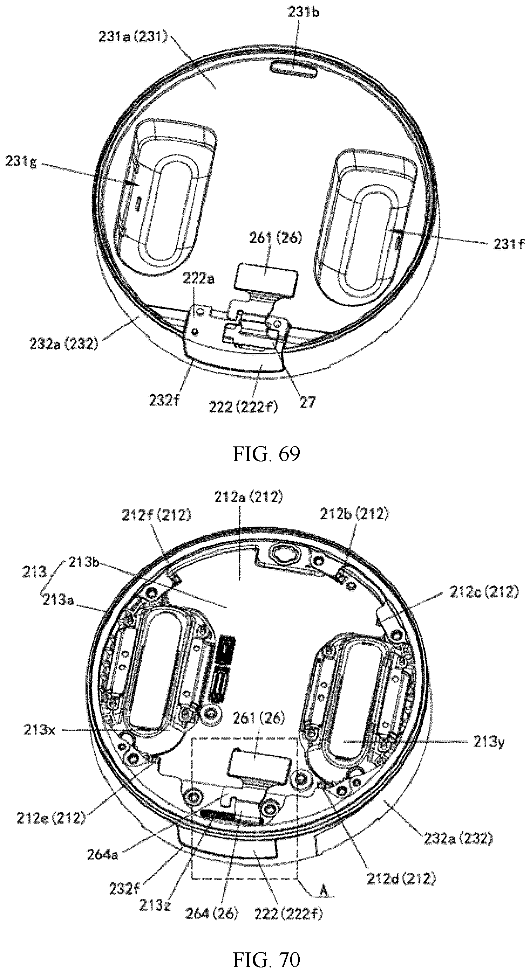

As shown in FIG. 69, the second bracket 231a of the second host housing 231 and the third host housing 232 may be assembled and fastened, and the second host housing 231 may be located on the inner side of the circumferential side wall 232a. From the perspective of FIG. 69, openings of the third accommodation groove 231f and the fourth accommodation groove 231g of the second bracket 231a face upward. The second bracket 231a covers both the third part 221c of the first shaft 221 and the third part 223c of the second shaft 223. The through hole 231b of the second bracket 231a and the shaft sleeve 222 may be respectively located at two opposite ends of a same diameter of the circumferential side wall 232a. With reference to FIG. 69 and FIG. 68, the through hole 231b may communicate with the second opening 232c of the third host housing 232.

With reference to FIG. 70 and FIG. 69, the first host housing 213 may cover the second host housing 231 and the third host housing 232. From the perspective of FIG. 70, openings of the first accommodation groove 213y and the second accommodation groove 213x of the first bracket 213b of the first host housing 213 may face downward. In this embodiment, the opening of the first accommodation groove 213y may face the opening of the third accommodation groove 231f, and the opening of the first accommodation groove 213y may be aligned with the opening of the third accommodation groove 23 1f The opening of the second accommodation groove 213x may face the opening of the fourth accommodation groove 231g, and the opening of the second accommodation groove 213x may be aligned with the opening of the fourth accommodation groove 231g.

With reference to FIG. 70 and FIG. 69, the first frame body 213a in the first host housing 213 may be fixedly connected to a side that is of the shaft sleeve 222 and that has the first outer surface 222a, and the first frame body 213a may cover a part of the first outer surface 222a and a part of the clamping member 27. The other part of the first outer surface 222a and the other part of the clamping member 27 may be exposed from the through hole 213z of the first frame body 213a. The electrical connection end 261 and the connection part 264 of the flexible circuit board 26 may pass through the through hole 213z of the first frame body 213a. The electrical connection end 261 may be connected to a circuit board of the first host circuit board assembly 212, so that the flexible circuit board 26 is electrically connected to the first host circuit board assembly 212. The grounding portion 264a of the connection part 264 may pass through the through hole 213z, and is connected to the first frame body 213a by using a conductor. The conductor may be, for example, conductive foam or a conductive adhesive. This enables the flexible circuit board 26 to be grounded, to avoid interference to antenna radiation performance of the host 2 (descriptions are further provided below). The limiting portion 264b of the connection part 264 is located in the through hole 213z.

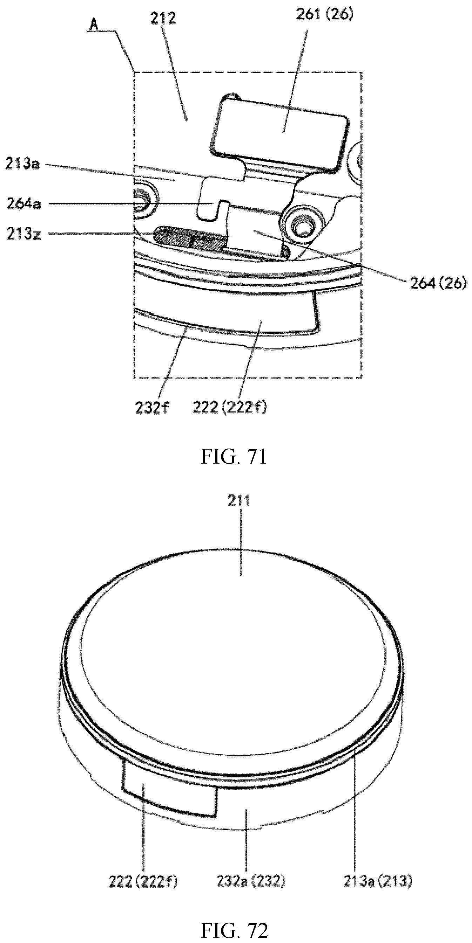

As shown in FIG. 71 and FIG. 69, the through hole 213z of the first frame body 213a may be filled with a sealing material (indicated by shading). The sealing material may fill the through hole 213z and cover the first outer surface 222a and a surface of the clamping member 27. The sealing material surrounds the connection part 264 of the flexible circuit board 26. The sealing material may be, for example, a sealant. The sealing material has a sealing effect, and can prevent moisture from intruding into the electrical connection end 261 and the first host circuit board assembly 212 through the through hole 213z of the first frame body 213a. The moisture may come from the outside, and the outside moisture may enter the through hole through an assembly gap between the shaft sleeve 222 and the circumferential side wall 232a. The moisture may also come from the inside of the host 2, and the moisture inside the host 2 may enter the through hole through an assembly gap between the shaft sleeve 222 and the second bracket 231a.

In another embodiment, a structure design may be adjusted (for example, a position and/or a size of the through hole of the first frame body 213a may be adjusted), so that only a part of the region of the clamping member 27 may be exposed from the through hole 213z of the first frame body 213a, and the first outer surface 222a of the shaft sleeve 222 is completely covered by the first frame body 213a. Accordingly, the sealing material in the through hole 213z covers only the surface of the clamping member 27. Alternatively, in another embodiment, based on an actual requirement, the first frame body 213a may not be provided with the through hole 213z, and may be sealed without filling the sealing material.

As shown in FIG. 72, the display 211 is mounted on the first host housing 213. With reference to FIG. 72, FIG. 70, and FIG. 6, the display 211 may cover the first bracket 213b of the first host housing 213, the first host circuit board assembly 212, the electrical connection end 261 and the connection part 264 of the flexible circuit board 26, and a part of the first frame body 213a of the first host housing 213. The circumferential edge of the first frame body 213a may surround a periphery of the display 211. FIG. 72 shows the closed state of the host 2. The second outer surface 222f of the shaft sleeve 222 can be seen as the external surface of the host 2.

To sum up, in the host 2, the shaft sleeve 222 of the rotating shaft assembly 22 is fixedly connected to the first part 21, and the first shaft 221 and the second shaft 223 of the rotating shaft assembly 22 are fixedly connected to the second part 23. The first part 21 can rotate around the first shaft 221 and the second shaft 223 along with the shaft sleeve 222.

The following describes a mechanism motion generated in the host 2 during opening and closing of the host 2.

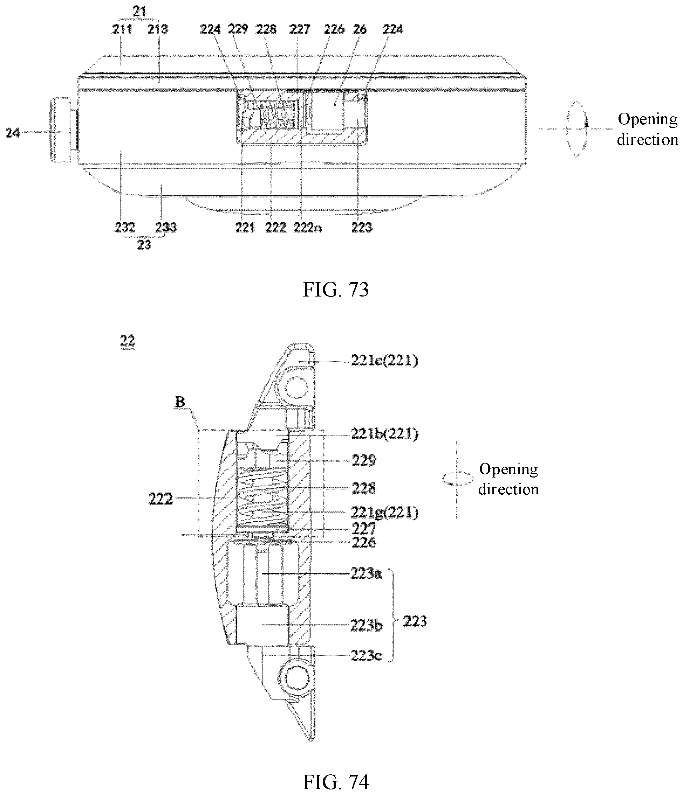

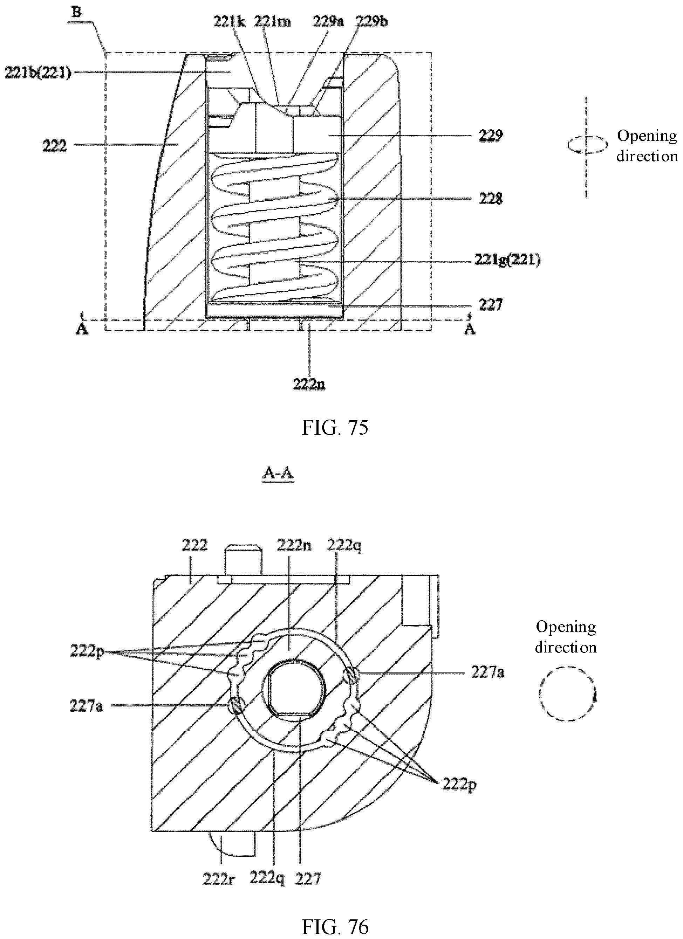

FIG. 73 is a schematic side view of the host 2 in a closed state, and FIG. 74 is a schematic top view of the rotating shaft assembly 22 of the host 2 in FIG. 73. In FIG. 73 and FIG. 74, the shaft sleeve 222 is cut open, to show an internal state of the rotating shaft assembly 22. It should be noted that a cross section of the shaft sleeve 222 in FIG. 73 and a cross section of the shaft sleeve 222 in FIG. 74 are perpendicular to each other. FIG. 75 is a partially enlarged view at a position B in FIG. 74.

As described above, when the host 2 is in the closed state, the latch portion 213d in the first part 21 forms a buckle connection with the buckle 251e of the open button 25, so that the first part 21 is locked by the second part 23.

As shown in FIG. 73 and FIG. 75, when the host 2 is in the closed state, one end of the elastic member 228 presses against the driven member 229, so that the driven member 229 remains in contact with the second part 221b. A top (namely, an end that is of the first slope 229a and that is far away from the plane 229b) of the first slope 229a of the driven member 229 may be in contact with a top (namely, an end that is of the slope 221k and that is close to the plane 221m) of the slope 221k of the second part 221b of the first shaft 221, and there is a gap between the plane 229b of the driven member 229 and the plane 221m of the second part 221b. A force of the slope 221k against the first slope 229a may cause the driven member 229 to tend to rotate in an opening direction in which the first part 21 of the host 2 may rotate to open relative to the second part 23.

As shown in FIG. 75, due to matching between the driven member 229 and the shaft sleeve 222, when the driven member 229 tends to rotate in a clockwise direction, the shaft sleeve 222 also tends to rotate in the opening direction. The shaft sleeve 222 is fixedly connected to the first part 21, so that the first part 21 also tends to rotate in the opening direction. However, because the first part 21 is locked by the second part 23, the first part 21 cannot actually rotate in the opening direction.

As shown in FIG. 75, the other end of the elastic member 228 abuts against the bump matching member 227, so that the bump matching member 227 abuts against the spacer plate 222n.

FIG. 76 is a schematic diagram of an A-A sectional structure of FIG. 75. FIG. 76 shows a sectional matching structure that includes the bump matching member 227 and the spacer plate 222n and that is obtained when the host 2 is in the closed state. The bumps 227a on the bump matching member 227 are shown in dotted lines. As shown in FIG. 76, the bumps 227a are located in the chute 222q on the spacer plate 222n, and the bumps 227a are spaced apart from the matching grooves 222p.

When the user presses the cap 251 of the open button 25, the buckle 251e of the open button 25 no longer forms a buckle connection with the latch portion 213d of the first part 21, and the first part 21 is no longer locked by the second part 23. The first rotation stroke segment of the first part 21 starts at this time.

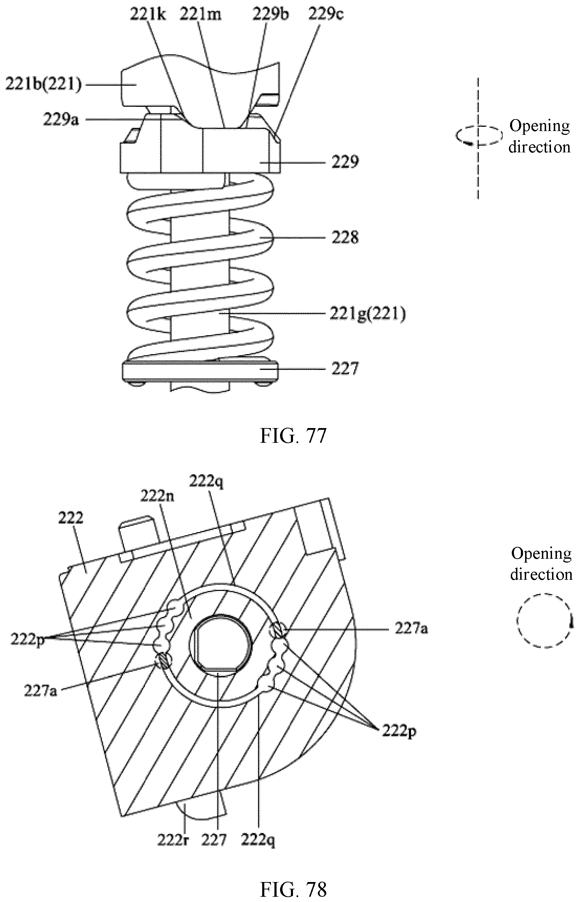

As shown in FIG. 77 (in FIG. 77, the shaft sleeve 222 is not shown, to clearly show matching between the driven member 229 and the second part 221b, and the same is hereinafter), the driven member 229 performs a composite motion under a joint action of the elastic member 228 and the slope 221k. The driven member 229 rotates in the opening direction and moves toward the second part 221b until a root of the first slope 229a (namely, one end that is of the first slope 229a and that is connected to the plane 229b) is in contact with the top of the slope 221k, and the plane 229b is in contact with the plane 221m (influence of inertia on a position of the driven member 229 can be ignored based on a structure design). With reference to FIG. 73, when the driven member 229 moves, the shaft sleeve 222 and the first part 21 also rotate around the second part 221b in the opening direction.

As shown in FIG. 73 and FIG. 2, when the driven member 229, the shaft sleeve 222, and the first part 21 stop rotating, the first part 21 completes the first rotation stroke segment, and the first part 21 is opened by an angle a relative to the second part 23. The angle a may be, for example, approximately 15°. It is easily understood that, in the first rotation stroke segment, because the first part 21 is driven by the shaft sleeve 222 to rotate, the first part 21 rotates automatically without the external force applied by the user.

With reference to FIG. 76 and FIG. 78, in the first rotation stroke segment, because the shaft sleeve 222 rotates relative to the bump matching member 227, the bumps 227a of the bump matching member 227 slide in the chute 222q and gradually approach the matching grooves 222p. When the first rotation stroke segment ends, the bumps 227a each may just reach a joint between the chute 222q and the matching groove 222p (as shown in FIG. 78). In the first rotation stroke segment, the bumps 227a always slide smoothly in the chute 222q. In this case, no displacement (or jolt) occurs between the bump matching member 227 and the shaft sleeve 222 in a direction of a rotating shaft of the shaft sleeve 222, and the bump matching member 227 does not impact the shaft sleeve 222. Therefore, when the user touches the first part 21, the user cannot experience the touch feeling feedback.

Alternatively, in another embodiment, when the first rotation stroke segment ends, the bumps 227a may enter the matching grooves 222p. When the bumps 227a enter first matching grooves 222p from the chute 222q, a displacement in the rotating shaft direction of the shaft sleeve 222 is generated between the bump matching member 227 and the shaft sleeve 222, and the bump matching member 227 may impact the shaft sleeve 222. Therefore, if the user touches the first part 21, the user may experience the touch feeling feedback.

As shown in FIG. 77, when the first part 21 is opened by the angle a relative to the second part 23, the plane 229b is in contact with the plane 221m, and a combined force applied by the elastic member 228 and the first shaft 221 to the driven member 229 in an axial direction of the main portion 221g is zero. Therefore, only the elastic member 228 and the first shaft 221 cannot drive the driven member 229 to rotate, in other words, the first part 21 cannot continue to rotate automatically. At this time, the user can rotate the first part 21 in the opening direction. The first part 21 can drive the shaft sleeve 222 to rotate in the opening direction, and the shaft sleeve 222 can drive the driven member 229 to rotate in the opening direction. It is easily understood that, because the plane 229b is in sliding contact with the plane 221m during the rotation of the driven member 229, the driven member 229 only rotates but does not move in the axial direction of the main portion 221g.

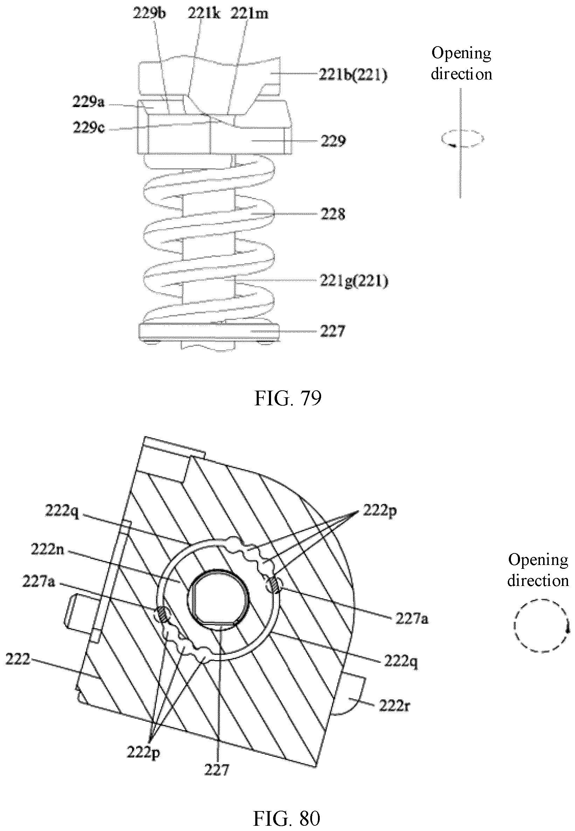

As shown in FIG. 79, when the end that is of the plane 229b and that is far away from the first slope 229a is in contact with the top of the slope 221k (or the top of the second slope 229c is in contact with the top of the slope 221k), the first part 21 may complete the second stroke segment. As shown in FIG. 3, when the second stroke segment is completed, the first part 21 is opened by an angle b relative to the second part 23. The angle b may be, for example, approximately 75°. As described above, in the second stroke segment, the first part 21 needs to be manually rotated by the user.

With reference to FIG. 78 and FIG. 80, in the second rotation stroke segment, the bumps 227a sequentially enter the respective matching grooves 222p. The bumps 227a can slide out of one matching groove 222p and into the chute 222q by the end of the second rotation stroke segment. In the second rotation stroke segment, when the bumps 227a enter and leave the matching grooves 222p, a displacement occurs between the bump matching members 227 and the shaft sleeve 222 in the direction of the rotating shaft of the shaft sleeve 222, and the bump matching members 227 impact the shaft sleeve 222. Therefore, the user can experience the touch feeling feedback.

As shown in 3, when the first part 21 is opened by the angle b relative to the second part 23, the first part 21 may start to enter the third stroke segment. A rotation feature of the first part 21 in the third stroke segment is similar to a rotation feature of the first part 21 in the first stroke segment, and the first part 21 also rotates automatically in the third stroke segment. Details are described below.

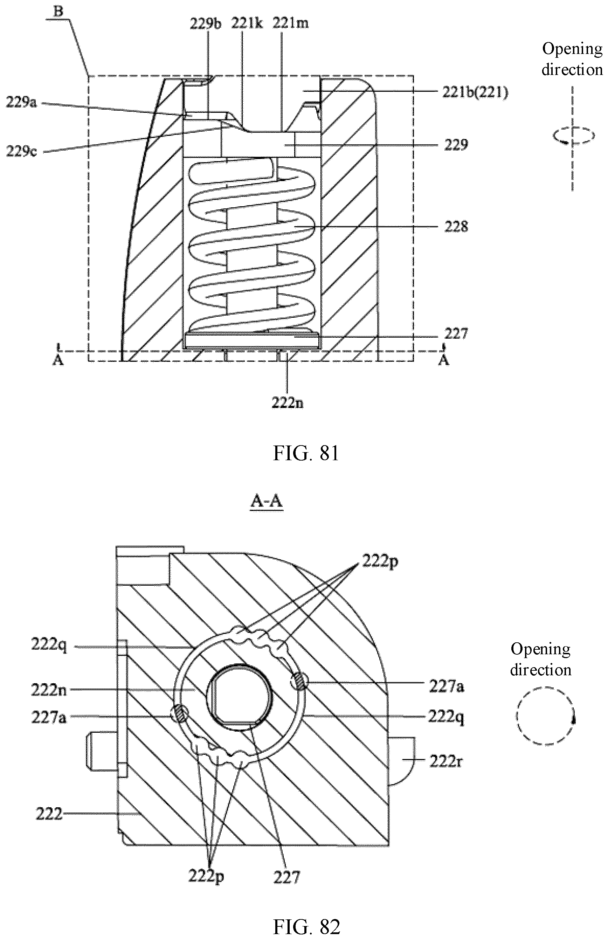

As shown in FIG. 79 and FIG. 81, when the third stroke segment begins, the top end of the second slope 229c is in contact with the top end of the slope 221k. The driven member 229 performs a composite motion under the joint action of the elastic member 228 and the slope 221k. The driven member 229 rotates in the opening direction and moves toward the second part 221b until a root of the second slope 229c (namely, one end that is of the second slope 229c and that is far away from the plane 229b) is in contact with the top of the slope 221k. When the driven member 229 moves, the shaft sleeve 222 and the first part 21 also rotate around the second part 221b in the opening direction.

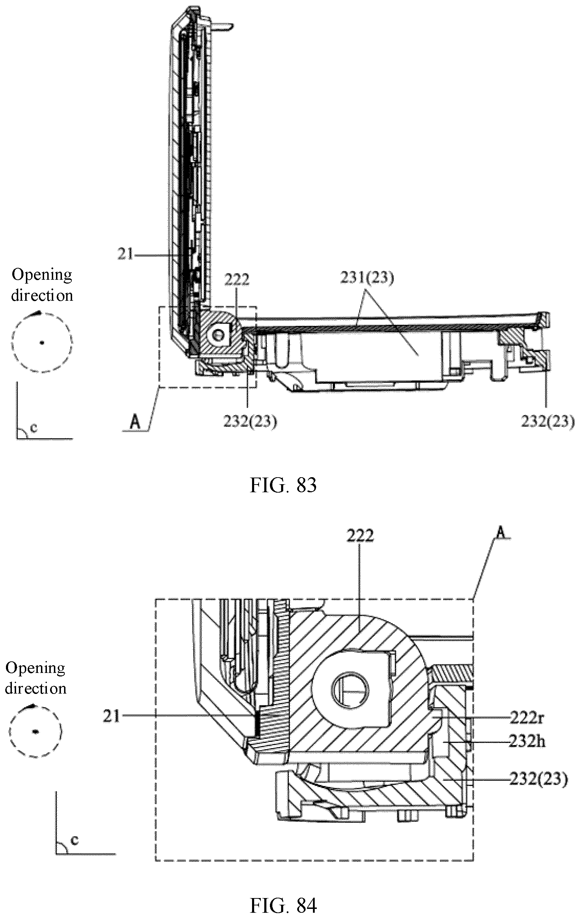

As shown in FIG. 83 and FIG. 84, the limiting protrusion 222r on the shaft sleeve 222 may enter the limiting groove 232h of the third host housing 232, and the limiting protrusion 222r abuts against an inner wall of the limiting groove 232h. In this case, because the shaft sleeve 222 cannot continue to rotate in the opening direction, the first part 21 also stops rotating.

When the driven member 229, the shaft sleeve 222, and the first part 21 stop rotating, the first part 21 completes the third rotation stroke segment. As shown in FIG. 5, the first part 21 is opened by an angle c relative to the second part 23. The angle c may be, for example, approximately 90°. It is easily understood that, in the third stroke segment, because the first part 21 is driven by the shaft sleeve 222 to rotate, the first part 21 rotates automatically without the external force applied by the user.

In this embodiment, through matching between the limiting groove 232h and the limiting protrusion 222r, the third host housing 232 can limit motion of the first part 21. Because the third host housing 232 has a larger size (compared with the rotating shaft assembly 22), and has good structural strength, assembly reliability of the limiting groove 232h and the limiting protrusion 222r is high, thereby helping ensure matching reliability of the host 2. It may be understood that, based on an actual requirement, in another embodiment, when the third stroke segment ends, the first part 21 may stop rotating through matching between the two-step ladder of the driven member and the two-step ladder of the first shaft 221. There is no need to design the limiting protrusion 222r on the shaft sleeve, and there is also no need to provide the limiting groove 232h on the third host housing 232.

With reference to FIG. 80 and FIG. 82, in the third rotation stroke segment, the bumps 227a slide smoothly in the chute 222q. In this case, no displacement occurs between the bump matching member 227 and the shaft sleeve 222 in the direction of the rotating shaft of the shaft sleeve 222, and the bump matching member 227 does not impact the shaft sleeve 222. Therefore, when the user touches the first part 21, the user cannot experience the touch feeling feedback.

With reference to FIG. 73, FIG. 67, and FIG. 62, in an opening process of the first part 21, the electrical connection end 261 of the flexible circuit board 26 rotates with the first part 21, the wound part of the flexible circuit board 26 may gradually relax, and a diameter of the wound part may gradually increase.

It is easily understood from the foregoing descriptions of the opening process of the host 2 that the entire process of closing the opened first part 21 requires manual rotation of the first part 21 in a direction opposite to the opening direction until the first part 21 is locked with the open button. In a stroke in which the opening angle of the first part 21 decreases from the angle b to the angle a, because the bumps 227a sequentially slide into and out of the matching grooves 222p, the bump matching member 227 impacts the shaft sleeve 222, and therefore there is a touch feeling feedback. In another stroke, because the bumps 227a slide smoothly in the chute 222q, the bump matching member 227 does not impact the shaft sleeve 222, and therefore there is no touch feeling feedback. In addition, in the closing process of the first part 21, the electrical connection end 261 of the flexible circuit board 26 rotates with the first part 21, the wound part of the flexible circuit board 26 may be gradually tightened, and the diameter of the wound part may gradually decrease.

As can be easily understood from the foregoing descriptions, an assembly structure including the first shaft 221, the driven member 229, the elastic member 228, and the shaft sleeve 222 in the rotating shaft assembly 22 is used to construct the cam mechanism and implement opening and closing of the host 2. The second shaft 223 of the rotating shaft assembly 22 is used to mount and wrap the flexible circuit board 26. In this embodiment, the first shaft 221 and the second shaft 223 are separately designed, so that the flexible circuit board 26 is easily assembled to the second shaft 223 and the shaft sleeve 222.

Due to a manufacturing error, the first shaft 221 and the second shaft 223 may not be concentric after being assembled (an axis of the first shaft 221 does not coincide with an axis of the second shaft 223). If no corresponding measure is taken, stress is generated when the rotating shaft assembly 22 performs a mechanism motion, which may reduce reliability of the rotating shaft assembly 22 and further cause an abnormal voice. In this embodiment, the end portion 221d of the first shaft 221 matches the groove 223e of the second shaft 223, so that an assembly tolerance can be absorbed, and stress caused by eccentricity can be reduced or avoided.

Different from this embodiment, in another embodiment, the first shaft and the second shaft may not be connected, and the end portion of the second shaft may not be provided with a groove for accommodating the end portion of the first shaft. Alternatively, in another embodiment, there may be no design in which a flexible circuit board is wound around a shaft, and an integrated single shaft may be used to replace the first shaft 221 and the second shaft 223. At this time, the limiting member 226 may not be provided.

It is easily understood from the foregoing descriptions that the assembly structure including the elastic member 228, the bump matching member 227, and the shaft sleeve 222 in the rotating shaft assembly 22 is used to implement the touch feeling feedback during opening and closing of the host 2. In another embodiment, the touch feeling feedback design may be canceled. To be specific, the bump matching member 227, and the chute 222q and the matching grooves 222p on the spacer plate 222n of the shaft sleeve 222 may not be provided. In this case, the elastic member may directly abut against the spacer plate 222n.

In this embodiment, when the shaft sleeve 222 rotates, the shaft contact member 224 mounted on the shaft sleeve 222 rotates along with the shaft sleeve 222. In addition, the shaft contact member 224 is kept in contact with the first shaft 221 and the second shaft 223. In other words, the shaft contact member 224 is in sliding contact with the first shaft 221 and the second shaft 223.

### Two feeding paths of an antenna system of the host 2

In this embodiment, both the first frame body 213a and the third host housing 232 of the host 2 may be used as antennas in the antenna system of the host 2. The following describes the two feeding paths of the antenna system of the host 2.

As shown in FIG. 70, the first frame body 213a may be in contact with the feeding spring 212f of the first host circuit board assembly 212, so that a radio frequency signal can be fed into the first frame body 213a by using the feeding spring 212f. In addition, the first frame body 213a may be in contact with the grounding spring 212b, the grounding spring 212c, the grounding spring 212d, and the grounding spring 212e of the first host circuit board assembly 212, so that the first frame body 213a can be grounded. Therefore, the first frame body 213a can serve as an antenna.

As described above, the first frame body 213a is connected to the shaft sleeve 222, the shaft contact member 224 on the shaft sleeve 222 is in contact with both the first shaft 221 and the second shaft 223, and both the first shaft 221 and the second shaft 223 are connected to the third host housing 232. Therefore, the radio frequency signal can be transmitted from the first frame body 213a to the third host housing 232 through the shaft sleeve 222, the shaft contact member 224, the first shaft 221, and the second shaft 223. Therefore, the third host housing 232 can also serve as an antenna.

It can be learned that, the first host circuit board assembly 212 is connected to the first frame body 213a and the third host housing 232 through a physical mechanical structure, to form a first feeding path of the antenna system.

When the host 2 is in the closed state, there is a small gap between the first frame body 213a and the third host housing 232 in an axial direction of the first frame body 213a (or a thickness direction of the host 2). The gap is, for example, 0.1 mm. Due to existence of the gap, the first frame body 213a may feed power to the third host housing 232 through coupling, so that the third host housing 232 can serve as an antenna.

It can be learned that, the first host circuit board assembly 212 is connected to the first frame body 213a through a physical mechanical structure, and then is electrically coupled to the third host housing 232, to form a second feeding path of the antenna system.

When the host 2 is in the closed state, the third host housing 232 in the second feeding path has high radiation. In this case, antenna performance is ensured by the host 2 together with the first frame body 213a and the third host housing 232. When the host 2 is in the open state, the third host housing 232 in the second feeding path has low radiation. In this case, antenna performance is ensured mainly through radiation of the first frame body 213a. However, compared with the closed state of the host 2, when the host 2 is in the open state, a radiation direction of the antenna system changes, which can meet a communication requirement of the host 2 in the open state. Therefore, in this embodiment, the two feeding paths of the antenna system are designed, so that different communication requirements of the host 2 in the open state and the closed state can be met, and antenna performance of the host 2 in the different states can be ensured.

It is easily understood that, in another embodiment, there may be no second feeding path. In other words, the first frame body 213a does not feed the third host housing 232 through coupling.

In this embodiment, the flexible circuit board 26 may cause interference to radiation performance of the first frame body 213a and the third host housing 232. In particular, the interference is more severe when a length of the flexible circuit board 26 is larger. As described above, the grounding portion 264a of the flexible circuit board 26 may be connected to the first frame body 213a by using a conductor. In this way, the flexible circuit board 26 can be grounded, to avoid interference of the flexible circuit board 26 to antenna radiation performance of the host 2. In another embodiment, the foregoing grounding design may not be performed on the flexible circuit board 26 based on a product requirement.

### Earphones 3

In this embodiment, structures of the first earphone 31 and the second earphone 32 may be completely consistent. The following uses the first earphone 31 as an example for description.

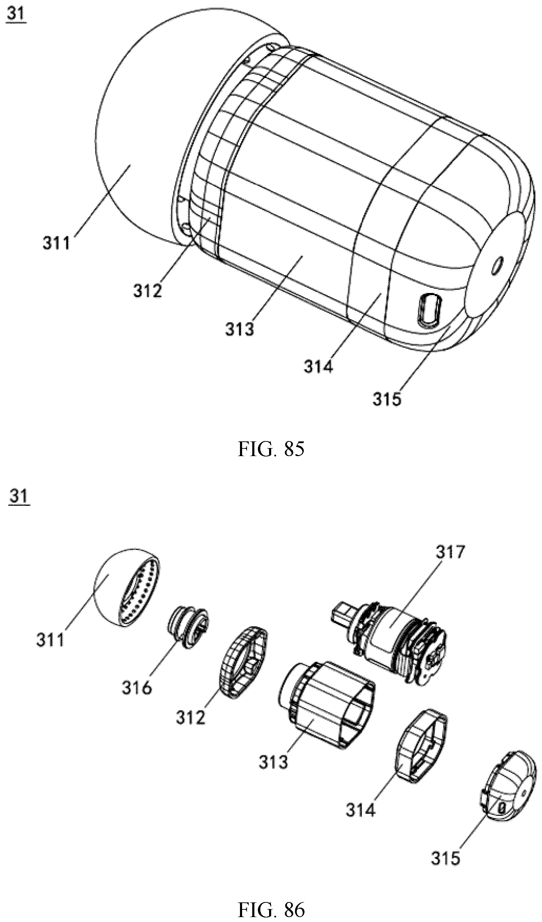

As shown in FIG. 85 and FIG. 86, the first earphone 31 may include an earplug 311, an earplug support assembly 316, a first electrode 312, an earphone front-housing assembly 313, a second electrode 314, an earphone rear-housing assembly 315, and an electronic assembly 317. Both the earplug support assembly 316 and the first electrode 312 may be mounted on one end of the earphone front-housing assembly 313, and both the second electrode 314 and the earphone rear-housing assembly 315 may be mounted on the other end of the earphone front-housing assembly 313. The earplug 311 and the earplug support assembly 316 are located at a same end of the earphone front-housing assembly 313, and the earplug 311 is mounted at an end that is of the earplug support assembly 316 and that is far away from the earphone front-housing assembly 313. The electronic assembly 317 may be mounted in a space enclosed by the earplug support assembly 316, the first electrode 312, the earphone front-housing assembly 313, the second electrode 314, and the earphone rear-housing assembly 315.

The following describes structures and assembly of the earplug 311, the earplug support assembly 316, the first electrode 312, the earphone front-housing assembly 313, the second electrode 314, and the earphone rear-housing assembly 315 in the first earphone 31, and then describes a structure and assembly of the electronic assembly 317.

As shown in FIG. 85, in this embodiment, the first electrode 312, the earphone front-housing assembly 313, the second electrode 314, and the earphone rear-housing assembly 315 may roughly form an octahedron, and an outer circumferential surface of the octahedron may include a plane and a curved surface. The plane and the curved surface are connected and alternately arranged to form a circle (in other words, each plane is connected between two curved surfaces, and each curved surface is connected between two planes). The octahedron appearance of the first earphone 31 is in a centrosymmetric shape. In another embodiment, the first earphone may alternatively have another centrosymmetric appearance shape. For example, the first earphone is roughly cylindrical or tetrahedron.

In this embodiment, a radial size of the first earphone 31 may be greater than the groove depth of the first accommodation groove 213y. For example, the radial size of the first earphone 31 may be at least twice the groove depth of the first accommodation groove 213y. The radial size may be a distance between two planes that are on the first earphone 31 and that are directly opposite to each other.

### Earphone front-housing assembly 313

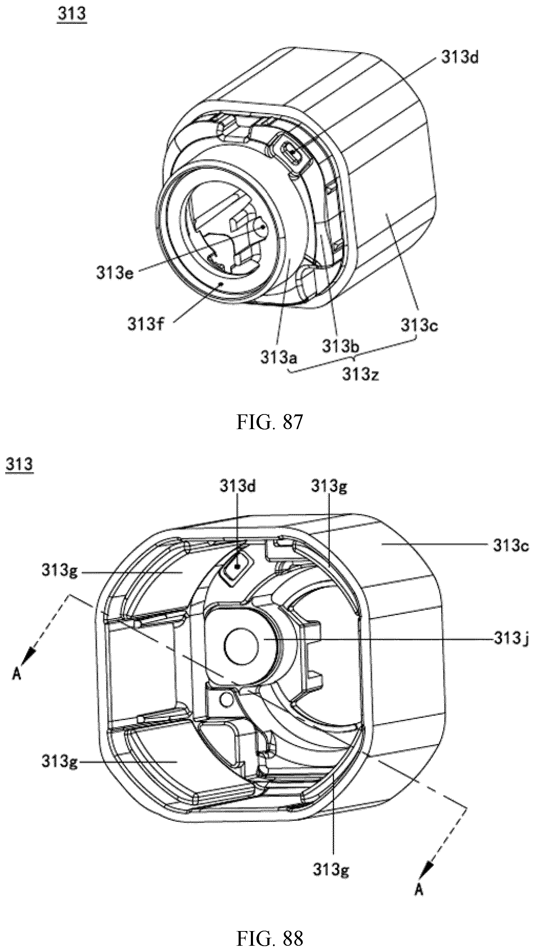

As shown in FIG. 87, FIG. 88, and FIG. 89, the earphone front-housing assembly 313 may include an earphone front housing 313z, a noise reduction microphone mesh 313j, and an earphone magnet 313g.

As shown in FIG. 87 and FIG. 88, the earphone front housing 313z may be a hollow cylindrical structure with two ends open. The earphone front housing 313z may include a first part 313a, a second part 313b, and a third part 313c that are sequentially connected. A circumferential length of the first part 313a may be less than that of the second part 313b, and the circumferential length of the second part 313b may be less than that of the third part 313c. The circumferential length is a size in a direction of a center line of the cylindrical structure that surrounds the earphone front housing 313z. The third part 313c may be roughly an octahedral cylindrical structure, and a wall of the third part 313c may include a flat part and an arc part. The flat part and the arc part are connected and alternately arranged to form a circle (in other words, each flat part is connected between two arc parts, and each arc part is connected between two flat parts).

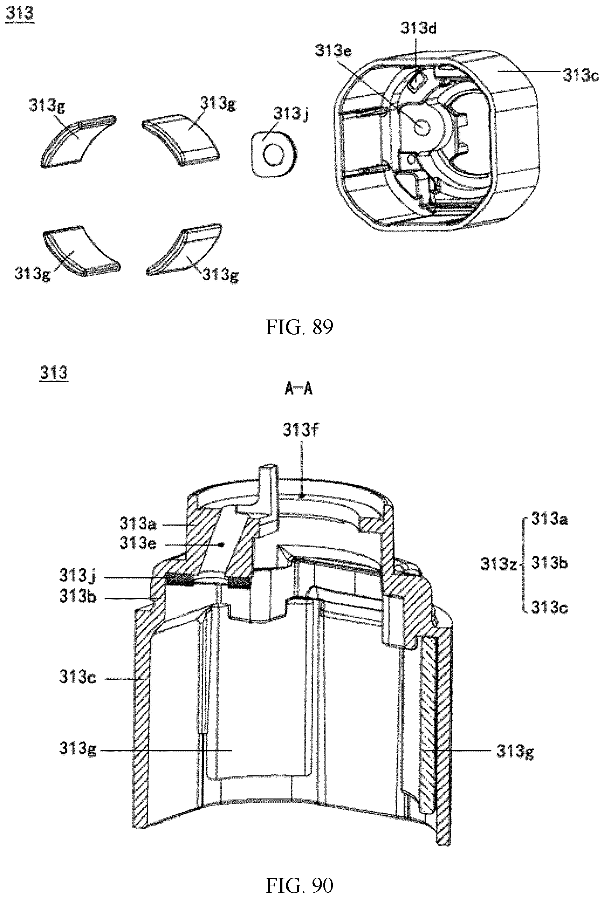

As shown in FIG. 87 and FIG. 90, an end that is of the first part 313a and that is far away from the second part 313b may form a mounting groove 313f, and the mounting groove 313f may enclose a circle. A voice pickup channel 313e may be further provided on a wall of the earphone front housing 313z, and the voice pickup channel 313e may extend roughly along a straight line. One end of the voice pickup channel 313e penetrates a bottom surface of the mounting slot 313f, and the other end of the voice pickup channel 313e communicates with an inner cavity of the earphone front housing 313z. Athrough hole 313d may be provided on the second part 313b, and the through hole 313d communicates with the inner cavity of the earphone front housing 313z.

### Noise reduction microphone mesh 313j

The noise reduction microphone mesh 313j may be roughly in a sheet shape, and may include several layers of materials, such as an acoustic mesh and an adhesive layer. As shown in FIG. 89 and FIG. 90, the noise reduction microphone mesh 313j may be fastened in the earphone front housing 313z, and an end that is of the voice pickup channel 313e and that is far away from the mounting groove 313f is sealed, so that a voice in the voice pickup channel 313e may pass through the noise reduction microphone mesh 313j.

### Earphone magnet 313g

As shown in FIG. 89, the earphone magnet 313g in this embodiment may be a single magnet. The earphone magnet 313g may have a single magnetic field direction. Alternatively, the earphone magnet 313g may have at least two magnetic field directions, and the earphone magnet 313g may form a Halbach array (which can be prepared by magnetizing different regions of a physical single magnet in different directions). For example, the earphone magnet 313g is a Halbach array having two different magnetic field directions.

In another embodiment, the earphone magnet may be formed by splicing at least two single magnets. The earphone magnet may have at least two magnetic field directions, and the earphone magnet forms a Halbach array.

As shown in FIG. 89, the earphone magnet 313g in this embodiment may be roughly a curved plate-like structure, and the curved plate-like structure may be bent in a direction around a center line of the first earphone 31. The earphone magnet 313g may match an inner wall of the third part 313c of the earphone front housing 313z in shape. The earphone magnet 313g may be fastened to the inner wall of the third part 313c of the earphone front housing 313z, for example, fastened to an inner wall of an arc part of the third part 313c.

As shown in FIG. 89, there may be four earphone magnets 313g in this embodiment, the four earphone magnets 313g may be evenly distributed on the inner wall of the third part 313c at an equal spacing, and an inner wall of each arc part of the third part 313c is provided with one earphone magnet 313g. Specifications of the four earphone magnets 313g may be the same, and magnetic field directions of the four earphone magnets 313g may be consistent.

In another embodiment, a quantity of earphone magnets may be designed based on a product requirement. For example, there may be only one earphone magnet, the earphone magnet may enclose a closed ring structure, and the earphone magnet may match the inner wall of the third part 313c in shape. The earphone magnet may form a Halbach array, and four regions in a one-to-one correspondence between the earphone magnet and the four arc parts of the third part 313c may have different magnetic field directions.

Alternatively, for example, there may be three earphone magnets, each earphone magnet may be a curved structure that surrounds a center line of the first earphone, and the three earphone magnets may be distributed at a spacing on an inner wall of the third part of the earphone front housing. The three earphone magnets may be evenly distributed at an equal spacing or unevenly distributed at a non-equal spacing. In this design, the third part of the earphone front housing may be roughly an octahedron cylindrical structure or a cylindrical structure.

### Assembly jig 100 and assembly technique of the earphone magnet 313g

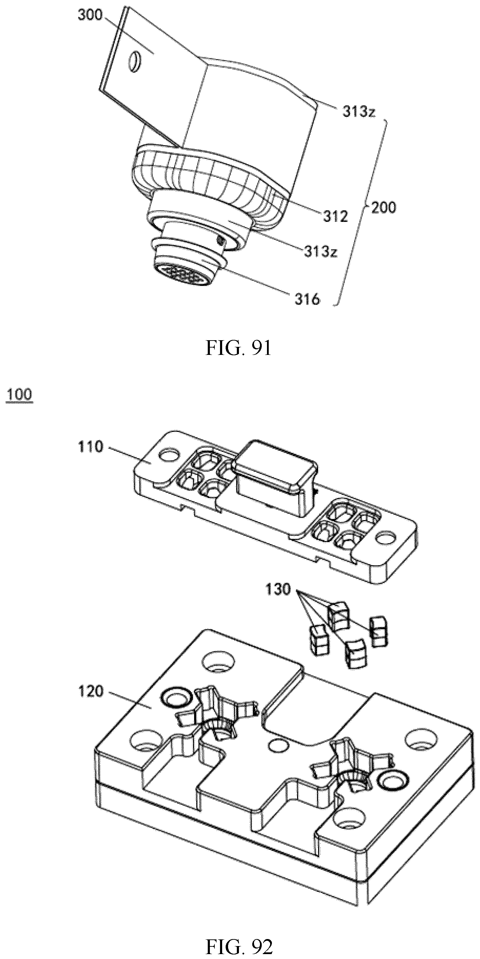

In this embodiment, to ensure accurate mounting of a magnet, an assembly jig may be used to assist in mounting the earphone magnet 313g. Based on a product assembly requirement, the earphone magnet 313g and the earphone front housing 313z may be directly assembled, and an assembly jig may be customized accordingly. Alternatively, as shown in FIG. 91, the earplug support assembly 316, the first electrode 312, and the like may be first mounted to the earphone front housing 313z to form an intermediate assembly 200, and then the earphone magnet 313g is mounted in the earphone front housing 313z of the intermediate assembly 200. An assembly jig can be customized accordingly. The following uses the latter assembly manner as an example for description.

As shown in FIG. 91 and FIG. 92, this embodiment provides the assembly jig 100 to assemble the intermediate assembly 200. The intermediate assembly 200 may include the earplug support assembly 316, the first electrode 312, and the earphone front housing 313z that are assembled in advance (an assembly structure including the earplug support assembly 316, the first electrode 312, and the earphone front housing 313z is described in detail below). For ease of taking, placing, and positioning the intermediate assembly 200, a clamp 300 may be sleeved on a periphery of the earphone front housing 313z in the intermediate assembly 200. The clamp 300 may be collar-like, and the clamp 300 wraps and clamps the earphone front housing 313z. The clamp 300 may also be used in another assemble process for the first earphone 31.

As shown in FIG. 92, the assembly jig 100 in this embodiment may include a base 120, a jig magnet 130, and an upper cover 110.

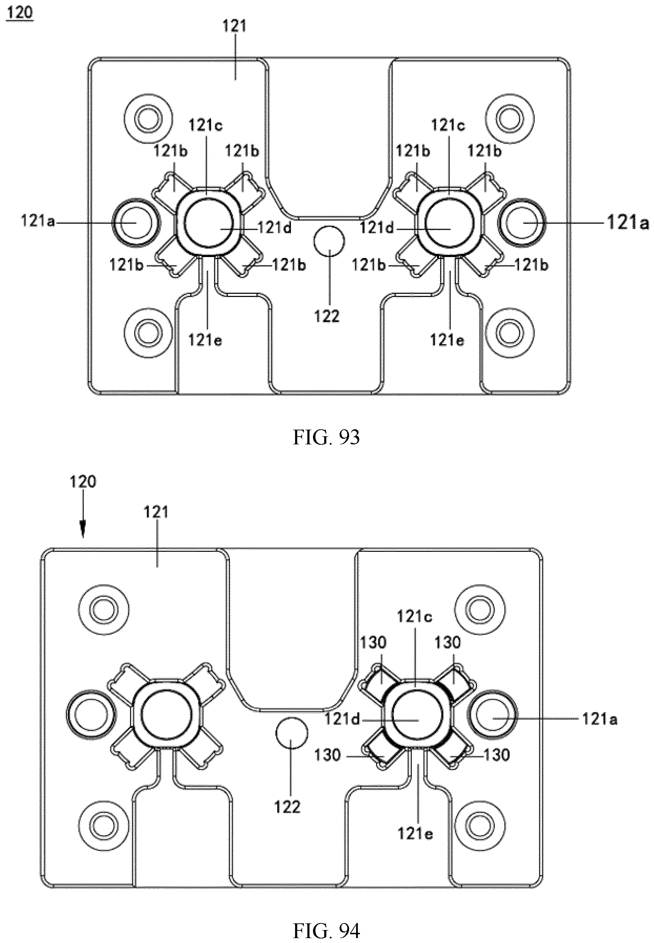

As shown in FIG. 93 and FIG. 94, the base 120 may include a bottom plate 121 and a base magnet 122 fastened to the bottom plate 121. An upper cover positioning hole 121a may be provided on the bottom plate 121. For example, there are two upper cover positioning holes 121a, and the two upper cover positioning holes 121a are respectively located at two ends of the bottom plate 121. A workpiece positioning groove 121c, a jig magnet mounting groove 121b, and a clamp accommodation groove 121e may also be provided in a region (for example, a right end region from the perspective of FIG. 93) of the bottom plate 121.

As shown in FIG. 93, an inner surface of a bottom of the workpiece positioning groove 121c may be profiled as an outer surface of the first electrode 312. A bottom wall of the workpiece positioning groove 121c may be provided with a through hole 121d, and the through hole 121d is used for the earphone front housing 313z and the earplug support assembly 316 to pass through.

As shown in FIG. 93, the jig magnet mounting grooves 121b may be located on an outer side of the workpiece positioning groove 121c, and may be connected to the workpiece positioning groove 121c. It may be considered that the jig magnet mounting grooves 121b penetrate the side wall of the workpiece positioning groove 121c. A quantity of jig magnet mounting grooves 121b may be the same as a quantity of jig magnets 130. For example, there are four jig magnet mounting grooves 121b. The four jig magnet mounting grooves 121b may be distributed around the workpiece positioning grooves 121c at an equal spacing.

With reference to FIG. 92 and FIG. 94, one jig magnet 130 may be mounted in each jig magnet mounting groove 121b. One jig magnet 130 may include only single magnet, or may be formed by connecting at least two single magnets.

As shown in FIG. 93, the clamp accommodation groove 121e may be located on a periphery of the workpiece positioning groove 121c and may communicate with the workpiece positioning groove 121c. The clamp accommodation groove 121e may be positioned between two jig magnet mounting grooves 121b.

As shown in FIG. 93, a same workpiece positioning groove 121c, a same through hole 121d, a same jig magnet mounting groove 121b, and a same clamp accommodation groove 121e may also be provided in another region (for example, a left end region from the perspective of FIG. 93) of the bottom plate 121. This design allows the assembly jig 100 to assemble two intermediate assemblies 200. The positioning grooves 121c, the through holes 121d, the jig magnet mounting grooves 121b, and the clamp accommodation grooves 121e in the two regions of the bottom plate 121 may be located between the two upper cover positioning holes 121a.

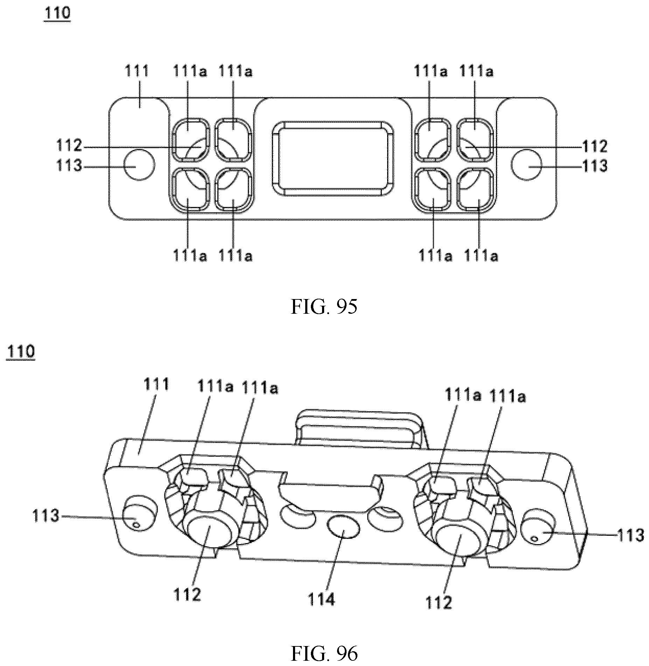

As shown in FIG. 95 and FIG. 96, the upper cover 110 may include a cover plate 111, an upper cover positioning post 113, an upper cover limiting post 112, and an upper cover magnet 114.

There may be two upper cover positioning posts 113, and the two upper cover positioning posts 113 are respectively located at two ends of the cover plate 111. A magnet placement through hole 111a may be provided in a region (for example, a right region from the perspective of FIG. 95) of the cover plate 111. A quantity of magnet placement through holes 111a may be consistent with a quantity of earphone magnets 313g. For example, there are also four magnet placement through holes 111a. The four magnet placement through holes 111a may roughly form a 2*2 matrix.

The upper cover limiting post 112 is disposed on one side in a thickness direction of the cover plate 111, and a center of the upper cover limiting post 112 may be roughly located between the four magnet placement through holes 111a. In addition, for each magnet placement through hole 111a and the upper cover limiting post 112, a part of a projection of the upper cover limiting post 112 in an axial direction of the magnet placement through hole 111a falls within a projection of the magnet placement through hole 111a in the axial direction of the magnet placement through hole 111a. In other words, from the perspective of FIG. 95, there is a part of the upper cover limiting post 112 in each magnet placement through hole 111a, and this part may be referred to as a limiting member. It is easily understood that a quantity of the members is the same as a quantity of the earphone magnets 313g. The upper cover limiting post 112 may match the inner cavity of the earphone front housing 313z in shape.

The upper cover magnet 114 may be fastened to the cover plate 111. The upper cover magnet 114 and the upper cover limiting post 112 may be located on a same side of the cover plate 111.

As shown in FIG. 95 and FIG. 96, a same magnet placement through hole 111a and a same upper cover limiting post 112 may also be designed for another region (for example, a left region from the perspective of FIG. 95) of the cover plate 111. This design allows the assembly jig 100 to assemble two intermediate assemblies 200. The magnet placement through holes 111a and the upper cover limiting posts 112 in the two regions of the cover plate 111 may be located between the two upper cover positioning posts 113.

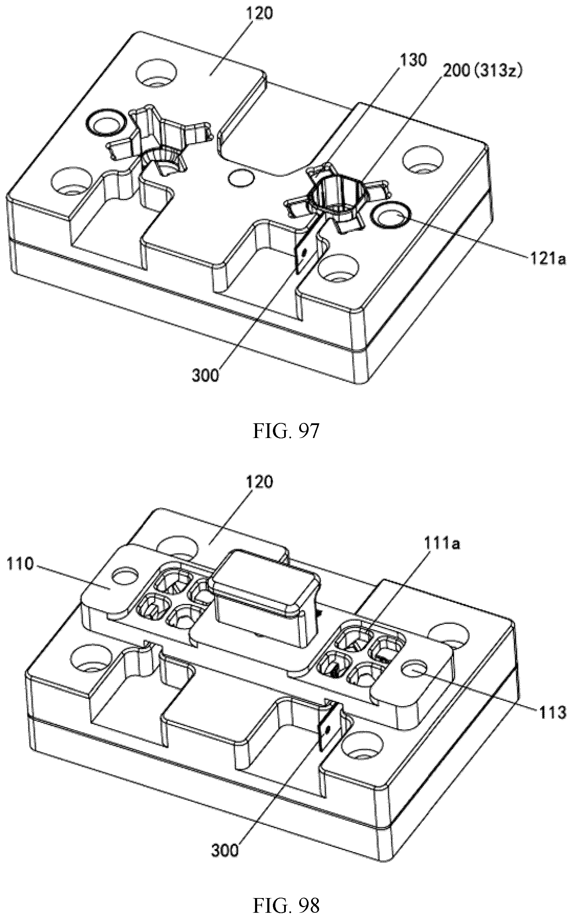

With reference to FIG. 97 to FIG. 101, the following describes a process example of fitting the four earphone magnets 313g into the intermediate assembly 200 by using the assembly jig 100.

With reference to FIG. 91 and FIG. 97, the clamp 300 and the intermediate assembly 200 are first positioned on the base 120, so that an annular part of the clamp 300 is placed in the workpiece positioning groove 121c, another part of the clamp 300 is placed in the clamp accommodation groove 121e, the earplug support assembly 316 and the earphone front housing 313z enter the through hole 121d, the first electrode 312 enters the workpiece positioning groove 121c, and the outer surface of the first electrode 312 matches an inner surface of the workpiece positioning groove 121c. In this case, each jig magnet 130 may correspond to a mounting position for mounting the earphone magnet 313g in the earphone front housing 313z.

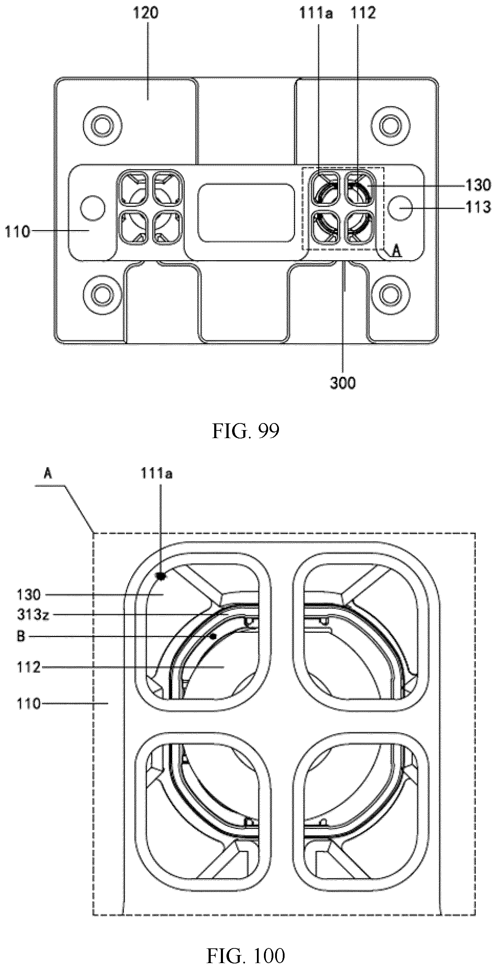

With reference to FIG. 98, FIG. 96, and FIG. 97, the upper cover 110 is mounted on the base 120, so that the cover plate 111 is in contact with the base 120, the upper cover positioning post 113 is inserted into the upper cover positioning hole 121a, and the upper cover magnet 114 is magnetically attached to the base magnet 122. With reference to FIG. 96 and FIG. 91, in this case, the upper cover limiting post 112 in the upper cover 110 is inserted into the inner cavity of the earphone front housing 313z. With reference to FIG. 99, FIG. 100, and FIG. 94, each magnet placement through hole 111a has a part of the workpiece positioning groove 121c. In other words, projections of different regions of the workpiece positioning groove 121c in the axial direction of the magnet placement through hole 111a respectively fall into each magnet placement through hole 111a. From perspectives of FIG. 99 and FIG. 100, each magnet placement through hole 111a of the upper cover 110 has a part of the earphone front housing 313z. In other words, projections of different regions of the earphone front housing 313z in the axial direction of the magnet placement through hole 111a respectively fall into each magnet placement through hole 111a.

In addition, as shown in FIG. 100, gaps B are formed between each of the limiting members of the upper cover limiting post 112 and an inner wall of the earphone front housing 313z (only one gap B is marked in the figure for brevity). Each gap B is used to accommodate one earphone magnet 313g. There is a jig magnet 130 near each gap B.

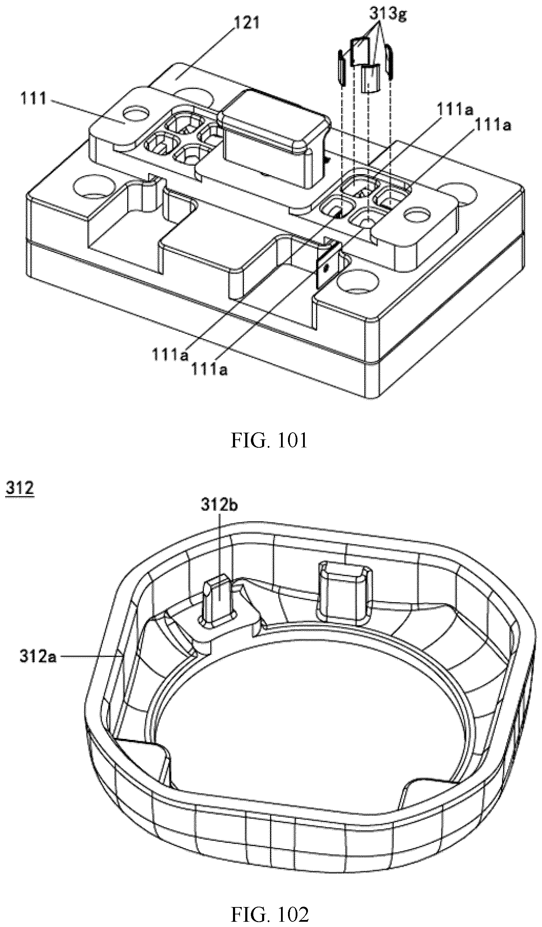

As shown in FIG. 101, the four earphone magnets 313g are respectively fitted into four gaps B via the four magnet placement through holes 111a, so that one earphone magnet 313g is located in each gap B, and each earphone magnet 313g is positioned at the mounting position in the earphone front housing 313z. The jig magnet 130 near each gap B may be magnetically attached to the earphone magnet 313g in the gap B, so that the earphone magnet 313g may be maintained at the mounting position in the earphone front housing 313z. In this way, positioning of the earphone magnet 313g can be completed.

Thereafter, the upper cover 110 may be removed to expose the intermediate assembly 200 and the earphone magnet 313g intended to be located therein. Then, the earphone magnet 313g may be fastened to the inner wall of the earphone front housing 313z by using an appropriate technique. For example, the earphone magnet 313g may be bonded to the inner wall of the earphone front housing 313z by using a dispensing technique. An adhesive used in the dispensing technique may be, for example, a fast-drying adhesive.

It is easily understood from the foregoing descriptions that the base 120 can well position the intermediate assembly 200, and a matching structure including the upper cover 110 and the base 120 can accurately define a mounting space of the earphone magnet 313g. The earphone magnet 313g can be conveniently and reliably maintained at the mounting position in the earphone front case 313z by using the jig magnet 130. Therefore, assembly precision and reliability of the earphone magnet 313g can be greatly improved by using the assembly jig 100. In addition, an assembly technique is simple, and mass production performance is good.

### First electrode 312

As shown in FIG. 102, the first electrode 312 may include an electrode body 312a and a conduction portion 312b. The electrode body 312a may be roughly a ring structure that surrounds the center line of the first earphone 31. The conduction portion 312b may be roughly columnar, and the conduction portion 312b may be convexly disposed on an inner surface of the electrode body 312a. The first electrode 312 may be made of a conductive material, for example, a metal material.

With reference to FIG. 102 and FIG. 87, the first electrode 312 may be mounted on the earphone front housing 313z. The electrode body 312a of the first electrode 312 matches the second part 313b of the earphone front case 313z. The conduction portion 312b of the first electrode 312 may pass through the through hole 313d of the earphone front housing 313z, and is electrically connected to a circuit board (descriptions are provided below) of a first earphone circuit board assembly located in the inner cavity of the earphone front housing 313z, so that the first electrode 312 serves as a charging electrode. A detailed assembly structure continues to be described below.

### Earplug support assembly 316

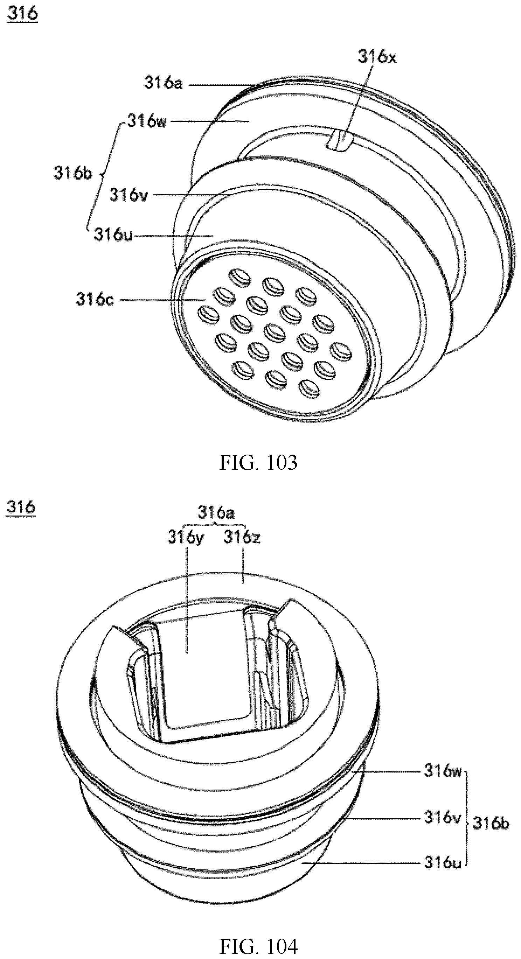

As shown in FIG. 103, FIG. 104, and FIG. 105, the earplug support assembly 316 may include an earplug support 316b, a front vent acoustic mesh 316a, and a speaker mesh 316c.

As shown in FIG. 103 to FIG. 105, the earplug support 316b may include a support body 316u, a first skirt 316v, and a second skirt 316w. The support body 316u may be roughly of a hollow cylindrical structure with two ends open. Both the first skirt 316v and the second skirt 316w may be bosses convexly disposed on an outer circumferential surface of the support body 316u, and both the first skirt 316v and the second skirt 316w may surround the support body 316u. Both the first skirt 316v and the second skirt 316w may be located between the two ends of the support body 316u. The first skirt 316v is spaced from the second skirt 316w.

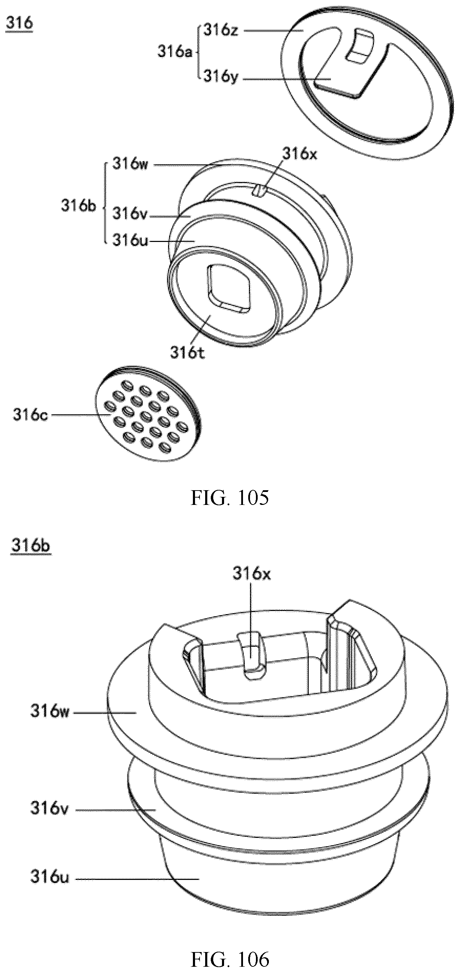

As shown in FIG. 106 and FIG. 103, a notch may be provided on an end that is of the support body 316u and that is near the second skirt 316w and roughly form a C-shaped structure. The end of the support body 316u may also have a front vent 316x, and the front vent 316x penetrates a wall of the support body 316u. An opening that is of the front vent 316x and that is on the outer circumferential surface of the support body 316u may be located on a side that is of the second skirt edge 316w and that faces the first skirt edge 316v, and the opening may be connected to the second skirt edge 316w.

As shown in FIG. 105, a mounting groove 316t may be formed at one end that is of the support body 316u and that is close to the first skirt 316v. A bottom wall of the mounting groove 316t is provided with a through hole, and the through hole communicates with an inner cavity of the support body 316u.

In this embodiment, the entire earplug support 316b or a part of the earplug support 316b may be made of a conductive material. The conductive material is, for example, metal. Because the earplug support 316b can accommodate a speaker (descriptions are provided below) in the electronic assembly 317, the earplug support 316b may also be referred to as a voice-emitting mouth.

The front vent acoustic mesh 316a may be roughly in a sheet shape, and may include several layers of materials, such as an acoustic mesh and an adhesive layer. The bent front vent acoustic mesh 316a is shown in the figure. As shown in FIG. 105, the front vent acoustic mesh 316a may include a fastening region 316z and a blocking region 316y. The fastening region 316z may be in a ring shape. The blocking region 316y may be in a rectangular strip shape, and the blocking region 316y may be connected to an inner side of the fastening region 316z. The blocking region 316y can allow air and sound waves to pass through.

As shown in FIG. 105, FIG. 104, and FIG. 106, the front vent acoustic mesh 316a may be mounted on the earplug support 316b. The fastening region 316z may be mounted on a side that is of the second skirt 316w and that is far away from the first skirt 316v. For example, an adhesive layer in the fastening region 316z may be bonded to the side of the second skirt 316w. The blocking region 316y may be bent into the inner cavity of the support body 316u, and is attached to an inner wall of the support body 316u. For example, an adhesive layer in the blocking region 316y may be bonded to the inner wall of the support body 316u. In addition, the blocking region 316y may block the front vent 316x.

With reference to FIG. 103, FIG. 104, and FIG. 87, the earplug support 316b may be mounted in the mounting slot 313f of the earphone front housing 313z. For example, the earplug support 316b may be bonded to the bottom surface of the mounting groove 313f through the adhesive layer in the fastening region 316z. A detailed assembly structure continues to be described below.

### Speaker mesh 316c

As shown in FIG. 105, the speaker mesh 316c may be roughly in a sheet shape, and may include several layers of materials, such as an acoustic mesh, an adhesive layer, and a PET sheet. A plurality of voice-emitting holes may be provided on the speaker mesh 316c.

As shown in FIG. 105, the speaker mesh 316c may be mounted in the mounting groove 316t of the support body 316u. A voice (from the speaker, descriptions are provided below) in the inner cavity of the support body 316u enters a human ear through the speaker mesh 316c.

Based on a product requirement, in another embodiment, the earplug support may further have another appropriate structure, and is not limited to the foregoing descriptions. The front vent may not be provided on the earplug support, but may be provided on the earphone front housing 313z. For example, the front vent is provided on the first part 313a of the earphone front housing 313z, and communicates with the voice pickup channel 313e. An aperture of the front vent may be small (for example, less than 0.22 mm). In this case, the front vent acoustic mesh 316a may be omitted.

### Earplug 311

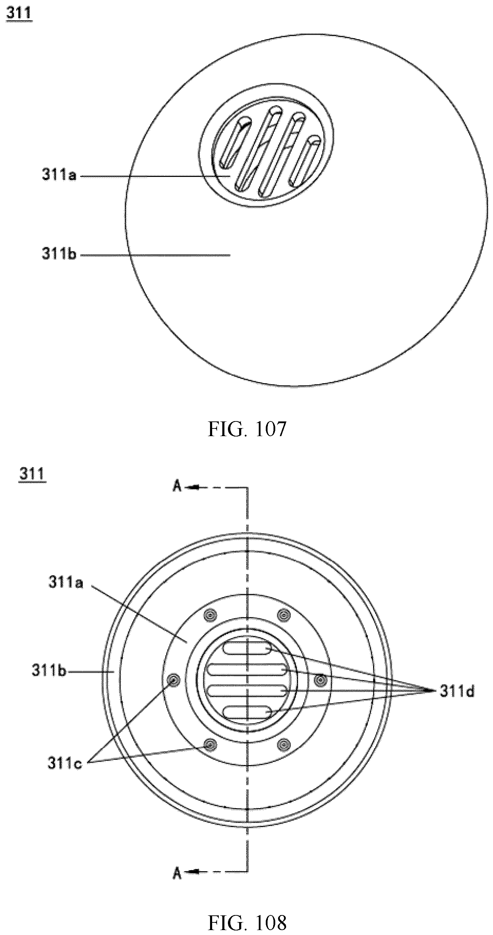

As shown in FIG. 107, FIG. 108, and FIG. 109, the earplug 311 may include an earplug inner cover 311a and an earplug outer cover 311b, and the two may be fixedly connected.

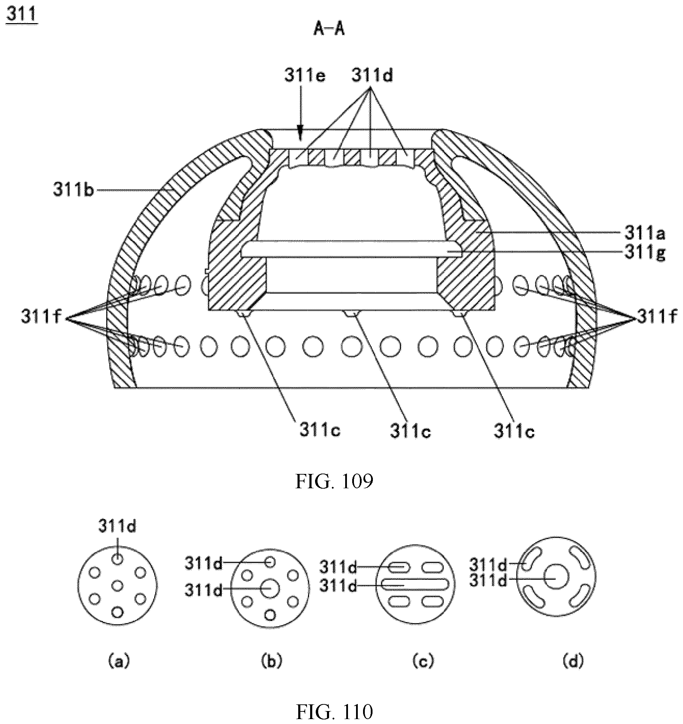

As shown in FIG. 108 and FIG. 109, the earplug inner cover 311a may be roughly a hollow rotary structure with two ends open. Several voice-emitting through holes 311d may be formed at an axial end of the earplug inner cover 311a, and all these voice-emitting through holes 311d communicate with an inner cavity of the earplug inner cover 311a. The voice-emitting through holes 311d are spaced apart from each other and may be arranged according to a specific rule.

As shown in FIG. 108, in an implementation, the voice-emitting through holes 311d may be arranged side by side. Shapes of the voice-emitting through holes 311d may be the same or similar. For example, each of the voice-emitting through holes 311d may be a runway-shaped hole. In another implementation, shapes and an arrangement of the voice-emitting through holes 311d may be designed based on a product requirement. For example, FIG. 110 shows four shapes and four arrangements of the voice-emitting through holes 311d.

In this embodiment, a speaker is provided in the inner cavity of the earplug inner cover 311a, and the voice-emitting through holes 311d may be used for a voice from the speaker to pass through, so as to enter a human ear (descriptions are further provided below). An end that is of the earplug inner cover 311a and on which the voice-emitting through holes 311d are formed may be of an ear scale-proof structure, and the ear scale-proof structure can reduce or prevent ear scale from entering the speaker.

As shown in FIG. 109, a slot 311g may further be formed on an inner wall of the earplug inner cover 311a. The slot 311g encloses a circle, and the slot 311g may be far away from the voice-emitting through holes 311d. The slot 311g matches the first skirt 316v of the earplug support 316b, so that the earplug inner cover 311a is mounted on the earplug support 316b (a detailed assembly structure continues to be described below).

As shown in FIG. 108 and FIG. 109, several second bumps 311c may be provided on a surface of one end that is of the earplug inner cover 311a and that is far away from the voice-emitting through holes 311d, and these second bumps 311c may be spaced apart from each other and enclose a circle.

As shown in FIG. 107 to FIG. 109, the earplug outer cover 311b may be roughly a hollow rotary body with two ends open. An end of the earplug outer cover 311b in an axial direction may be fixedly connected to the end that is of the earplug inner cover 311a and on which the voice-emitting through holes 311d are formed. The earplug outer cover 311b may surround a periphery of the earplug inner cover 311a. Several first bumps 311f may be provided on an inner wall of the other end in the axial direction of the earplug outer cover 311b. The second bumps 311c may be spaced from each other and enclose a circle.

In this embodiment, the earplug inner cover 311a may be made of a material that is hard and not easily deformed, so as to form a reliable connection to the earplug support 316b, and have functions of accommodating and protecting the earplug support 316b. The earplug outer cover 311b may be made of a material that is soft and easily deformed, so as to fit and adapt to an ear canal.

### Second electrode 314

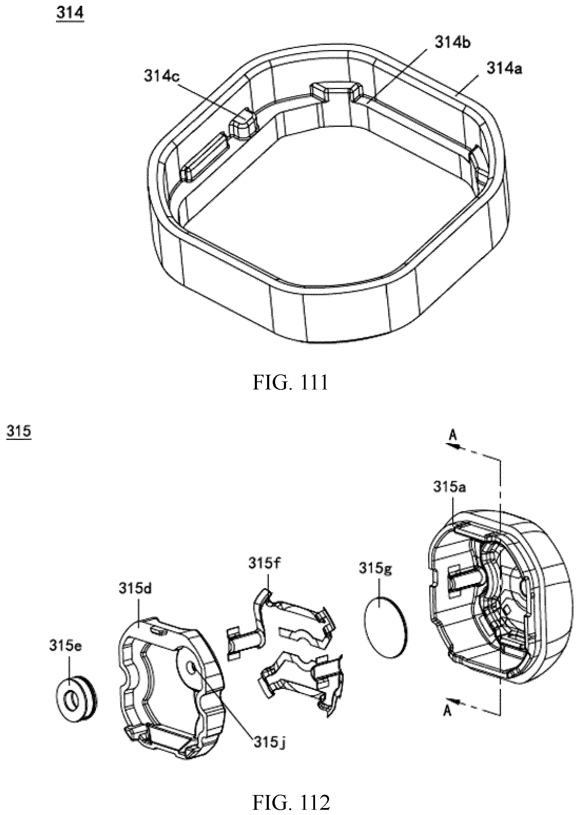

As shown in FIG. 111, the second electrode 314 may include an electrode body 314a, an inner bearing platform 314b, and a conduction portion 314c. The electrode body 314a may be a ring structure that surrounds the center line of the first earphone 31. The inner bearing platform 314b is located on an inner side of the electrode body 314a, and the inner bearing platform 314b may circle around the electrode body 314a. The conduction portion 314c may be roughly columnar, and the conduction portion 314c may be located on the inner side of the electrode body 314a, and may be convexly disposed on the inner bearing platform 314b. The second electrode 314 may be made of a conductive material, for example, a metal material.

With reference to FIG. 111 and FIG. 88, the second electrode 314 may be connected to the earphone front housing 313z. The electrode body 314a of the second electrode 314 matches the third part 313c of the earphone front housing 313z. The conduction portion 314c of the second electrode 314 may be electrically connected to a circuit board (descriptions are provided below) that is located in the second electrode 314 and that is in the second earphone circuit board assembly 317g, so that the second electrode 314 serves as another charging electrode. A detailed assembly structure continues to be described below.

### Earphone rear-housing assembly 315

As shown in FIG. 112, FIG. 113, and FIG. 114, the earphone rear-housing assembly 315 may include an earphone rear housing 315a, a first primary microphone mesh 315g, an antenna 315f, a rear housing support 315d, and a second primary microphone mesh 315e. The first primary microphone mesh 315g, the antenna 315f, the rear housing support 315d, and the second primary microphone mesh 315e may all be accommodated on an inner side of the earphone rear housing 315a.

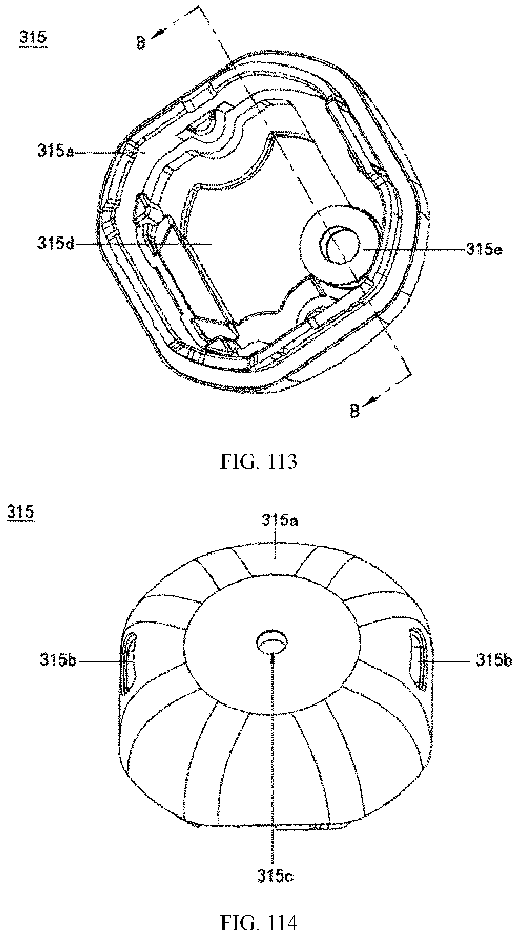

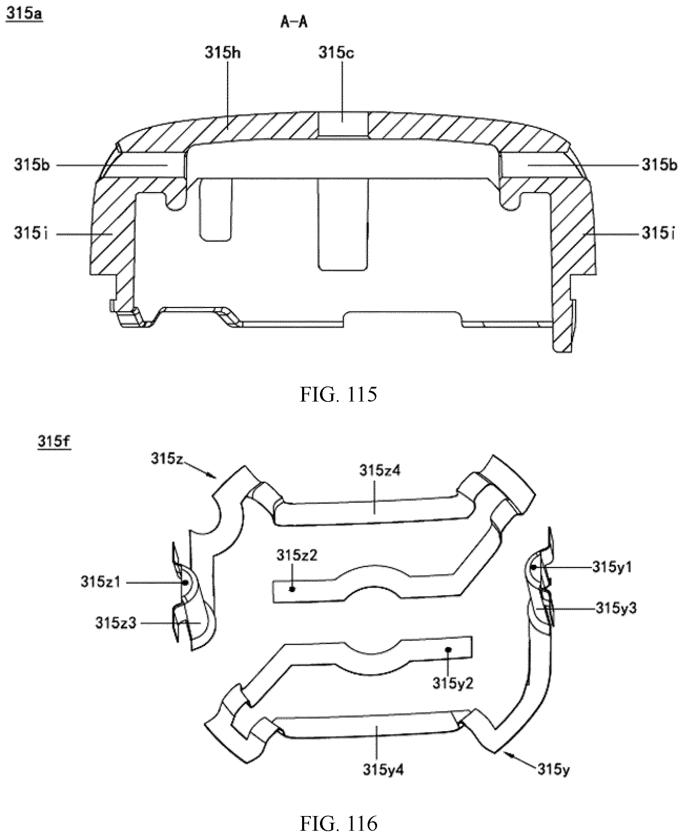

As shown in FIG. 113, FIG. 114, and FIG. 115 (FIG. 115 is a schematic diagram of an A-A sectional structure of the earphone rear housing 315a in FIG. 112), the earphone rear housing 315a may be roughly in a bowl shape. The earphone rear housing 315a may include a bottom wall 315h, and a circumferential side wall 315i surrounding a periphery edge of the bottom wall 315h. The circumferential side wall 315i and the bottom wall 315h enclose an open cavity. A voice pickup through hole 315c may be provided on the bottom wall 315h, and the voice pickup through hole 315c communicates with an inner cavity of the earphone rear housing 315a. Several wind noise prevention through holes 315b may be provided on the circumferential side wall 315i, and the wind noise prevention through holes 315b communicate with the inner cavity of the earphone rear housing 315a. For example, there may be two wind noise prevention through holes 315b, and the two wind noise prevention through holes 315b may be basically symmetrically distributed on both sides of the voice pickup through hole 315c. Alternatively, a quantity of wind noise prevention through holes 315b may be greater than or equal to two, for example, three or four, and these wind noise prevention through holes 315b may be spaced apart from each other.

### Antenna 315f

In this embodiment, the antenna 315f may be a common mode antenna, and may include two antenna stubs that are physically separated but can work in a coupling mode. The two antenna stubs are coupled, so that the antenna 315f works on a specified frequency band. The antenna 315f may be, for example, a Bluetooth antenna, and the specified frequency band may be, for example, 2.4 GHz.

As shown in FIG. 116, in the implementation 1 of this embodiment, the antenna 315f may include a first antenna stub 315z and a second antenna stub 315y. Both the first antenna stub 315z and the second antenna stub 315y may be roughly a bent narrow-strip structure.

As shown in FIG. 116, the first antenna stub 315z may include a first segment 315z3 and a second segment 315z4, and the first segment 315z3 and the second segment 315z4 are bent and connected. For example, the first segment 315z3 and the second segment 315z4 may be roughly perpendicular to each other. An end that is of the first segment 315z3 and that is far away from the second segment 315z4 is referred to as a head end 315z1, and an end that is of the second segment 315z4 and that is far away from the first segment 315z3 is referred to as a tail end 315z2. In other words, the head end 315z1 and the tail end 315z2 are respectively two opposite ends of the first antenna stub 315z. The first segment 315z3 may be roughly in a straight-line shape, and the second segment 315z4 may be in a bent shape.

As shown in FIG. 116, similarly, the second antenna stub 315y may include a third segment 315y3 and a fourth segment 315y4, and the third segment 315y3 and the fourth segment 315y4 are bent and connected. For example, the third segment 315y3 and the fourth segment 315y4 may be roughly perpendicular to each other. An end that is of the third segment 315y3 and that is far away from the fourth segment 315y4 is referred to as a head end 315y1, and an end that is of the fourth segment 315y4 and that is far away from the third segment 315y3 is referred to as a tail end 315y2. In other words, the head end 315y1 and the tail end 315y2 are respectively two opposite ends of the second antenna stub 315y. The third segment 315y3 may be roughly in a straight-line shape, and the fourth segment 315y4 may be in a bent shape. As shown in FIG. 116, the first antenna stub 315z and the second antenna stub 315y may be basically centrosymmetric, that is, the first antenna stub 315z basically overlaps the second antenna stub 315y after being rotated 180° around a center. For an entire region occupied by the first antenna stub 315z and the second antenna stub 315y, from the head end 315z1 to the tail end 315z2 of the first antenna stub 315z, the first antenna stub 315z is bent and extends along an outward-inward path (for example, from the perspective of FIG. 116, the first antenna stub 315z is bent in the clockwise direction); and from the head end 315y1 to the tail end 315y2 of the second antenna stub 315y, the second antenna stub 315y is bent and extends along an outward-inward path (for example, from the perspective of FIG. 116, the second antenna stub 315y is bent in the clockwise direction). The head end 315z1 and the head end 315y1 are located outside, and the head end 315z1 is far away from the head end 315y1. Both the tail end 315z2 and the tail end 315y2 are located between the head end 315z1 and the head end 315y1, the tail end 315z2 is close to the tail end 315y2, and the tail end 315z2 and the tail end 315y2 are coupled, so that the antenna 315f works in the 2.4G frequency band.

As described below, both the head end 315z1 and the head end 315y1 are connected to a feeding point on a circuit board of the third earphone circuit board assembly 317h in the electronic assembly 317, so that both the first antenna stub 315z and the second antenna stub 315y can receive and send signals. The two feeding points may be symmetrical with respect to the center line of the first earphone 31.

With reference to FIG. 116, FIG. 112, and FIG. 115, in the implementation 1, the antenna 315f may be disposed on an inner wall of the earphone rear housing 315a, both the head end 315z1 and the head end 315y1 may be located on an inner surface of the circumferential side wall 315i of the earphone rear housing 315a, and both the tail end 315z2 and the tail end 315y2 may be located on an inner surface of the bottom wall 315h of the earphone rear housing 315a. From the head end 315z1 to the tail end 315z2 of the first antenna stub 315z, the second segment 315z4 of the first antenna stub 315z may extend roughly in a direction from the circumferential side wall 315i to the bottom wall 315h. From the head end 315y1 to the tail end 315y2 of the second antenna stub 315y, the fourth segment 315y4 of the second antenna stub 315y may also extend roughly in the direction from the circumferential side wall 315i to the bottom wall 315h.

For example, the antenna 315f may be formed on the inner wall of the earphone rear housing 315a by using a laser direct structuring (laser direct structuring, LDS) technique, that is, the antenna 315f may be, for example, an LDS antenna.

Different wearing angles of the first earphone 31 in the ear canal may cause the first antenna stub 315z to be closer to the human body, or the second antenna stub 315y to be closer to the human body. For an antenna stub closer to the human body, antenna performance deteriorates (for example, antenna efficiency is low), and signal quality becomes poor.

Therefore, when the first earphone 31 works at different wearing angles, the first earphone 31 may detect an antenna stub with better signal quality in the antenna 315f, and select the antenna stub (an antenna stub further away from the human body) with better signal quality as a feeding end and another antenna stub as a grounding end. For example, a received signal strength (received signal strength indicator, RSSI) value may be detected to determine signal quality of an antenna stub. A controller and a switch circuit may be built in the first earphone 31. The controller is configured to: determine the antenna stub with good signal quality, switch the antenna stub to the feeding end by using the switch circuit, and switch an antenna stub with poor signal quality to the grounding end. For example, the controller may be disposed on a circuit board in the second earphone circuit board assembly 317g (descriptions are provided below). For example, the switch circuit may be disposed on a circuit board in the third earphone circuit board assembly 317h (descriptions are provided below). It may be understood that positions of the controller and the switch circuit may be designed as required, and are not limited to the foregoing descriptions.

For example, when the first earphone 31 is worn at a first wearing angle, the second antenna stub 315y is further away from the human body. In this case, the first earphone 31 may detect that the second antenna stub 315y has better signal quality, and select the second antenna stub 315y as the feeding end and the first antenna stub 315z as the grounding end. Alternatively, when the first earphone 31 is worn at a second wearing angle, the first antenna stub 315z is further away from the human body. In this case, the first earphone 31 may detect that the first antenna stub 315z has better signal quality, and select the first antenna stub 315z as the feeding end and the second antenna stub 315y as the grounding end.

In the antenna 315f in this implementation, two antenna stubs that are centrosymmetrically distributed and work in coupling mode are designed, so that when the user wears the first earphone 31 at different wearing angles, antenna performance of the first earphone 31 can be ensured, to ensure communication quality of the first earphone 31 and user experience.

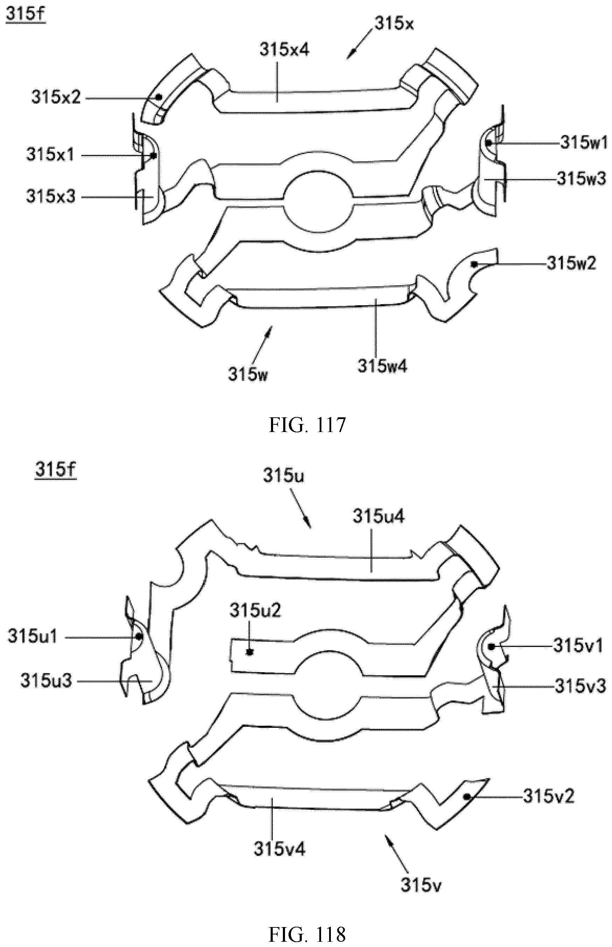

As shown in FIG. 117, in an implementation 2 of this embodiment, the antenna 315f may include a first antenna stub 315x and a second antenna stub 315w. Both the first antenna stub 315x and the second antenna stub 315w may be roughly a bent narrow-strip structure.

As shown in FIG. 117, the first antenna stub 315x may include a first segment 315x3 and a second segment 315x4, and the first segment 315x3 and the second segment 315x4 are bent and connected. For example, the first segment 315x3 and the second segment 315x4 may be roughly perpendicular to each other. An end that is of the first segment 315x3 and that is far away from the second segment 315x4 is referred to as a head end 315x1, and an end that is of the second segment 315x4 and that is far away from the first segment 315x3 is referred to as a tail end 315x2. In other words, the head end 315x1 and the tail end 315x2 are respectively two opposite ends of the first antenna stub 315x. The first segment 315x3 may be roughly in a straight-line shape, and the second segment 315x4 may be in a bent shape.

As shown in FIG. 117, similarly, the second antenna stub 315w may include a third segment 315w3 and a fourth segment 315w4, and the third segment 315w3 and the fourth segment 315w4 are bent and connected. For example, the third segment 315w3 and the fourth segment 315w4 may be roughly perpendicular to each other. An end that is of the third segment 315w3 and that is far away from the fourth segment 315w4 is referred to as a head end 315w1, and an end that is of the fourth segment 315w4 and that is far away from the third segment 315w3 is referred to as a tail end 315w2. In other words, the head end 315w1 and the tail end 315w2 are respectively two opposite ends of the second antenna stub 315w. The third segment 315w3 may be roughly in a straight-line shape, and the fourth segment 315w4 may be in a bent shape.

As shown in FIG. 117, the first antenna stub 315x and the second antenna stub 315w may be basically centrosymmetric.

Different from those in the implementation 1, in the implementation 2, for an entire region occupied by the first antenna stub 315x and the second antenna stub 315w, from the head end 315x1 to the tail end 315x2 of the first antenna stub 315x, the first antenna stub 315x is bent and extends along an inward-outward path (for example, from the perspective of FIG. 117, the first antenna stub 315x is bent in a counterclockwise direction); and from the head end 315w1 and the tail end 315w2 of the second antenna stub 315w, the second antenna stub 315w is bent and extends along an inward-outward path (for example, from the perspective of FIG. 117, the second antenna stub 315w is bent in the counterclockwise direction). The head end 315x1, the tail end 315x2, the head end 315w1, and the tail end 315w2 are all located on an outer side. The head end 315x1 is close to the head end 315w1 and coupling is generated, so that the antenna 315f works on the 2.4 G frequency band.

As shown in FIG. 117, FIG. 112, and FIG. 115, in the implementation 2, the antenna 315f may be disposed on the inner wall of the earphone rear housing 315a. Both the head end 315x1 and the head end 315w1 may be located on the inner surface of the circumferential side wall 315i of the earphone rear housing 315a. Both the tail end 315x2 and the tail end 315w2 may be located on the inner surface of the bottom wall 315h of the earphone rear housing 315a, and may be close to the circumferential side wall 315i. Different from those in the implementation 1, in the implementation 2, from the head end 315x1 to the tail end 315x2 of the first antenna stub 315x, the second segment 315x4 of the first antenna stub 315x may extend roughly in a direction from the bottom wall 315h to the circumferential side wall 315i; and from the head end 315w1 to the tail end 315w2 of the second antenna stub 315w, the fourth segment 315w4 of the second antenna stub 315w may also extend roughly in the direction from the bottom wall 315h to the circumferential side wall 315i.

The implementation 2 provides another topology structure of the antenna 315f, to meet an antenna design requirement of the first earphone 31.

As shown in FIG. 118, in the implementation 3 of this embodiment, the antenna 315f may include a first antenna stub 315u and a second antenna stub 315v. Both the first antenna stub 315u and the second antenna stub 315v may be roughly a bent narrow-strip structure.

As shown in FIG. 118, the first antenna stub 315u may include a first segment 315u3 and a second segment 315u4, and the first segment 315u3 and the second segment 315u4 are bent and connected. For example, the first segment 315u3 and the second segment 315u4 may be roughly perpendicular to each other. An end that is of the first segment 315u3 and that is far away from the second segment 315u4 is referred to as a head end 315u1, and an end that is of the second segment 315u4 and that is far away from the first segment 315u3 is referred to as a tail end 315u2. In other words, the head end 315u1 and the tail end 315u2 are respectively two opposite ends of the first antenna stub 315u. The first segment 315u3 may be roughly in a straight-line shape, and the second segment 315u4 may be in a bent shape.

As shown in FIG. 118, similarly, the second antenna stub 315v may include a third segment 315v3 and a fourth segment 315v4, and the third segment 315v3 and the fourth segment 315v4 are bent and connected. For example, the third segment 315v3 and the fourth segment 315v4 may be roughly perpendicular to each other. An end that is of the third segment 315v3 and that is far away from the fourth segment 315v4 is referred to as a head end 315v1, and an end that is of the fourth segment 315v4 and that is far away from the third segment 315v3 is referred to as a tail end 315v2. In other words, the head end 315v1 and the tail end 315v2 are respectively two opposite ends of the second antenna stub 315v. The third segment 315v3 may be roughly in a straight-line shape, and the fourth segment 315v4 may be in a bent shape.

Different from those in the implementation 1, in the implementation 3, from an entire region occupied by the first antenna stub 315u and the second antenna stub 315v, from the head end 315u1 to the tail end 315u2 of the first antenna stub 315u, the first antenna stub 315u is bent and extends along an outward-inward path (for example, from the perspective of FIG. 118, the first antenna stub 315u is bent in the clockwise direction); and from the head end 315v1 and the tail end 315v2 of the second antenna stub 315v, the second antenna stub 315v is bent and extends along an outward-inward path (for example, from the perspective of FIG. 118, the second antenna stub 315v is bent in the counterclockwise direction). The head end 315u1, the head end 315v1, and the tail end 315v2 are all located on an outer side, and the tail end 315u2 is located on an inner side. The tail end 315u2 is close to the head end 315v1, and coupling is generated, so that the antenna 315f works on the 2.4 G frequency band.

As shown in FIG. 117, FIG. 112, and FIG. 115, in the implementation 3, the antenna 315f may be disposed on the inner wall of the earphone rear housing 315a. Both the head end 315u1 and the head end 315v1 may be located on the inner surface of the circumferential side wall 315i of the earphone rear housing 315a. Both the tail end 315u2 and the tail end 315v2 may be located on the inner surface of the bottom wall 315h of the earphone rear housing 315a, and the tail end 315v2 may be close to the circumferential side wall 315i. Different from those in the implementation 1, in the implementation 3, from the head end 315u1 to the tail end 315u2 of the first antenna stub 315u, the second segment 315u4 of the first antenna stub 315u may extend roughly in the direction from the circumferential side wall 315i to the bottom wall 315h. From the head end 315v1 to the tail end 315v2 of the second antenna stub 315v, the fourth segment 315v4 of the second antenna stub 315v may also extend roughly in the direction from the bottom wall 315h to the circumferential side wall 315i.

The implementation 3 provides another topology structure of the antenna 315f, to meet the antenna design requirement of the first earphone 31.

The foregoing implementations enumerate three topologies and three coupling manners of the antenna 315f. Embodiments of this application are actually not limited thereto. Another topology structure and coupling manner of the antenna 315f may alternatively be designed based on a product requirement. For example, from a head end to the tail end, the second segment may extend roughly in a direction from the bottom wall 315h to the circumferential side wall 315i, and the fourth segment may extend roughly in a direction from the circumferential side wall 315i to the bottom wall 315h. The head end of the first antenna stub may be coupled to the tail end of the second antenna stub, so that the antenna 315f works on the specified frequency band.

The foregoing describes three example topologies of the antenna 315f. It may be understood that, in this embodiment, a specific structure of the antenna 315f may be designed based on a product requirement, and is not limited to the foregoing descriptions. For ease of description, the following uses the antenna 315f in the implementation 1 as an example to describe content related to the antenna 315f.

### First primary microphone mesh 315g

The first primary microphone mesh 315g may be roughly in a circular sheet shape, and may include several layers of materials, such as an acoustic mesh and an adhesive layer. With reference to FIG. 112 and FIG. 115, the first primary microphone mesh 315g may be fixedly connected to the bottom wall 315h of the earphone rear housing 315a. For example, an adhesive layer in the first primary microphone mesh 315g may be bonded to the bottom wall 315h. In addition, the first primary microphone mesh 315g covers the voice pickup through hole 315c, and a voice entering the voice pickup through hole 315c may enter the inner cavity of the earphone rear housing 315a through the first primary microphone mesh 315g.

### Rear housing support 315d

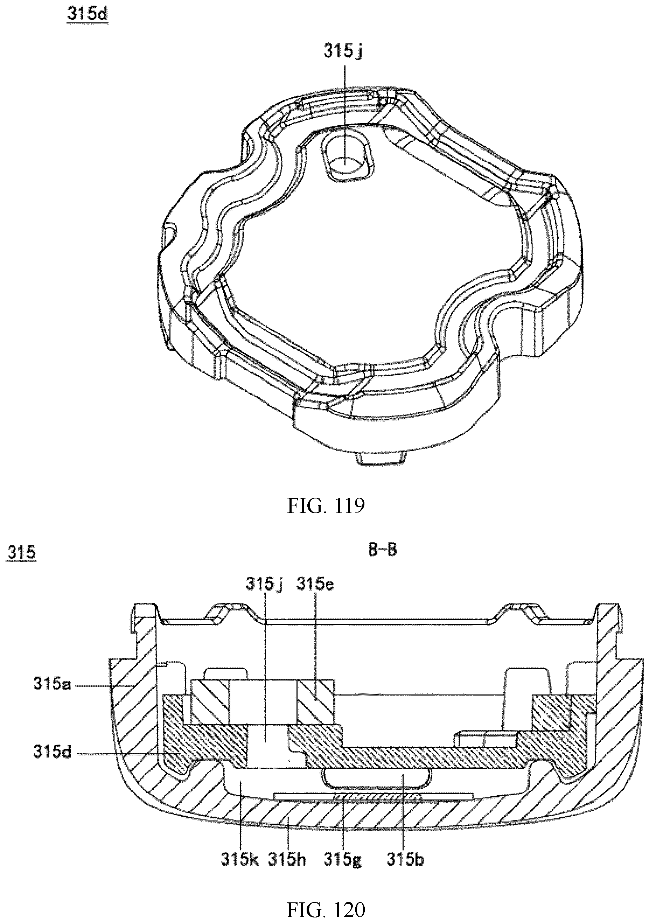

As shown in FIG. 112 and FIG. 119, the rear housing support 315d may be roughly in a hood shape. A through hole 315j may be provided on the rear housing support 315d.

### Second primary microphone mesh 315e

As shown in FIG. 112, the second primary microphone mesh 315e may be roughly in a circular sheet shape, and may include several layers of materials, such as an acoustic mesh, foam, and an adhesive layer. With reference to FIG. 112 and FIG. 119, the second primary microphone mesh 315e may be fastened to one side of the rear housing support 315d. For example, an adhesive layer in the second primary microphone mesh 315e may be bonded to the side of the rear housing support 315d. Further, the second primary microphone mesh 315e covers the through hole 315j, and a voice entering the through hole 315j may pass through the second primary microphone mesh 315e.

FIG. 120 is a B-B sectional view of the earphone rear-housing assembly 315 of FIG. 113. FIG. 120 may represent an assemble structure of the earphone rear-housing assembly 315. As shown in FIG. 120, the first primary microphone mesh 315g may be fastened to the inner surface of the bottom wall 315h of the earphone rear housing 315a. With reference to FIG. 120 and FIG. 114, the first primary microphone mesh 315g covers the voice pickup through hole 315c (the voice pickup through hole 315c is not displayed in FIG. 120 due to a position of a sectional surface in FIG. 113). The rear housing support 315d is mounted in the inner cavity of the earphone rear housing 315a, and the rear housing support 315d is spaced apart from the bottom wall 315h and the first primary microphone mesh 315g. Therefore, the rear housing support 315d and the earphone rear housing 315a enclose a wind noise prevention cavity 315k. The wind noise prevention through hole 315b communicates with the wind noise prevention cavity 315k.

As shown in FIG. 120, the second primary microphone mesh 315e is located in the inner cavity of the earphone rear housing 315a, the second primary microphone mesh 315e may be fastened to a side that is of the rear housing support 315d and that is far away from the bottom wall 315h, and the second primary microphone mesh 315e covers the through hole 315j of the rear housing support 315d.

The foregoing describes in detail the structures of the earplug 311, the earplug support assembly 316, the first electrode 312, the earphone front-housing assembly 313, the second electrode 314, and the earphone rear-housing assembly 315 in the first earphone 31. The following describes an overall assembly structure including the components.

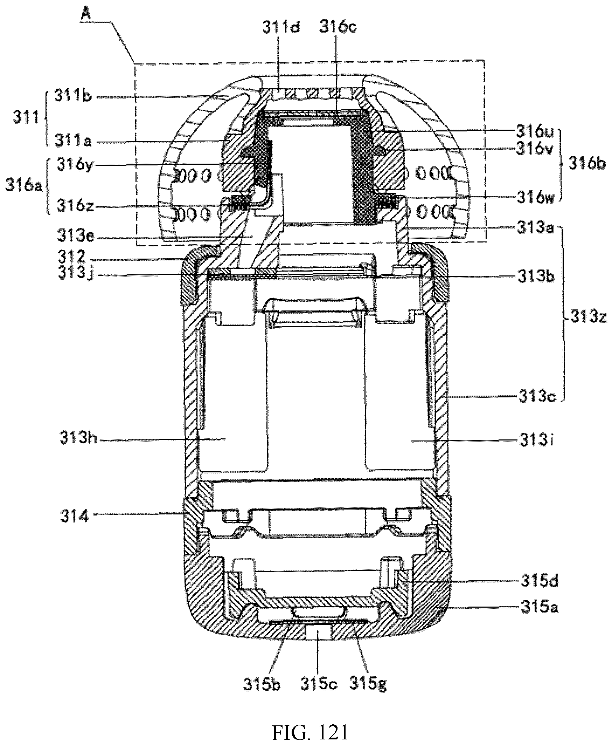

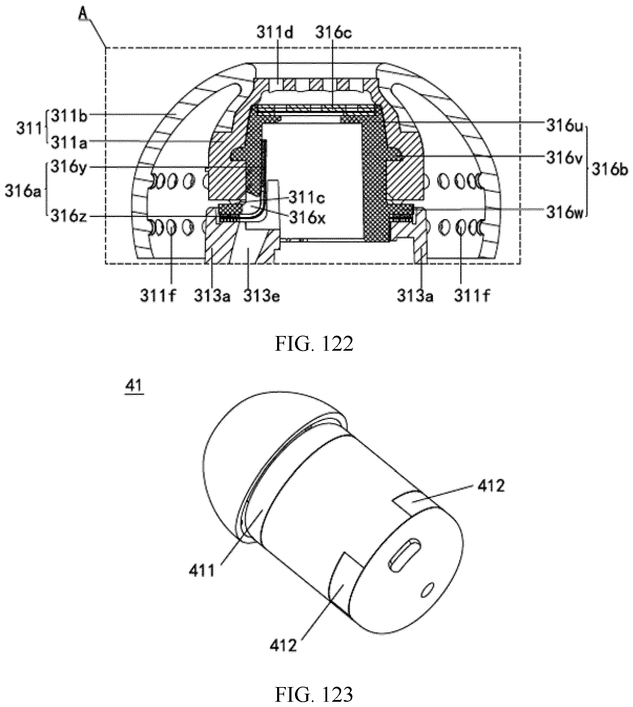

FIG. 121 is a schematic diagram of a sectional structure of the first earphone 31. Some structures are not displayed due to a position selection of a sectional section. FIG. 122 is a partially enlarged view at a position A in FIG. 121.

As shown in FIG. 121, the first electrode 312 may match with the second part 313b of the earphone front housing 313z. With reference to FIG. 102 and FIG. 87, the conduction portion 312b of the first electrode 312 may pass through the through hole 313d on the second part 313b, and extend into the inner cavity of the earphone front housing 313z.

As shown in FIG. 121 and FIG. 122, the earplug support 316b may match with the first part 313a of the earphone front housing 313z. With reference to FIG. 122 and FIG. 90, the second skirt 316w of the earplug support 316b may be bonded to the mounting groove 313f of the first part 313a through the fastening region 316z of the front vent acoustic mesh 316a. The support body 316u of the earplug support 316b may extend into the inner cavity of the earphone front housing 313z. In addition, as shown in FIG. 122, the front vent 316x on the earplug support 316b may be close to the voice pickup channel 313e on the earphone front housing 313z, and the blocking region 316y of the front vent acoustic mesh 316a is located between the front vent 316x and the voice pickup channel 313e.

As shown in FIG. 122, the earplug inner cover 311a may be sleeved on a periphery of the earplug support 316b. With reference to FIG. 109 and FIG. 122, the slot 311g of the earplug inner cover 311a may match the first skirt edge 316v of the earplug support 316b, and there may be a specific spacing between the end that is of the earplug inner cover 311a and on which the voice-emitting through holes 311d are provided and the speaker mesh 316c on the earplug support 316b. The second bumps 311c on the earplug inner cover 311a may be in contact with the second skirt 316w of the earplug support 316b, so that there is a gap between the earplug inner cover 311a and the second skirt 316w, to prevent the earplug inner cover 311a from blocking the front vent 316x near the second skirt 316w. It may be understood that the second bumps 311c may be staggered with the front vent 316x, to prevent the second bumps 311c from blocking the front vent 316x.

As shown in FIG. 122, the earplug outer cover 311b surrounds a periphery of the earplug inner cover 311a, a lower end of the earplug outer cover 311b may surround a periphery of the first part 313a of the earphone front housing 313z, and first bumps 311f on the inner wall of the earplug outer cover 311b may also surround the periphery of the first part 313a. Designing the first bumps 311f may increase structural strength of the earplug outer cover 311b, so that when the first earphone 31 is worn by the user, shaking or vibration of the earplug outer cover 311b is reduced, thereby reducing a "stethoscope effect".

As shown in FIG. 121, the second electrode 314 is connected to the third part 313c of the earphone front housing 313z and the earphone rear housing 315a.

In this embodiment, the earplug support assembly 316, the earphone front-housing assembly 313, the second electrode 314, and the earphone rear-housing assembly 315 may enclose the inner cavity of the first earphone 31, and the electronic assembly 317 is accommodated in the inner cavity.

In this embodiment, after the first earphone 31 is placed in position in the third accommodation groove 231f, the first electrode 312 may be in contact with the first charging spring 231e in the third accommodation groove 231f, and the second electrode 314 may be in contact with the second charging spring 231c, so that the host 2 charges the first earphone 31. Because the first electrode 312 and the second electrode 314 each are of a 360-degree closed ring structure, when the first earphone 31 is placed in the third accommodation groove 231f at any angle, the first electrode 312 may always be in contact with the first charging spring 231e, and the second electrode 314 may always be in contact with the second charging spring 231c, to ensure that the host 2 charges the first earphone 31. Such a structure of the first electrode 312 and the second electrode 314 enables the user to place the first earphone 31 in the third accommodation groove 231f at will. This improves user experience.

It is easy to understand that, in another embodiment, one of the first electrode and the second electrode has a 360-degree closed ring structure, and the other electrode is not 360-degree closed, but forms an open ring structure. In this way, it can also be ensured that, on a premise that the first earphone can be charged, the first earphone is randomly placed within a specific angle range.

For example, for the first earphone 41 shown in FIG. 123, the first electrode 411 still has a 360-degree closed ring structure, but there are two or more second electrodes 412, the second electrodes 412 are spaced from each other, and the second electrodes 412 may be distributed on a same circle. Each second electrode 412 may be an open ring structure. Alternatively, in another embodiment, there is a single second electrode 412, and the second electrode 412 is an open ring structure with a notch. For example, a surrounding angle of the second electrode 412 may be 120 degrees, 180 degrees, 270 degrees, or the like (but less than 360 degrees).

Alternatively, in another embodiment, neither the first electrode nor the second electrode is 360-degree closed, and the first electrode and the second electrode each are a single open ring structure with a notch. Alternatively, one of the first electrode and the second electrode is a single open ring structure with a notch, and a quantity of the other electrode is at least two, where the at least two electrodes are spaced from each other and distributed on a same circle. Alternatively, there are at least two first electrodes and two second electrodes, and the first electrodes and the second electrodes are spaced from each other and distributed on a same circle. The design may also ensure that, on the premise that the first earphone can be charged, the first earphone can be randomly placed within a specific angle range.

In this embodiment, the first electrode 312 is electrically connected to the first charging spring 231e, or the second electrode 314 is electrically connected to the second charging spring 231c, and the first electrode 312 or the second electrode 314 may be further configured to implement communication between the first earphone 31 and the host 2. In other words, the first electrode 312 or the second electrode 314 may be further multiplexed as a communication electrode of the first earphone 31, to implement communication between the first earphone 31 and the host 2.

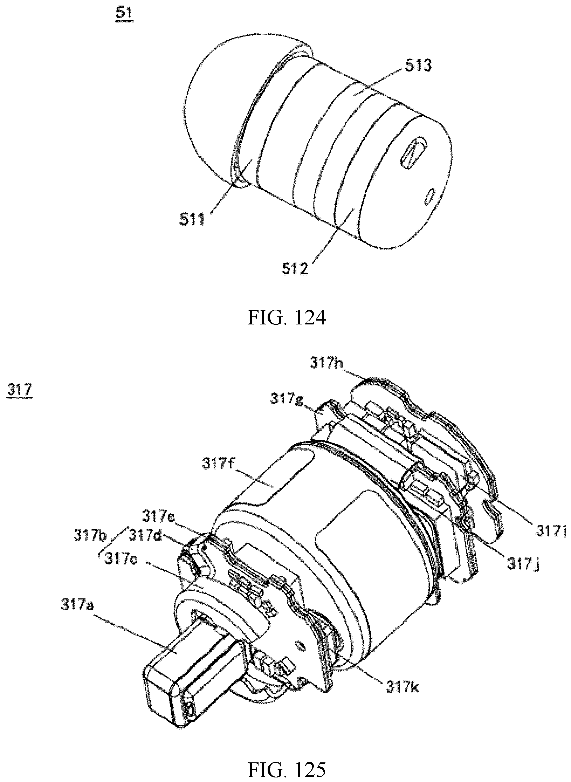

Different from this embodiment, in another embodiment, as shown in FIG. 124, the first earphone 51 may have a first electrode 512 and a second electrode 512, and the first electrode 512 and the second electrode 512 are dedicated to implementing charging of the first earphone 51 by the host. In addition, the first earphone 51 further has a communication electrode 513, and the communication electrode 513 is dedicated to communication with the host. It may be understood that the first electrode 512, the second electrode 512, and the communication electrode 513 shown in FIG. 124 each are of a 360-degree closed ring structure, and this is merely an example. Actually, structures, quantities, and distribution of first electrodes 512, second electrodes 512, and communication electrodes 513 may all be designed based on a product requirement.

### Electronic assembly 317

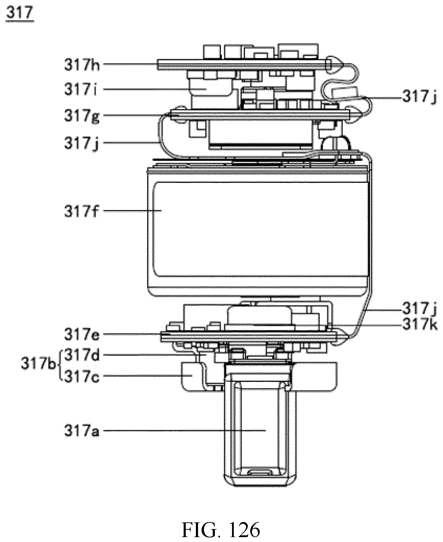

FIG. 125 and FIG. 126 each show a schematic structure of the electronic assembly 317 according to this embodiment. It may be understood that a structure of the electronic assembly 317 to be described below is merely an example, and is not intended to limit embodiments of this application.

As shown in FIG. 125 and FIG. 126, the electronic assembly 317 may include the first earphone circuit board assembly 317e, the second earphone circuit board assembly 317g, the third earphone circuit board assembly 317h, a flexible circuit board 317j, a speaker 317a, a wearing detection plate 317b, a secondary microphone 317k, an earphone battery 317f, and a primary microphone 317i.

### First earphone circuit board assembly 317e, second earphone circuit board assembly 317g, and third earphone circuit board assembly 317h

The first earphone circuit board assembly 317e, the second earphone circuit board assembly 317g, and the third earphone circuit board assembly 317h are sequentially stacked and spaced from each other, and the three may be electrically connected through the flexible circuit board 317j. The first earphone circuit board assembly 317e, the second earphone circuit board assembly 317g, and the third earphone circuit board assembly 317h each may include a circuit board and a circuit and a component disposed on the circuit board.

For example, a wearing detection sensor may be disposed on the circuit board of the first earphone circuit board assembly 317e, and the wearing detection sensor is configured to implement wearing detection of the first earphone 31. The wearing detection sensor may include, for example, at least one of a gravity sensor (gravity sensor, G-sensor), an inertial measurement unit (inertial measurement unit, IMU) sensor, a bone conduction sensor, an infrared (infrared radiation, IR) sensor, a voice accelerometer (voice accelerometer, VACC), a voice pickup unit (voice pickup unit, VPU), and the like. A magnetic field sensor may be further disposed on the circuit board of the first earphone circuit board assembly 317e, and the magnetic field sensor is configured to detect a variation of a magnetic flux of a host magnet, to implement box-in and box-out detection of the first earphone 31 (a principle of box-in and box-out detection is further described below). The magnetic field sensor is, for example, a Hall effect sensor or a magnetometer. For example, there may be two magnetic field sensors. For example, a charging circuit and a discharging circuit may be disposed on the circuit board of the second earphone circuit board assembly 317g. For example, a radio frequency circuit may be disposed on the circuit board of the third earphone circuit board assembly 317h.

### Speaker 317a

As shown in FIG. 126, the speaker 317a may be electrically connected to the circuit board of the first earphone circuit board assembly 317e. The speaker 317a may be located on a side that is of the first earphone circuit board assembly 317e and that is far away from the second earphone circuit board assembly 317g.

### Wearing detection plate 317b

As shown in FIG. 125 and FIG. 126, the wearing detection plate 317b may include a plate 317c and a connection pin 317d that are connected, and the connection pin 317d is led out from the plate 317c, and may be electrically connected (for example, soldered) to the circuit board of the first earphone circuit board assembly 317e. The plate 317c may be located on a same side of the first earphone circuit board assembly 317e as the speaker 317a. The wearing detection plate 317b can conduct electricity, for example, may be made of a metal material. When the wearing detection plate 317b is close to the human body, a coupling capacitance can be generated. When a distance between the wearing detection plate 317b and the human body changes, a coupling capacitance value changes. Wearing detection of the first earphone 31 may be implemented through detecting and processing of the coupling capacitance value of the wearing detection plate 317b.

### Secondary microphone 317k

As shown in FIG. 125 and FIG. 126, the secondary microphone 317k is located on a side that is of the first earphone circuit board assembly 317e and that is far away from the speaker 317a, and may be electrically connected to the circuit board of the first earphone circuit board assembly 317e. The secondary microphone 317k may be disposed on the circuit board of the first earphone circuit board assembly 317e. A through hole may be provided at a part, corresponding to the secondary microphone 317k, on the circuit board of the first earphone circuit board assembly 317e, and a voice may be picked up by the secondary microphone 317k through the through hole. The secondary microphone 317k is configured to implement noise reduction, and may be further configured to perform wearing detection.

### Earphone battery 317f

As shown in FIG. 125 and FIG. 126, the earphone battery 317f may be located between the first earphone circuit board assembly 317e and the second earphone circuit board assembly 317g. An electrode pin of the earphone battery 317f may be electrically connected to the circuit board of the first earphone circuit board assembly 317e.

### Primary microphone 317i

As shown in FIG. 125 and FIG. 126, the primary microphone 317i may be located between the second earphone circuit board assembly 317g and the third earphone circuit board assembly 317h, and may be electrically connected to the circuit board of the third earphone circuit board assembly 317h. The primary microphone 317i may be disposed on the circuit board of the third earphone circuit board assembly 317h. A through hole may be provided at a part, corresponding to the primary microphone 317i, on the circuit board of the third earphone circuit board assembly 317h, and a human voice may be picked up by the primary microphone 317i through the through hole.

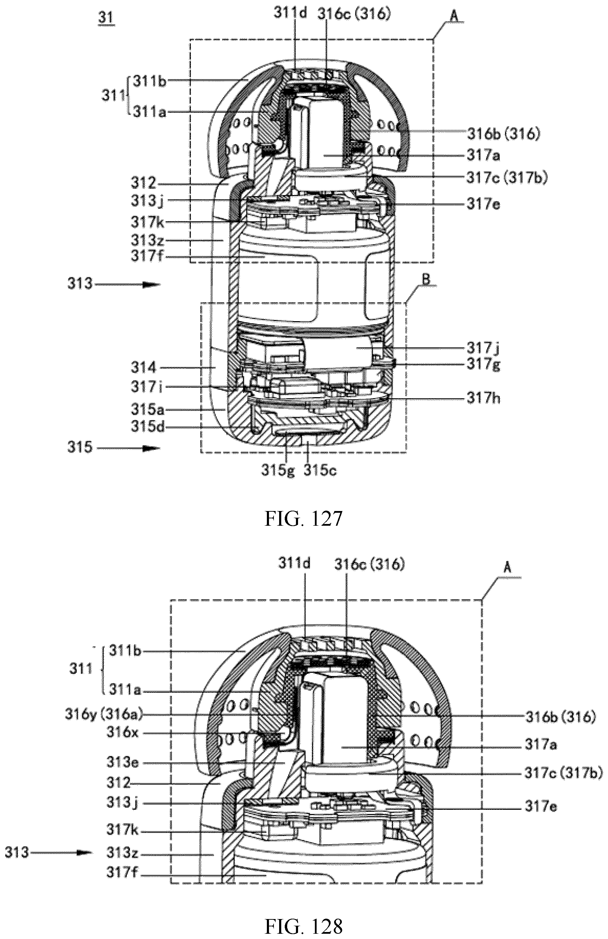

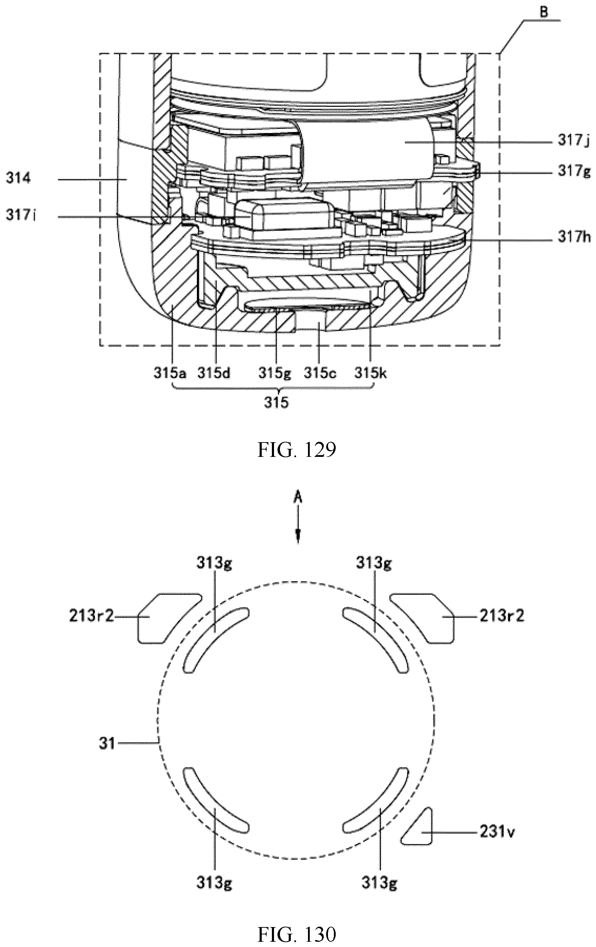

FIG. 127 shows an assembly structure including the electronic assembly 317 and another component of the first earphone 31. FIG. 128 is a partially enlarged view at a position A in FIG. 127, and FIG. 129 is a partially enlarged view at a position B in FIG. 127.

As shown in FIG. 127, the electronic assembly 317 may be accommodated in an inner cavity enclosed by the earplug support assembly 316, the earphone front-housing assembly 313, the second electrode 314, and the earphone rear-housing assembly 315.

As shown in FIG. 128, at least a part of the speaker 317a may be located in an inner cavity of the earplug support 316b. A sound wave emitted by the speaker 317a may be transmitted through the speaker mesh 316c and the voice-emitting through hole 311d, and enter the ear canal. Because of the front vent 316x, atmospheric pressure in the inner cavity of the earplug support 316b is balanced with external atmospheric pressure, to ensure that the speaker 317a can normally work. In addition, the front vent 316x can also improve a noise reduction depth of the secondary microphone 317k.

As shown in FIG. 128, for example, the plate 317c of the wearing detection plate 317b may be fixedly connected (for example, soldered) to an end that is of the earplug support 316b and that is far away from the speaker mesh 316c, and the wearing detection plate 317b and the earplug support 316b may be connected to form a conductor having a large area. Therefore, both the wearing detection plate 317b and the earplug support 316b may generate coupling capacitances, so that the wearing detection plate 317b and the earplug support 316b may be used for wearing detection. In other words, in addition to providing support and accommodating functions, the earplug support 316b may be further reused as a detection plate for wearing detection.

It may be understood that, based on a product requirement, the assembly structure including the wearing detection plate and the earplug support may alternatively be in another form, and is not limited to the foregoing descriptions. For example, if only a part of the earplug support is made of a conductive material, the wearing detection plate may be fixedly connected to the part of the earplug support, and the assembly structure including the wearing detection plate and the earplug support may be designed based on respective structures of the wearing detection plate and the earplug support and an inner space of the first earphone.

In this embodiment, the wearing detection plate 317b and the earplug support 316b are jointly used as a detection plate for wearing detection, so that an area of the detection plate can be increased, and consistency and reliability of wearing detection can be ensured. Because the earplug support 316b is closer to the inside of the ear canal than the wearing detection plate 317b, capacitance detection data of the earplug support 316b is more accurate and reliable. This helps improve overall reliability of wearing detection. In addition, when the earplug support 316b is reused as a detection plate for wearing detection, an overall size of the first earphone 31 is not affected, and a stacking space inside the first earphone 31 can be further reduced.

In addition, if the earplug support 316b is made of a material with high strength like metal, a wall thickness and an overall structural size of the earplug support 316b may be small on a premise that structural strength of the earplug support 316b meets a requirement. This can enable the earplug outer cover 311b to have an adequate compression deformation space, thereby helping ensure wearing comfort of the user.

In this embodiment, for example, the wearing detection sensor, the wearing detection plate 317b, and the earplug support 316b may be jointly used to implement wearing detection. This design can greatly improve consistency and reliability of wearing detection, and reduce a probability of false detection.

Based on a product requirement, in another embodiment, any one or any two of the wearing detection sensor, the wearing detection plate 317b, and the earplug support 316b may alternatively be used to implement wearing detection.

As shown in FIG. 128, the first earphone circuit board assembly 317e may be located in the earphone front housing 313z. With reference to FIG. 102, FIG. 87, FIG. 88, and FIG. 128, the conduction portion 312b of the first electrode 312 may pass through the through hole 313d of the earphone front housing 313z, and is electrically connected (for example, soldered) to the circuit board of the first earphone circuit board assembly 317e, so that the first electrode 312 serves as a charging electrode.

As shown in FIG. 128, one side of the circuit board of the first earphone circuit board assembly 317e may be attached to the noise reduction microphone mesh 313j. The secondary microphone 317k is located on the other side of the circuit board, and the secondary microphone 317k may correspond to the noise reduction microphone mesh 313j. Noise in the ear canal may sequentially pass through the speaker mesh 316c, the voice pickup channel 313e, the noise reduction microphone mesh 313j, and the through hole that is on the circuit board of the first earphone circuit board assembly 317e and that corresponds to the secondary microphone 317k, and be picked up by the secondary microphone 317k. The speaker 317a may generate a phase-inverted signal whose phase is opposite to a phase of the noise signal, and the phase-inverted signal may cancel the noise signal. In this way, the first earphone 31 can implement active noise reduction.

When the first earphone 31 works, a voice of the speaker 317a and the noise in the ear canal may pass through the front vent acoustic mesh 316a, and leak to the outside through the front vent 316x. In this way, pressure inside and outside the ear canal can be balanced, to improve wearing comfort of the user. The front vent acoustic mesh 316a that blocks the front vent 316x may alternatively be removed. In this case, the front vent 316x may be made smaller. For example, a diameter of the front vent 316x is less than 0.22 mm.

In addition, the secondary microphone 317k may also be used for wearing detection, and a principle is that the speaker 317a may send a sound wave signal of a specific frequency. If the first earphone 31 is not worn by the user, a large quantity of sound wave signals may be leaked to the outside through the front vent 316x, and signal strength of the sound wave signals picked up by the secondary microphone 317k is low. If the first earphone 31 is worn by the user, because the front vent 316x is blocked to an extent or completely, the secondary microphone 317k can pick up more sound wave signals, and signal strength of the sound wave signals picked up by the secondary microphone 317k is high. Therefore, whether the first earphone 31 is worn by the user may be determined through detection on signal strength of a signal picked up by the secondary microphone 317k.

As shown in FIG. 129, the second earphone circuit board assembly 317g may be located on an inner side of the second electrode 314. With reference to FIG. 111 and FIG. 129, the conduction portion 314c of the second electrode 314 may be electrically connected (for example, soldered) to the circuit board of the second earphone circuit board assembly 317g, so that the second electrode 314 serves as a charging electrode.

As shown in FIG. 129, the third earphone circuit board assembly 317h may be carried on the rear housing support 315d. With reference to FIG. 129 and FIG. 120, a side that is of the third earphone circuit board assembly 317h and that is far away from the primary microphone 317i may be attached to the second primary microphone mesh 315e. The primary microphone 317i may correspond to the second primary microphone mesh 315e. A voice emitted by the user may sequentially pass through the voice pickup through hole 315c, the first primary microphone mesh 315g, the through hole 315j on the rear housing support 315d, the second primary microphone mesh 315e, and the through hole that is on the circuit board of the third earphone circuit board assembly 317h and that corresponds to the primary microphone 317i, and be picked up by the primary microphone 317i.

With reference to FIG. 129 and FIG. 120, after entering a wind noise prevention cavity 315k from one wind noise prevention through hole 315b, an external airflow may flow out of the wind noise prevention cavity 315k from another wind noise prevention through hole 315b. In this way, wind noise caused by the external airflow can be reduced or prevented from being picked up by the primary microphone 317i.

With reference to FIG. 116 and FIG. 129, the head end 315z1 and the head end 315y1 of the antenna 315f each are connected to, for example, soldered, a feeding point on the circuit board of the third earphone circuit board assembly 317h. The two feeding points may be symmetrical with respect to the center line of the first earphone 31. In this way, the antenna 315f can radiate and receive signals.

### Features and functions of the wearable device 1

In this embodiment, because the wearable device 1 includes the host 2 and the earphone, the wearable device 1 may have the following features and functions. For some features or functions that the host 2 and the earphone both have, because the first earphone (for example, the first earphone 31, the first earphone 41, and the first earphone 51) is completely the same as the second earphone, for brevity, the first earphone 31 is mainly used as an example for description.

### 1. When the host 2 is opened, the first earphone 31 is attached to the first part 21 of the host 2.

With reference to FIG. 1 and FIG. 4, in this embodiment, when the host 2 is in the closed state, the first earphone 31 is accommodated in a space enclosed by the first accommodation groove 213y of the first part 21 and the third accommodation groove 231f of the second part 23.

FIG. 130 shows, from a side-view perspective, a position relationship between the first host attachment magnet 213r2 in the first part 21, the second host attachment magnet 231v in the second part 23, and the earphone magnet 313g in the first earphone 31 when the host 2 is in the closed state. As shown in FIG. 130, the first host attachment magnet 213r2 and the second host attachment magnet 231v each are magnetically attached to the earphone magnet 313g.

In this embodiment, a magnetic field of the first host attachment magnet 213r2 is strong, and a magnetic attraction force between the first host attachment magnet 213r2 and the earphone magnet 313g is large; and a magnetic field of the second host attachment magnet 231v is weak, and a magnetic attraction force between the second host attachment magnet 231v and the earphone magnet 313g is small. As shown in FIG. 1 to FIG. 4, when the host 2 is gradually opened from the closed state, because the magnetic attraction force of the first host attachment magnet 213r2 is greater than the magnetic attraction force of the second host attachment magnet 231v, the first earphone 31 is attached to the first part 21, and rotates with the first part 21 relative to the second part 23.

In this embodiment, an appropriate magnet design may be performed, to enable a strong magnetic attraction force between the first host attachment magnet 213r2 and the earphone magnet 313g.

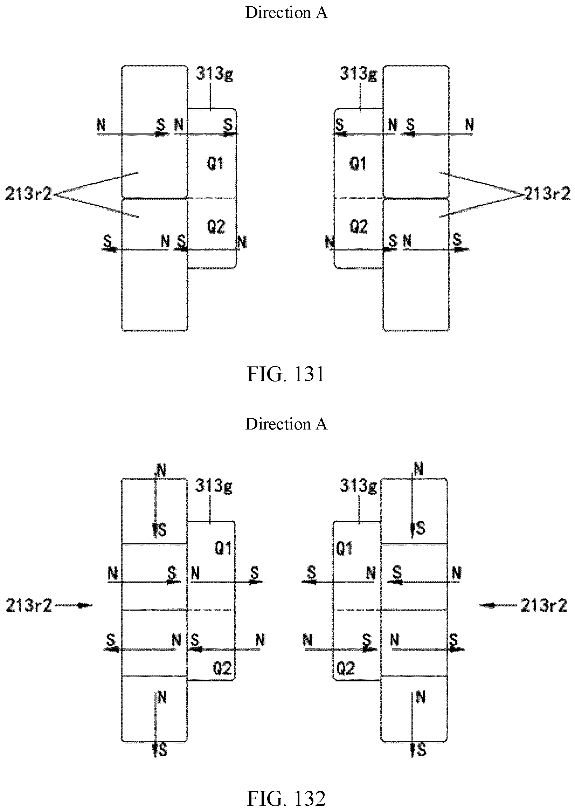

As shown in FIG. 131, in the implementation 1 of this embodiment, each first host attachment magnet 213r2 is a Halbach array formed by splicing two single magnets, and magnetic field directions (represented by using arrows pointing from N to S) of the two single magnets are different, so that each first host attachment magnet 213r2 has two magnetic field directions. With reference to FIG. 131 and FIG. 130, schematically, in each first host attachment magnet 213r2, a magnetic field direction of one single magnet (for example, a single magnet in an upper part in FIG. 131) roughly points from a radial outer side of the first earphone 31 to a radial inner side, and a magnetic field direction of the other single magnet (for example, a single magnet in a lower part in FIG. 131) roughly points from the radial inner side of the first earphone 31 to the radial outer side.

As shown in FIG. 131, each earphone magnet 313g may be a Halbach array formed by a single magnet, and different parts of each earphone magnet 313g may have different magnetic field directions. With reference to FIG. 131 and FIG. 130, schematically, a magnetic field direction of a part Q1 of each earphone magnet 313g roughly points from the radial outer side of the first earphone 31 to the radial inner side, and a magnetic field direction of the other part Q2 roughly points from the radial inner side of the first earphone 31 to the radial outer side. A design in which each earphone magnet 313g is a single magnet can reduce assembly difficulty of the earphone magnet 313g. In another implementation, each earphone magnet 313g may alternatively be formed by splicing several (for example, two) single magnets.

The design of the first host attachment magnet 213r2 and the earphone magnet 313g enables the first host attachment magnet 213r2 and the earphone magnet 313g to be magnetically attached. In addition, through product verification, this design enables a large magnetic attraction force between the first host attachment magnet 213r2 and the earphone magnet 313g.

Different from that in the implementation 1, as shown in FIG. 132, in the implementation 2 of this embodiment, each first host attachment magnet 213r2 is a Halbach array having four magnetic field directions. Each first host attachment magnet 213r2 may be formed by splicing four single magnets, or may be a single magnet having four magnetic field directions. The magnet design in the implementation 2 can meet a design requirement that the first earphone 31 is magnetically attached to the first part 21.

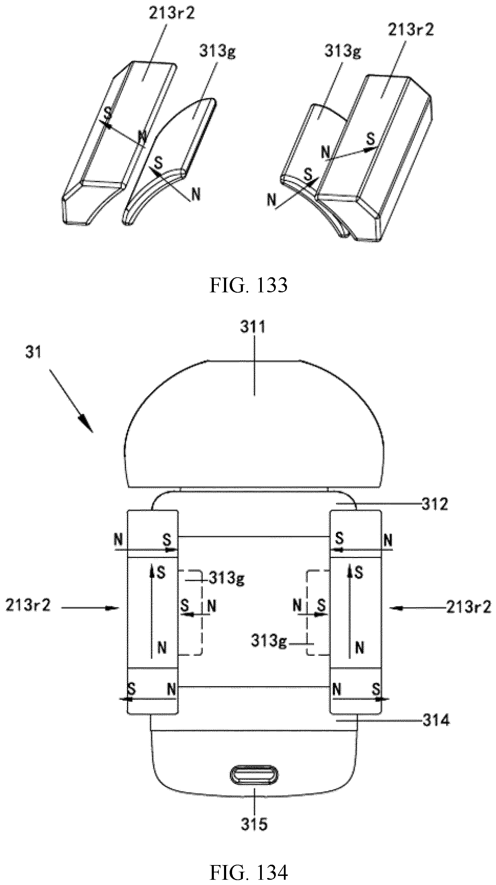

Different from that in the implementation 1, as shown in FIG. 133, in the implementation 3 of this embodiment, each first host attachment magnet 213r2 is a single magnet having a single magnetic field direction. For example, the magnetic field direction of each first host attachment magnet 213r2 may roughly point from the radial inner side of the first earphone 31 to the radial outer side. Each earphone magnet 313g is a single magnet having a single magnetic field direction. For example, the magnetic field direction of each earphone magnet 313g may roughly point from the radial inner side of the first earphone 31 to the radial outer side. The magnet design in the implementation 3 can meet a design requirement that the first earphone 31 is magnetically attached to the first part 21.

Different from that in the implementation 1, as shown in FIG. 134, in an implementation 4 of this embodiment, each first host attachment magnet 213r2 is a Halbach array having three magnetic field directions. Each first host attachment magnet 213r2 may be formed by splicing three single magnets, or may be a single magnet having three magnetic field directions. Each earphone magnet 313g may have a single magnetic field direction. In addition, the first electrode 312 and the second electrode 314 may be made of a material that can be magnetically attached by the first host attachment magnet 213r2, for example, a magnetic conductive material (for example, steel plate cold common (steel plate cold common, SPCC) or SUS430). Both the first electrode 312 and the second electrode 314 may be magnetically attached to the first host attachment magnet 213r2. The magnet design in the implementation 4 can not only meet a design requirement that the first earphone 31 is magnetically attached to the first part 21, but also has a simple design structure, is easy to be manufactured, and has low costs.

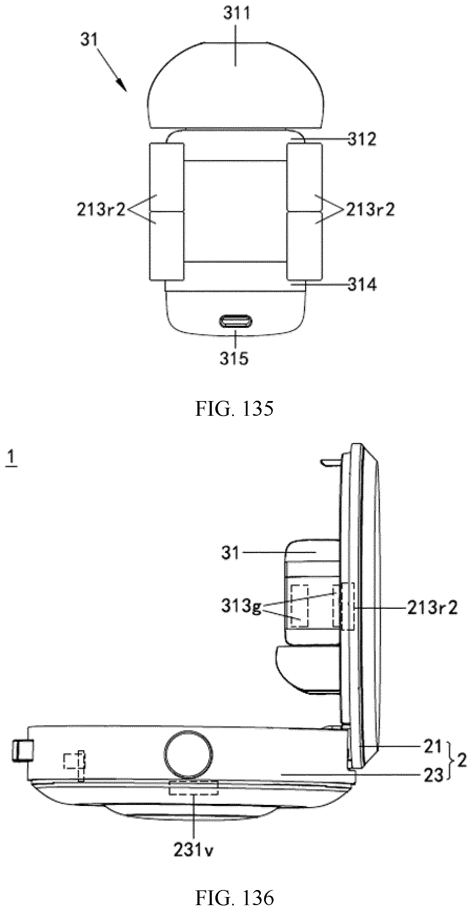

Alternatively, different from that in the implementations, in an implementation 5, the first earphone 31 may not need to have a built-in earphone magnet. The first electrode 312 and the second electrode 314 may be made of a material that can be magnetically attached by the first host attachment magnet 213r2, for example, a magnetic conductive material (for example, SPCC or SUS430). As shown in FIG. 135, both the first electrode 312 and the second electrode 314 may be magnetically attached to the first host attachment magnet 213r2. In the implementation 5, the first host attachment magnet 213r2 may be flexibly designed based on a requirement, and may have a single magnetic field direction or several magnetic field directions. The magnet design in the implementation 5 can not only meet a design requirement that the first earphone 31 is magnetically attached to the first part 21, but also has a simple design structure, is easy to be manufactured, and has low costs.

In this embodiment, as shown in FIG. 136, because the radial size of the first earphone 31 may be at least twice the groove depth of the first accommodation groove 213y, a majority of the first earphone 31 is exposed outside the first accommodation groove 213y. This design is convenient for the user to directly take the first earphone 31 from the first part 21 after the host 2 is opened.

In the foregoing implementations, the magnet design of the first host attachment magnet 213r2 and the earphone magnet 313g is described. Actually, a magnet design may also be performed on the second host attachment magnet 231v and the earphone magnet 313g with reference to the foregoing principle, provided that magnetic field strength of the second host attachment magnet 231v is less than magnetic field strength of the first host attachment magnet 213r2.

It may be understood from the foregoing descriptions that, based on a product requirement, in another embodiment, magnetic field strength of the first host attachment magnet 213r2 may alternatively be less than magnetic field strength of the second host attachment magnet 231v, so that after the host 2 is opened, the first earphone 31 is not sucked up by the first part 21, but is still accommodated in the second part 23. Alternatively, no first accommodation groove is provided on the first part of the host, and the first earphone may be attached to the first part after the host is opened.

### 2. When the first earphone 31 is placed on the first part 21, the first earphone 31 may be automatically placed in position.

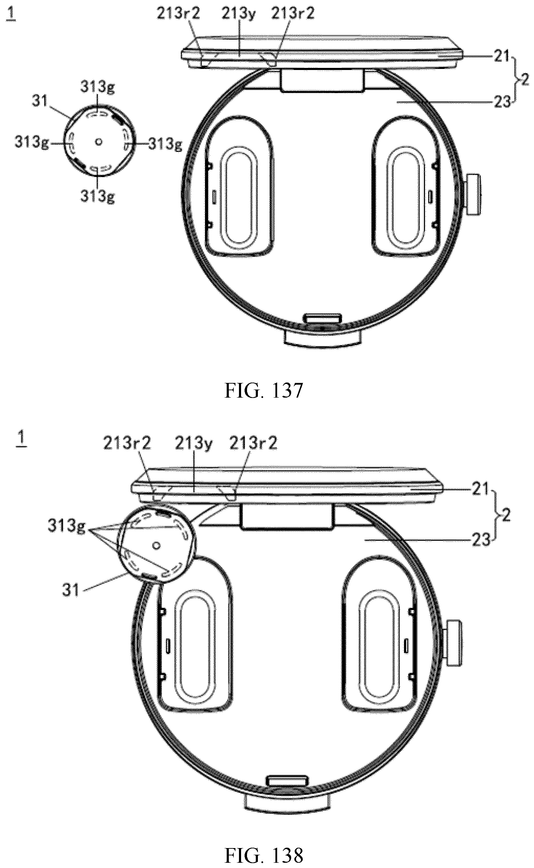

As shown in FIG. 137, FIG. 138, and FIG. 139, after the host 2 is opened and the first earphone 31 is taken out from the host 2, the user may pick up the first earphone 31 and enable the first earphone 31 to be in a posture roughly matching the first accommodation groove 213y (to be specific, the earplug 311 of the first earphone 31 roughly faces an end that is of the first accommodation groove 213y and that is used to accommodate the earplug 311, the earphone rear-housing assembly 315 of the first earphone 31 roughly faces an end that is of the first accommodation groove 213y and that is used to accommodate the earphone rear-housing assembly 315, and the first earphone 31 may rotate around the center line of the first accommodation groove 213y at any angle), and then put the first earphone 31 close to the first accommodation groove 213y. Under an effect of the magnetic attraction force of the first host attachment magnet 213r2 in the first part 21 on the earphone magnet 313g in the first earphone 31, the first earphone 31 is corrected to a posture matching the first accommodation groove 213y, and is automatically attached in the first accommodation groove 213y, so that the first earphone 31 can be accurately and appropriately placed in the first accommodation groove 213y.

According to the automatic in-position design in this embodiment, the user can conveniently place the first earphone 31 on the host 2, and the placement can be completed without precise alignment, thereby improving user experience.

### 3. When the first earphone 31 is placed in the second part 23, and the first earphone 31 is not easy to be separated from the second part 23.

If the user places the first earphone 31 in the third accommodation groove 231f of the second part 23, the first earphone 31 is attached in the third accommodation groove 231f under an effect of the magnetic attraction force of the second host attachment magnet 231v in the second part 23 on the earphone magnet 313g in the first earphone 31. Even if the host 2 is turned over, the first earphone 31 is not detached from the third accommodation groove 23 1f.

In addition, both the second charging spring 231c and the first charging spring 231e in the third accommodation groove 231f may apply specific extrusion pressure to the first earphone 31, and the extrusion pressure can increase friction between the first earphone 31 and the second host housing 231 in the second part 23, so that it is more difficult for the first earphone 31 to be detached from the third accommodation groove 231f.

### 4. The first earphone 31 may be placed in the accommodation groove at a random angle.

In this embodiment, the first earphone 31 can overlap the first earphone 31 each time the first earphone 31 is rotated around the center line of the first earphone 31 by a specific angle. Therefore, the rotated first earphone 31 can always be accurately accommodated in the first accommodation groove 213y or the third accommodation groove 231f, and adapt to the inner wall of the first accommodation groove 213y or the third accommodation groove 231f. This enables the user to place the first earphone 31 into the first accommodation groove 213y or the third accommodation groove 231f without holding the first earphone 31 at a fixed angle.

For example, for the first earphone 31 that is roughly an octahedron, the first earphone 31 can overlap the first earphone 31 each time the first earphone 31 is rotated around the center line of the first earphone 31 by 90°. Even if the user rotates the first earphone 31 by 90°, 180°, 270°, or the like, the first earphone 31 can still adapt to the inner wall of the first accommodation groove 213y or the third accommodation groove 231f. Therefore, the first earphone 31 can be smoothly and accurately placed in the first accommodation groove 213y or the third accommodation groove 231f. In addition, as shown in FIG. 137 to FIG. 139, when the first earphone 31 is placed in the first accommodation groove 213y, because the magnetic force of the first host attachment magnet 213r2 has an angle correction function, even if the user rotates the first earphone 31 randomly (for example, rotates by 10°, 35°, or 55°), the magnetic force of the first host attachment magnet 213r2 can correct an angle of the first earphone 31 to a normal angle. In this way, the first earphone 31 can be smoothly and accurately placed in the first accommodation groove 213y, and adapt to the inner wall of the first accommodation groove 213y.

For example, for the first earphone 31 that is roughly cylindrical, the first earphone 31 can overlap the first earphone 31 after being rotated around the center line of the first earphone 31 by any angle. Therefore, even if the user rotates the first earphone 31 by any angle, the first earphone 31 can still adapt to the inner wall of the first accommodation groove or the third accommodation groove. Therefore, the first earphone 31 can be smoothly and accurately placed in the first accommodation groove or the third accommodation groove.

### 5. Detection of the open/closed state of the host 2

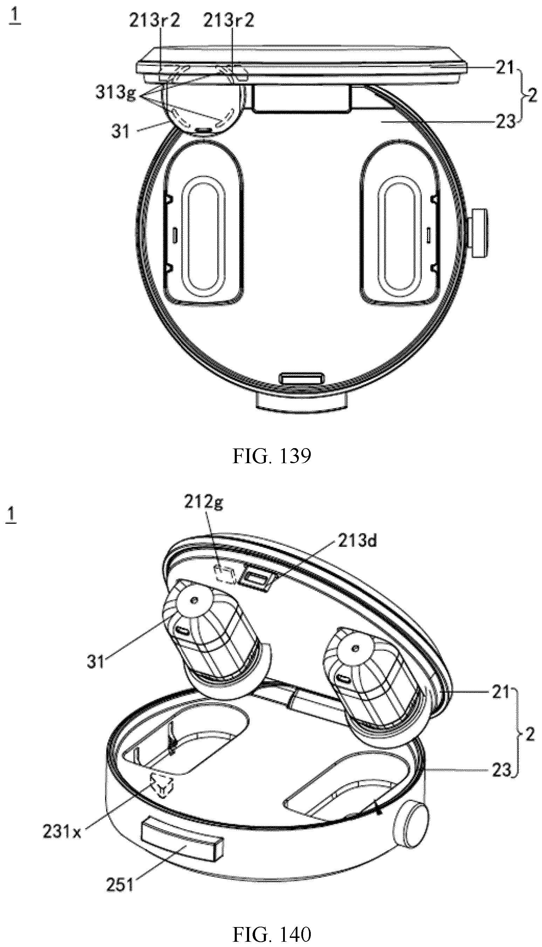

As shown in FIG. 140, the first part 21 of the host 2 has a magnetic field sensor 212g (which may be referred to as a first magnetic field sensor), and the magnetic field sensor 212g may be, for example, disposed on the circuit board 212a in the first part 21. The magnetic field sensor 212g is configured to detect a magnetic flux of the status detection magnet 231x in the second part 23 of the host 2. The magnetic flux of the status detection magnet 231x detected by the magnetic field sensor 212g may be in direct proportion to a spacing between the magnetic field sensor 212g and the status detection magnet 231x. When the host 2 is in the closed state, the magnetic flux detected by the magnetic field sensor 212g is the largest. When the host 2 is completely opened, the magnetic flux detected by the magnetic field sensor 212g is the smallest.

In this embodiment, the magnetic field sensor 212g may be, for example, a Hall effect sensor or a magnetometer. The Hall effect sensor can detect a change of the magnetic flux. When the Hall effect sensor detects that the magnetic flux exceeds a hardware threshold of the Hall effect sensor, the Hall effect sensor can generate a corresponding signal and report the signal to a processor of the host 2. The processor of the host 2 may perform corresponding processing based on the signal of the Hall effect sensor. Different from the Hall effect sensor, the magnetometer can detect a value of the magnetic flux and report the value to the processor of the host 2. The processor of the host 2 may determine whether the magnetic flux detected by the magnetometer exceeds a software threshold built in the processor, and perform corresponding processing based on a determining result. The following uses an example in which the magnetic field sensor 212g is a Hall effect sensor for description.

As shown in FIG. 140, after the user presses the cap 251, the host 2 is gradually opened from the closed state, the spacing between the magnetic field sensor 212g and the status detection magnet 231x gradually increases, and the magnetic flux of the status detection magnet 231x detected by the magnetic field sensor 212g tends to decrease. When the magnetic flux detected by the magnetic field sensor 212g is less than a first threshold, a first signal may be generated. The processor of the host 2 determines, based on the first signal, that the host 2 is in the open state.

On the contrary, when the host 2 is gradually closed from the open state, the spacing between the magnetic field sensor 212g and the status detection magnet 231x gradually decreases, and the magnetic flux of the status detection magnet 231x detected by the magnetic field sensor 212g tends to increase. When the magnetic flux detected by the magnetic field sensor 212g is greater than a second threshold, a second signal may be generated. The processor of the host 2 determines, based on the second signal, that the host 2 is in the closed state.

In this embodiment, when the processor of the host 2 determines that the host 2 is in the open state, the processor controls the display 211 to perform corresponding interface display.

In this embodiment, when it is determined that the host 2 is in the open state and the first earphone 31 is in the third accommodation groove 231f (the following describes how to detect whether the first earphone 31 is located in the third accommodation groove 231f), the communication electrode of the host 2 may send a signal to the communication electrode of the first earphone 31, to wake up the first earphone 31. When it is determined that the host 2 is in the closed state and the first earphone 31 is located in the host 2, the host 2 may start foreign matter detection, and after determining that no foreign matter enters, start charging the first earphone 31. In another embodiment, positions of the magnetic field sensor 212g and the status detection magnet 231x may be exchanged. To be specific, the magnetic field sensor 212g may be in the second part 23, and the status detection magnet 231x may be in the first part 21.

### 6. Detection of an in-box/out-box state of the first earphone 31

The in-box/out-box state of the first earphone 31 is a relative position relationship between the first earphone 31 and the first accommodation groove 213y and a relative position relationship between the first earphone 31 and the third accommodation groove 231f, and includes: The first earphone 31 is in the first accommodation groove 213y and in the third accommodation groove 231f (the host 2 is closed and the first earphone 31 is in the host 2); the first earphone 31 is located in the first accommodation groove 213y and outside the third accommodation groove 231f (the host 2 is opened and the first earphone 31 is attached to the first part 21); or the first earphone 31 is located in the third accommodation groove 231f and outside the first accommodation groove 213y (the host 2 is opened and the first earphone 31 is attached to the second part 23).

In this embodiment, both the host 2 and the first earphone 31 may detect the in-box/out-box state of the first earphone 31. Descriptions are sequentially provided below.

### (1) The host 2 detects the in-box/out-box state of the first earphone 31.

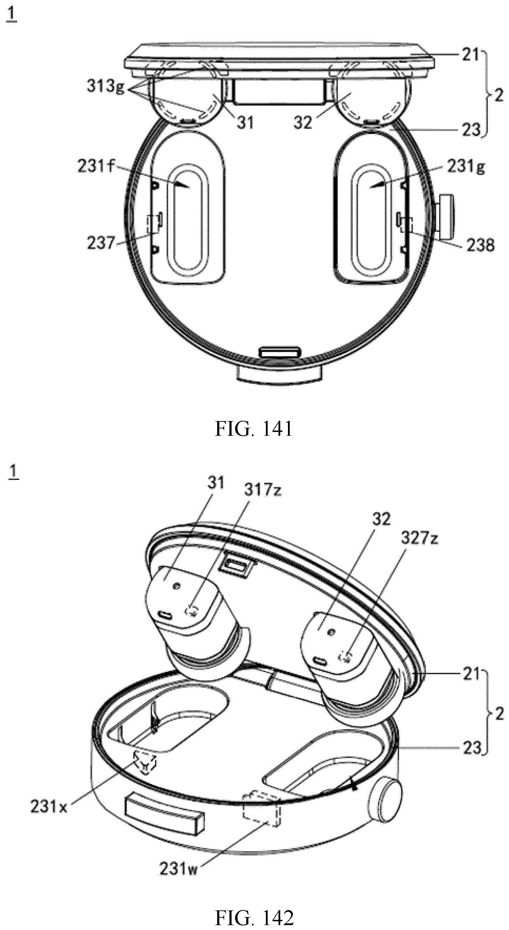

As shown in FIG. 141, the second part 23 of the host 2 has a magnetic field sensor 237 and a magnetic field sensor 238 (both may be referred to as second magnetic field sensors, as shown in dashed boxes). The magnetic field sensor 237 may be close to an outer surface of the groove wall of the third accommodation groove 231f, and the magnetic field sensor 238 may be close to an outer surface of the groove wall of the fourth accommodation groove 231g. The magnetic field sensor 237 and the magnetic field sensor 238 each may be, for example, a single-axis Hall effect sensor or a magnetometer. The following uses an example in which the magnetic field sensor 237 and the magnetic field sensor 238 each are a Hall effect sensor for description.

The magnetic field sensor 237 is configured to detect a change of a magnetic flux of the earphone magnet 313g in the first earphone 31. The magnetic flux of the earphone magnet 313g detected by the magnetic field sensor 237 may be in direct proportion to a distance between the magnetic field sensor 237 and the earphone magnet 313g. When the first earphone 31 is located in the third accommodation groove 231f (which may be that the host 2 is closed and the first earphone 31 is in the host 2, or the host 2 is opened and the first earphone 31 is attached to the second part 23), the magnetic flux detected by the magnetic field sensor 237 is large. When the first earphone 31 leaves the third accommodation groove 231f and is attached to the first part 21, the magnetic flux detected by the magnetic field sensor 237 is small.

In this embodiment, when the magnetic flux detected by the magnetic field sensor 237 is greater than or equal to a third threshold, a third signal may be generated. The processor of the host 2 determines, based on the third signal, that the first earphone 31 is located in the third accommodation groove 231f.

In this embodiment, the processor of the host 2 may determine the in-box/out-box state of the first earphone 31 by combining the third signal sent by the magnetic field sensor 237 and the first signal or the second signal sent by the magnetic field sensor 212g. For example, when the processor receives the third signal and the first signal, the processor determines that the host 2 is opened and the first earphone 31 is attached to the second part 23. When the processor receives the third signal and the second signal, the processor determines that the host 2 is closed and the first earphone 31 is in the host 2.

When the magnetic flux detected by the magnetic field sensor 237 is less than the third threshold but is greater than or equal to a fourth threshold, a fourth signal may be generated. The processor of the host 2 determines, based on the fourth signal, that the first earphone 31 leaves the third accommodation groove 231f and is attached to the first part 21 (as shown in FIG. 141).

Similarly, the magnetic field sensor 238 is configured to detect a change of a magnetic flux of the earphone magnet in the second earphone 32. As described above, the host 2 may determine an in-box/out-box state of the second earphone 32 by using a signal sent by the magnetic field sensor 238 or by combining signals sent by the magnetic field sensor 238 and the magnetic field sensor 212g.

In conclusion, it is easily understood that the magnetic field sensor 237 located in the second part 23 is configured to determine whether the first earphone 31 is in the third accommodation groove 231f or outside the third accommodation groove 231f. Similarly, the magnetic field sensor 238 located in the second part 23 is configured to detect whether the second earphone 32 is in the fourth accommodation groove 231g or outside the fourth accommodation groove 231g.

In another embodiment, at least one of the magnetic field sensor 237 and the magnetic field sensor 238 may alternatively be located in the first part 21 of the host 2. For example, the magnetic field sensor 237 may be located in the first part 21 (for example, close to the outer surface of the groove wall of the first accommodation groove 213y). The change of the magnetic flux of the earphone magnet 313g in the first earphone 31 may be detected through the magnetic field sensor 237, to determine whether the first earphone 31 is in the first accommodation groove 213y or outside the first accommodation groove 213y. A specific principle is the same as that described above. Details are not described herein again.

In this embodiment, when the host 2 determines that the first earphone 31 is in the third accommodation groove 231f and the host 2 is in the open state, the communication electrode of the host 2 may send a signal to the communication electrode of the first earphone 31, to wake up the first earphone 31. The host 2 may further charge the first earphone 31 through the first charging spring 231e and the second charging spring 231c. In addition, the host 2 may further start a charging overheat protection mechanism (descriptions are provided below). Based on a product requirement, alternatively, the first earphone 31 may not need to be charged and the charging overheat protection mechanism may not be started.

In this embodiment, when the host 2 determines that the first earphone 31 is in the host 2 and the host 2 is in the closed state, the host 2 may start a foreign matter detection mechanism (descriptions are provided below), and may further charge the first earphone 31 and start the charging overheat protection mechanism. Based on a product requirement, alternatively, the first earphone 31 may not need to be charged and the charging overheat protection mechanism may not be started.

In another embodiment, when the host 2 determines that the first earphone 31 is in the first accommodation groove 213y and the host 2 is in the open state, the first earphone 31 is woken up (a principle is described below).

### (2) The first earphone 31 detects the in-box/out-box state of the first earphone 31.

As shown in FIG. 142, the first earphone 31 may have a magnetic field sensor 317z (which may be referred to as a third magnetic field sensor, as represented by a dashed box), and the magnetic field sensor 317z may be, for example, disposed on the circuit board of the third earphone circuit board assembly 317h. The magnetic field sensor 317z may be, for example, a Hall effect sensor or a magnetometer. The following uses an example in which the magnetic field sensor 317z is a Hall effect sensor for description.

The magnetic field sensor 317z is configured to detect a change of a magnetic flux of the status detection magnet 231x in the second part 23 of the host 2. The magnetic flux of the status detection magnet 231x detected by the magnetic field sensor 317z may be in direct proportion to a spacing between the magnetic field sensor 317z and the status detection magnet 231x. When the first earphone 31 is located in the third accommodation groove 231f (which may be that the host 2 is closed and the first earphone 31 is in the host 2, or the host 2 is opened and the first earphone 31 is attached to the second part 23), the magnetic flux detected by the magnetic field sensor 317z is large. When the first earphone 31 leaves the third accommodation groove 231f and is attached to the first part 21, the magnetic flux detected by the magnetic field sensor 317z is small.

In this embodiment, when the magnetic flux detected by the magnetic field sensor 317z is greater than or equal to a fifth threshold, a sixth signal may be generated. A controller of the first earphone 31 determines, based on the sixth signal, that the first earphone 31 is located in the third accommodation groove 231f.

In this embodiment, the controller (which may be a central processing unit or a microcontroller unit (microcontroller unit, MCU)) of the first earphone 31 may determine the in-box/out-box state of the first earphone 31 by combining the sixth signal sent by the magnetic field sensor 317z and the first signal or the second signal (the first signal and the second signal may be transmitted through the communication electrode of the host 2 and the communication electrode of the first earphone 31) sent by the magnetic field sensor 212g. For example, when the controller receives the sixth signal and the first signal, the controller determines that the host 2 is opened and the first earphone 31 is attached to the second part 23. When the controller receives the sixth signal and the second signal, the controller determines that the host 2 is closed and the first earphone 31 is in the host 2.

When the magnetic flux detected by the magnetic field sensor 317z is less than the fifth threshold but is greater than or equal to the sixth threshold, a seventh signal may be generated. The controller of the first earphone 31 determines, based on the seventh signal, that the first earphone 31 leaves the third accommodation groove 231f and is attached to the first part 21.

As shown in FIG. 142, the second earphone 32 may also have a magnetic field sensor 327z (represented by a dashed box), and the magnetic field sensor 327z is configured to detect a change of a magnetic flux of the magnet 231w in the second part 23. The magnetic field sensor 327z may be, for example, a single-axis Hall effect sensor. As described above, the second earphone 32 may determine the in-box/out-box state of the second earphone 32 by using a signal sent by the magnetic field sensor 327z or by combining signals sent by the magnetic field sensor 327z and the magnetic field sensor 212g.

In this embodiment, the first earphone 31 detects the in-box/out-box state of the first earphone 31, so that the first earphone 31 performs a corresponding operation.

If the host 2 is in the closed state, and the first earphone 31 detects that the first earphone 31 is located in the third accommodation groove 231f, the first earphone 31 may be in a sleep state.

If the host 2 is in the open state, and the first earphone 31 detects that the first earphone 31 is located in the third accommodation groove 231f, the first earphone 31 may be woken up by the host 2. For example, the communication electrode of the host 2 may send a signal to the communication electrode of the first earphone 31, to wake up the first earphone 31.

If the host 2 is in the open state, and the first earphone 31 detects that the first earphone 31 is attached to the first part 21, a detection signal of the magnetic field sensor 317z triggers the controller of the first earphone 31 to work, to wake up the first earphone 31.

In this embodiment, both the host 2 and the first earphone 31 can detect the in-box/out-box state of the first earphone 31, so that a risk that may be caused by detection performed only by the host 2 or the first earphone 31 can be avoided (for example, if detection is performed only by the host 2, the in-box/out-box state of the first earphone 31 cannot be accurately detected if power of the host 2 is exhausted), and reliability of detection of the in-box/out-box state of the first earphone 31 can be ensured.

### 7. Foreign matter detection mechanism

In this embodiment, if foreign matter (for example, a liquid or a solid or semi-solid dirt) enters the third accommodation groove 231f of the host 2, surfaces of the host 2 and the first earphone 31 may be contaminated, corroded, and rusted, and even a function abnormality may be caused, thereby affecting reliability and a service life of the product. In particular, if the second charging spring 231c and the first charging spring 231e in the third accommodation groove 231f are in contact with a large quantity of foreign matter, a charging abnormality (or a communication abnormality) may be caused.

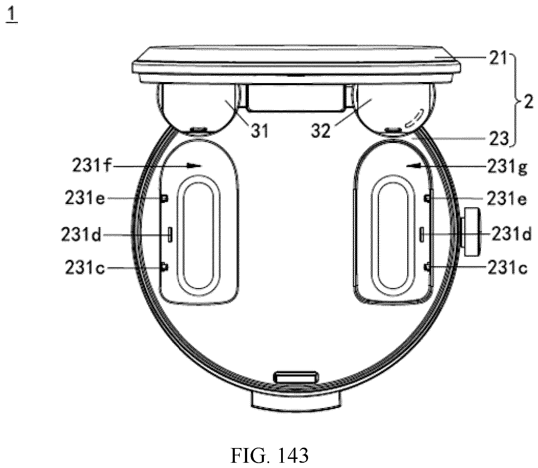

In view of this, as shown in FIG. 143, the foreign matter detection spring 231d is further disposed in the third accommodation groove 231f, and is configured to implement foreign matter detection. A detection principle may be as follows:

When at least one of the foreign matter detection spring 231d, the first charging spring 231e, and the second charging spring 231c is in contact with the foreign matter, a waveform of a charging signal of the host 2 changes. For example, after the foreign matter detection spring 231d and the first charging spring 231e are in contact with the foreign matter, or after the foreign matter detection spring 231d and the second charging spring 231c are in contact with the foreign matter, or after the foreign matter detection spring 231d, the first charging spring 231e, and the second charging spring 231c are in contact with the foreign matter, the waveform of the charging signal of the charging circuit of the host 2 changes. Such a charging signal whose waveform changes may be referred to as an abnormal charging signal. If at least one of the first charging spring 231e and the second charging spring 231c is in contact with the foreign matter, the waveform of the charging signal of the host 2 does not change. Such a charging signal whose waveform does not change may be referred to as a normal charging signal.

If only one of the first charging spring 231e, the second charging spring 231c, and the foreign matter detection spring 231d is in contact with the foreign matter or none of the first charging spring 231e, the second charging spring 231c, and the foreign matter detection spring 231d is in contact with the foreign matter, the waveform of the charging signal of the host 2 does not change. In other words, the charging circuit generates the normal charging signal.

Therefore, the processor of the host 2 may determine, based on a type of the charging signal, whether there is foreign matter entering the third accommodation groove 231f. For example, when determining that the charging signal is an abnormal charging signal, the processor determines that there is foreign matter entering the third accommodation groove 231f. On the contrary, when determining that the charging signal is a normal charging signal, the processor determines that no foreign matter enters the third accommodation groove 231f.

In this embodiment, when the host 2 determines that there is foreign matter entering the third accommodation groove 231f, the processor of the host 2 may control the charging circuit in the host 2 to be turned off. Therefore, when the first earphone 31 is accommodated in the third accommodation groove 231f, there is no charging current between the first charging spring 231e and the first electrode of the first earphone 31, and there is no charging current between the second charging spring 231c and the second electrode of the first earphone 31. In this way, a charging abnormality (for example, a short circuit) can be prevented.

In this embodiment, when the host 2 determines that there is foreign matter entering the third accommodation groove 231f, the processor of the host 2 may further control an alarm module in the host 2 to send an alarm, so as to send a warning to the user. The alarm module may be, for example, a speaker, a buzzer, or a motor in the host 2. It may be understood that, based on a product requirement, an alarm mechanism is not necessary.

In this embodiment, when the host 2 determines that no foreign matter enters the third accommodation groove 231f, the processor of the host 2 may control the charging circuit in the host 2 to be turned on. Therefore, when the first earphone 31 is accommodated in the third accommodation groove 231f, the host 2 normally charges the first earphone 31.

In another embodiment, based on a product requirement, the host may not have the foreign matter detection mechanism.

### 8. The host 2 charges the first earphone 31.

With reference to the foregoing descriptions, because of structure designs of the first electrode and the second electrode in the first earphone 31, after the first earphone 31 is placed in the third accommodation groove 231f at a plurality of rotation angles, the first charging spring 231e can be in contact with the first electrode 312, and the second charging spring 231c can be in contact with the second electrode 314, to ensure that the host 2 normally charges the first earphone 31. This design can simplify user operations and improve user experience.

### 9. Charging overheat protection mechanism of the host 2

In this embodiment, when the host 2 charges the first earphone 31, heat is generated. This may cause an excessively high temperature rise of the host 2 or the first earphone 31. For example, due to improper use of the user or a short circuit of an internal circuit, a charging current of the host 2 is excessively large, and in this case, a temperature rise is easily excessively high. An excessively high temperature affects safety, a service life, and reliability of the product, and may affect user experience.

In view of this, the host 2 may have a temperature detection module, and the temperature detection module may be disposed, for example, near the first accommodation groove 213y and/or the third accommodation groove 231f The temperature detection module may be, for example, a thermistor. The temperature detection module is configured to detect a temperature at a mounting position of the temperature detection module, and report the temperature to the processor of the host 2. The processor may determine, based on detection information of the temperature detection module, whether a temperature rise exceeds a threshold. When the temperature rise is greater than or equal to the threshold, the processor may control the charging circuit of the host 2 to be turned off, so that the host 2 may not charge the first earphone 31, to suppress the temperature rise. If the temperature rise is less than the threshold, the processor may control the charging circuit of the host 2 to be turned on, so that the host 2 can charge the first earphone 31. This charging overheat protection mechanism can improve the safety, a service life, and reliability of the product, and ensure user experience.

In this embodiment, when the processor of the host 2 determines that the temperature rise is excessively high, the processor may further control an alarm module in the host 2 to send an alarm, so as to send a warning to the user. The alarm module may be, for example, a speaker, a buzzer, or a motor in the host 2. It may be understood that, based on a product requirement, an alarm mechanism is not necessary.

In another embodiment, based on a product requirement, the host may not have the charging overheat protection mechanism.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. A wearable device,
comprising an earphone and a host, wherein
the earphone has an earphone magnet;
the host comprises a first part and a second part; the first part is configured to rotate relative to the second part and be opened relative to the second part, so that the host is opened, or the first part and the second part can be closed, so that the host is closed; the first part has a first accommodation groove; the second part has a third accommodation groove; and when the host is closed, the first accommodation groove and the third accommodation groove enclose an accommodation space;
the first part has a first host attachment magnet; when the host is closed, the earphone is accommodated in the accommodation space, and the earphone magnet is magnetically attached to the first host attachment magnet; and when the first part is opened relative to the second part, the earphone can be attached in the first accommodation groove and move with the first part; and
when the earphone is accommodated in the first accommodation groove, a maximum distance between a part that is of the earphone and that is located in the first accommodation groove and a plane on which an opening of the first accommodation groove is located is a first distance, and a maximum distance between a part that is of the earphone and that is located outside the first accommodation groove and the plane on which the opening of the first accommodation groove is located is a second distance, wherein the first distance is less than the second distance.

2. The wearable device according to claim 1, wherein
the first host attachment magnet is a Halbach array, and the earphone magnet is a single magnet or a Halbach array.

3. The wearable device according to claim 1 or 2, wherein
the first host attachment magnet is the Halbach array, the first host attachment magnet comprises two single magnets that are connected, and magnetic field directions of the two single magnets are different; and
the earphone magnet comprises one single magnet, and the single magnet is a Halbach array having two different magnetic field directions.

4. The wearable device according to any one of claims 1 to 3, wherein
the second part has a second host attachment magnet; and
when the earphone is accommodated in the accommodation space, the earphone magnet is magnetically attached to both the first host attachment magnet and the second host attachment magnet, and a magnetic force between the earphone magnet and the first host attachment magnet is greater than a magnetic force between the earphone magnet and the second host attachment magnet.

5. The wearable device according to any one of claims 1 to 4, wherein
a groove is provided on a circumferential edge of the first part, the first part has a sealing member, several protrusions are provided on a surface of the sealing member, the several protrusions are spaced in pairs, the sealing member is fastened in the groove of the first part, the several protrusions of the sealing member are all connected to a bottom surface of the groove of the first part, a side that is of the sealing member and that is far away from the protrusions of the sealing member is exposed outside the groove of the first part, and when the host is closed, a part that is of the sealing member and that is exposed outside the groove of the first part is in contact with the second part, to seal a gap between the first part and the second part; or
a groove is provided on a circumferential edge of the second part, the second part has a sealing member, several protrusions are provided on a surface of the sealing member, the several protrusions are spaced in pairs, the sealing member is fastened in the groove of the second part, the several protrusions of the sealing member are all connected to a bottom surface of the groove of the second part, a side that is of the sealing member and that is far away from the protrusions of the sealing member is exposed outside the groove of the second part, and when the host is closed, a part that is of the sealing member and that is exposed outside the groove of the second part is in contact with the first part, to seal a gap between the first part and the second part.

6. The wearable device according to any one of claims 1 to 5, wherein
the second part has a first charging spring and a second charging spring;
the earphone is in a centrosymmetric shape, the earphone comprises a first electrode and a second electrode, both the first electrode and the second electrode are located on an outer side of the earphone and are of ring-shaped structures that surround a center line of the earphone, the first electrode and the second electrode are spaced from each other, and when the earphone is located in the second part, the first electrode is in contact with the first charging spring, and the second electrode is in contact with the second charging spring; and
the host comprises a charging circuit, and the charging circuit is configured to charge the earphone by using the first charging spring and the second charging spring.

7. The wearable device according to claim 6, wherein
the second part has a foreign matter detection spring; and
the host comprises a processor; and the processor is configured to: control, based on an abnormal charging signal of the charging circuit, the charging circuit to be turned off, and control, based on a normal charging signal of the charging circuit, the charging circuit to work, wherein after the foreign matter detection spring and at least one of the first charging spring and the second charging spring are in contact with foreign matter, the charging circuit generates the abnormal charging signal;otherwise, the charging circuit generates the normal charging signal.

8. The wearable device according to claim 6 or 7, wherein
the first part or the second part has a temperature detection module; and
the host comprises the processor; the processor is configured to: when determining, based on a detection result of the temperature detection module, that a detected temperature is greater than or equal to a threshold, control the charging circuit to be turned off; and the processor is further configured to: when determining, based on the detection result of the temperature detection module, that the detected temperature is less than the threshold, control the charging circuit to work.

9. The wearable device according to any one of claims 1 to 8, wherein
the second part has a status detection magnet, the first part has a first magnetic field sensor, and the first magnetic field sensor is configured to detect a magnetic flux of the status detection magnet; and
the host comprises the processor, and the processor is configured to determine, based on a detection signal of the first magnetic field sensor, whether the host is in an open state or a closed state.

10. The wearable device according to any one of claims 1 to 9, wherein
the first part or the second part has a second magnetic field sensor, and the second magnetic field sensor is configured to detect a magnetic flux of the earphone magnet; and
the host comprises the processor; and the processor is configured to determine, based on a detection signal of the second magnetic field sensor of the first part, whether the earphone is located in the first accommodation groove; or the processor is configured to determine, based on a detection signal of the second magnetic field sensor of the second part, whether the earphone is located in the third accommodation groove.

11. The wearable device according to any one of claims 1 to 10, wherein
the second part has the status detection magnet, the earphone has a third magnetic field sensor, and the third magnetic field sensor is configured to detect the magnetic flux of the status detection magnet; and
the earphone has a controller, and the controller is configured to determine, based on a detection signal of the third magnetic field sensor, whether the earphone is located in the third accommodation groove.

12. The wearable device according to any one of claims 1 to 11, wherein
the host comprises a rotating shaft assembly, and the rotating shaft assembly comprises a sleeve, a driven member, an elastic member, and a first shaft;
the shaft sleeve has an inner cavity, and an outer side of the shaft sleeve is fixedly connected to the first part;
the driven member has a shaft matching surface and a through hole, the through hole of the driven member penetrates the shaft matching surface, the driven member is located in the inner cavity, and the driven member can slide along a surface of the inner cavity but cannot rotate relative to the shaft sleeve;
the elastic member is located in the inner cavity, and presses against a surface that is of the driven member and that is far away from the shaft matching surface;
one part of the first shaft is located in the inner cavity and is rotatably connected to the shaft sleeve; the part that is of the first shaft and that is located in the inner cavity passes through the through hole of the driven member, and fits with the shaft matching surface of the driven member to form a cam mechanism; and the other part of the first shaft is located outside the inner cavity and is fixedly connected to the second part; and
the first part can rotate relative to the second part by using the rotating shaft assembly; and in a process in which the host is switched from the closed state to the open state, a rotation stroke of the first part sequentially comprises a first stroke segment, a second stroke segment, and a third stroke segment, wherein
in the first stroke segment, the driven member can move along the first shaft under driving of an elastic force of the elastic member, and the driven member can rotate around the first shaft under a joint action of the cam mechanism and the elastic member, to drive the shaft sleeve to rotate around the first shaft, so that the shaft sleeve drives the first part to rotate relative to the second part;
in the second stroke segment, the first part can rotate relative to the second part under driving of an external force, to drive the shaft sleeve and the driven member to rotate around the first shaft; and
in the third stroke segment, the driven member can move along the first shaft under driving of the elastic force of the elastic member, and the driven member can rotate around the first shaft under the joint action of the cam mechanism and the elastic member, to drive the shaft sleeve to rotate around the first shaft, so that the shaft sleeve drives the first part to rotate relative to the second part.

13. The wearable device according to claim 12, wherein
the shaft matching surface comprises a first slope, a plane, and a second slope that are sequentially connected, the first slope and the plane form an obtuse angle, the plane and the second slope form an obtuse angle, and the first slope, the plane, and the second slope form a two-step ladder;
in the first stroke segment, the first slope is in sliding contact with the part that is of the first shaft and that is located in the inner cavity;
in the second stroke segment, the plane is in sliding contact with the part that is of the first shaft and that is located in the inner cavity; and
in the third stroke segment, the second slope is in sliding contact with the part that is of the first shaft and that is located in the inner cavity.

14. The wearable device according to any one of claims 1 to 13, wherein
the rotating shaft assembly comprises the shaft sleeve, a second shaft, and a flexible circuit board;
the shaft sleeve has the inner cavity;
a channel is formed on the second shaft in an axial direction of the second shaft, one part of the second shaft is located in the inner cavity and is rotatably connected to the shaft sleeve, and the other part of the second shaft is located outside the inner cavity;
the flexible circuit board comprises a first electrical connection end, a mounting part, and a second connection end; the mounting part is located between the first electrical connection end and the second electrical connection end; the mounting part comprises a wound part and a laminated part that are connected to each other; and when the flexible circuit board is mounted on the second shaft, both the first electrical connection end and the second electrical connection end are located outside the inner cavity, the wound part is wound around a part that is of the second shaft and that is located in the inner cavity, the laminated part is in a folded state, and at least one part of the laminated part is accommodated in the channel of the second shaft;
the first part has a first host circuit board assembly, the first host circuit board assembly is electrically connected to the first electrical connection end, the second part has a second host circuit board assembly, and the second host circuit board assembly is electrically connected to the second electrical connection end; and
the first part is fixedly connected to the outer side of the shaft sleeve, the second part is fixedly connected to a part that is of the second shaft and that is located outside the inner cavity, and the first part can rotate relative to the second part by using the rotating shaft assembly.

15. The wearable device according to claim 14, wherein
the first host circuit board assembly comprises a circuit board, and the circuit board has a grounding point and a feeding point; and
the first part comprises a first host housing, the first host housing is fixedly connected to the outer side of the shaft sleeve, the first host circuit board assembly is fastened to a side that is of the first host housing and that is far away from the shaft sleeve, the first host housing is electrically connected to both the grounding point and the feeding point, and the first host housing is used as an antenna of the host.

16. The wearable device according to claim 15, wherein
the rotating shaft assembly comprises a shaft contact member, and the shaft contact member is fastened in the shaft sleeve, and is in sliding contact with the part that is of the second shaft and that is located in the inner cavity; and
the second part comprises a third host housing, the third host housing is fixedly connected to the part that is of the second shaft and that is located outside the inner cavity, and the third host housing is used as an antenna of the host.

17. The wearable device according to claim 16, wherein
when the host is closed, there is a gap between the first host housing and the third host housing, and the first host housing and the second host housing are coupled.

18. The wearable device according to any one of claims 1 to 17, wherein
the first part is one of a cover of the host and a body of the host, and the second part is the other one of the cover and the body;
the host comprises an open button, and the open button comprises a cap, an elastic member, and a touch-sensitive spring;
a part of the cap is located in the second part, the other part of the cap is located outside the second part, the cap is movably connected to the second part, and the cap has a bump located in the second part;
the elastic member is mounted in the second part to provide a rebound force for the cap;
the touch-sensitive spring is located in the second part, and the touch-sensitive spring is spaced opposite to the bump of the cap; and
when the host is closed, the cap and the first part form a buckle connection, to latch the first part and the second part; and when being pressed, the cap can move into the second part, so that the buckle connection is released, and the bump of the cap presses against the touch-sensitive spring.

19. The wearable device according to any one of claims 1 to 18, wherein
the earphone and the first accommodation groove match in shape, and/or the earphone and the third accommodation groove match in shape.

20. The wearable device according to any one of claims 1 to 19, wherein
the earphone comprises an earplug, the first electrode, an earphone front housing, the second electrode, and an earphone rear housing; the first electrode is located between the earplug and the earphone front housing; the earphone front housing is connected to the first electrode and the second electrode; and the second electrode is connected to the earphone front housing and the earphone rear housing; and
when the earphone is accommodated in the first accommodation groove or the third accommodation groove, the earplug faces the rotating shaft assembly, and the earphone rear housing is far away from the rotating shaft assembly.

21. The wearable device according to any one of claims 1 to 20, wherein
the host comprises a smartwatch.
